(19) Europäisches Patentamt
European Patent Office
Office européen des brevets

(11) EP 4 220 669 A1

(12) **EUROPEAN PATENT APPLICATION**
published in accordance with Art. 153(4) EPC

(43) Date of publication:
**02.08.2023 Bulletin 2023/31**

(21) Application number: **21872313.8**

(22) Date of filing: **16.09.2021**

(51) International Patent Classification (IPC):
***H01F 1/26*** *(2006.01)* ***C08L 63/00*** *(2006.01)*
***C08L 101/00*** *(2006.01)* ***H01F 1/28*** *(2006.01)*
***H01F 1/37*** *(2006.01)* ***H05K 1/03*** *(2006.01)*

(52) Cooperative Patent Classification (CPC):
**C08L 63/00; C08L 101/00; H01F 1/26; H01F 1/28; H01F 1/37; H05K 1/03**

(86) International application number:
**PCT/JP2021/034059**

(87) International publication number:
**WO 2022/065183 (31.03.2022 Gazette 2022/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **24.09.2020 JP 2020159807**

(71) Applicant: **FUJIFILM Corporation**
**Tokyo 106-8620 (JP)**

(72) Inventor: **MIYATA, Tetsushi**
**Haibara-gun, Shizuoka 421-0396 (JP)**

(74) Representative: **HGF**
**HGF Limited**
**1 City Walk**
**Leeds LS11 9DX (GB)**

# (54) COMPOSITION, MAGNETIC PARTICLE-CONTAINING CURED PRODUCT, MAGNETIC PARTICLE INTRODUCED SUBSTRATE, AND ELECTRONIC MATERIAL

(57) A first object of the present invention is to provide a composition having excellent fluidity and capable of forming a cured substance having excellent magnetic properties and excellent filling suitability. A second object of the present invention is to provide a magnetic particle-containing cured substance formed of the composition. A third object of the present invention is to provide a magnetic particle-introduced substrate and an electronic material that contain the magnetic particle-containing cured substance.

The composition according to an embodiment of the present invention is a composition containing
magnetic particles,
one or more components selected from the group consisting of a resin and a resin precursor,
a solvent,
in which a content of magnetic particles having a primary particle diameter of 4 μm or more is 25% by mass or less with respect to a total mass of the magnetic particles,
a content of the magnetic particles is 91% by mass or more with respect to a total solid content of the composition, and
a content of the solvent is 3% to 24% by mass with respect to a total mass of the composition.



Processed by Luminess, 75001 PARIS (FR)

## Description

## BACKGROUND OF THE INVENTION

### 1. Field of the Invention

The present invention relates to a composition, a magnetic particle-containing cured substance, a magnetic particle-introduced substrate, and an electronic material.

### 2. Description of the Related Art

With the performance upgrade and further miniaturization of electronic devices, the degree of integration of electronic circuits is increasing. As one of the materials for improving the degree of integration, there is a coating-type composition containing magnetic particles. Using such a composition enables a magnetic material to be mounted in any shape, which makes it easier to achieve miniaturization and performance upgrade of electronic devices compared to the conventional method of arranging individual pieces of magnetic materials on a chip.

For example, WO2018/194099A discloses "a resin composition containing (A) thermosetting resin, (B) curing agent, (C) thermoplastic resin, and (D) magnetic filler, in which a cured substance obtained by thermally curing the resin composition has an elastic modulus of 7 GPa or more and 18 GPa or less at 23°C".

## SUMMARY OF THE INVENTION

In recent years, an attempt has been made to manufacture a magnetic particle-introduced substrate obtained by filling hole portions (holes) of a substrate with a magnetic material by using a coating-type composition containing magnetic particles.

With reference to the resin composition described in WO2018/194099A, the inventors of the present invention prepared a coating-type composition containing magnetic particles and examined the performance of the composition as a composition for filling holes. As a result, the inventors have found that sometimes a cured substance formed of such a composition has poor magnetic properties (magnetic permeability) and that sometimes openings occur due to voids, cracks, and the like in a case where holes are filled with the composition. That is, the inventors have found that the cured substance formed of the composition has a room for further improvement in terms of magnetic property improvement and void ratio reduction (hereinafter, also described as "excellent filling suitability").

In addition, from the viewpoint of coating properties and ease of filling work, the composition is also required to have excellent fluidity as a basic performance.

For example, JP6024927B discloses a solventless composition that does not contain a solvent and is made exhibit fluidity by a resin component. However, in a case where an attempt is made to make sure that the solventless composition exhibits the desired fluidity, the content of magnetic particles that can be introduced into the solid content of the composition is limited. As a result, unfortunately, it is difficult to improve the magnetic properties (magnetic permeability) of the cured substance.

An object of the present invention is to provide a composition having excellent fluidity and capable of forming a cured substance having excellent magnetic properties and excellent filling suitability.

Another object of the present invention is to provide a magnetic particle-containing cured substance formed of the composition.

A still another object of the present invention is to provide a magnetic particle-introduced substrate and an electronic material that contain the magnetic particle-containing cured substance.

In order to achieve the above objects, the inventors of the present invention conducted intensive studies. As a result, the inventors have found that the objects can be achieved by the following constitutions.

[1] A composition containing magnetic particles,

one or more components selected from the group consisting of a resin and a resin precursor, and
a solvent,
in which a content of magnetic particles having a primary particle diameter of 4 μm or more is 25% by mass or less with respect to a total mass of the magnetic particles,
a content of the magnetic particles is 91% by mass or more with respect to a total solid content of the composition, and
a content of the solvent is 3% to 24% by mass with respect to a total mass of the composition.

[2] The composition described in [1], in which the magnetic particles are soft magnetic particles.
[3] The composition described in [1] or [2], in which the solvent includes a solvent having a boiling point of 80°C or higher.
[4] The composition described in any one of [1] to [3], in which the solvent includes a solvent having a boiling point of 160°C or higher.
[5] The composition described in any one of [1] to [4], in which the solvent includes a solvent having a boiling point of 160°C or higher, and a content of the solvent having a boiling point of 160°C or higher is 3% by mass or more with respect to a total mass of the composition.
[6] The composition described in any one of [1] to [5], in which the components include at least one of an epoxy compound or an oxetane compound.
[7] A magnetic particle-containing cured substance formed of the composition described in any one of [1] to [6].
[8] A magnetic particle-introduced substrate comprising a substrate in which hole portions are formed, and the magnetic particle-containing cured substance described in [7] that is disposed in the hole portions.
[9] An electronic material including the magnetic particle-introduced substrate described in [8].

According to the present invention, it is possible to provide a composition having excellent fluidity and capable of forming a cured substance having excellent magnetic properties and excellent filling suitability.
In addition, according to the present invention, it is possible to provide a magnetic particle-containing cured substance formed of the composition.
Furthermore, according to the present invention, it is possible to provide a magnetic particle-introduced substrate and an electronic material containing the magnetic particle-containing cured substance.

## DESCRIPTION OF THE PREFERRED EMBODIMENTS

Hereinafter, the present invention will be specifically described.
The following constituents will be described based on typical embodiments of the present invention in some cases. However, the present invention is not limited to the embodiments.
Regarding the notation of a group (atomic group) in the present specification, unless the gist of the present invention is missed, the notation without the terms "substituted" and "unsubstituted" includes both the group having no substituent and the group having a substituent. For example, "alkyl group" includes not only an alkyl group having no substituent (unsubstituted alkyl group) but also an alkyl group having a substituent (substituted alkyl group). Furthermore, in the present specification, "organic group" refers to a group having at least one carbon atom.
In the present specification, "actinic ray" or "radiation" means, for example, a bright line spectrum of a mercury lamp, a far ultraviolet ray represented by an excimer laser, extreme ultraviolet (EUV light), an X-ray, an electron beam (EB), and the like. In the present specification, "light" means an actinic ray or radiation.
Unless otherwise specified, "exposure" in the present specification means not only the exposure performed using a bright line spectrum of a mercury lamp, a far ultraviolet ray represented by an excimer laser, extreme ultraviolet, an X-ray, EUV light, and the like, but also the drawing performed using particle beams such as an electron beam and an ion beam.
In the present specification, a range described using "to" includes the numerical values listed before and after "to" as a lower limit and an upper limit.
In the present specification, (meth)acrylate represents acrylate and methacrylate, (meth)acryl represents acryl and methacryl, and (meth)acryloyl represents acryloyl and methacryloyl.
In the present specification, "solid content" of a composition means components forming a magnetic particle-containing cured substance (hereinafter, also simply described as "cured substance" in some cases). In a case where the composition contains a solvent (such as an organic solvent or water), "solid content" means all components except for the solvent. In addition, a liquid component is also regarded as a solid content as long as this component forms the cured substance.
In the present specification, unless otherwise specified, "boiling point" means a standard boiling point.
In the present specification, a weight-average molecular weight (Mw) is a polystyrene-equivalent value obtained by a Gel Permeation Chromatography (GPC) method.
The GPC method in the present specification is based on a method using HLC-8020GPC (manufactured by Tosoh Corporation), columns consisting of TSKgel SuperHZM-H, TSKgel SuperHZ4000, and TSKgel SuperHZ2000 (manufactured by Tosoh Corporation, 4.6 mm ID x 15 cm), and tetrahydrofuran (THF) as an eluent.
In the present specification, as each component, unless otherwise specified, one substance corresponding to each component may be used alone, or two or more substances corresponding to each component may be used in combination. Here, in a case where two or more substances are used in combination as each component, unless otherwise specified, the content of the component means the total content of the substances used in combination.

[Composition]

The composition according to an embodiment of the present invention is a composition containing

magnetic particles,
one or more components selected from the group consisting of a resin and a resin precursor (hereinafter, the resin and the resin precursor will be collectively called "binder component"), and
a solvent,
in which a content of magnetic particles having a primary particle diameter of 4 μm or more is 25% by mass or less with respect to a total mass of the magnetic particles,
a content of the magnetic particles is 91% by mass or more with respect to a total solid content of the composition, and
a content of the solvent is 3% to 24% by mass with respect to a total mass of the composition.

A magnetic particle-containing composition used as a composition for filling holes is required to exhibit not only excellent magnetic properties (magnetic permeability) but also sufficient fluidity in a liquid state from the viewpoint of coating properties and ease of filling work. From the viewpoint of strength, this composition is also required to exhibit, as a basic performance, properties of suppressing openings such as voids and cracks (excellent filling suitability) after being cured.
By intensive studies, the inventors of the present invention have found that the composition configured as above can exhibit excellent fluidity in a liquid state and can form a cured substance having excellent magnetic characteristics (magnetic permeability) and excellent filling suitability.
Furthermore, as will be described later, the inventors have confirmed that in a case where the content of a solvent having a boiling point of 160°C or higher is 3% by mass or more with respect to the total mass of the composition, the filling suitability of the cured substance formed of the composition is further improved.
Hereinafter, further improving the fluidity of the composition, further improving the magnetic characteristics (magnetic permeability) of the cured substance formed of the composition, and/or further improving the filling suitability of the cured substance formed of the composition will be described as "further improving the effects of the present invention" in some cases.
Hereinafter, each component that can be contained in the composition will be specifically described.

[Magnetic particles]

The composition contains magnetic particles.
The magnetic particles contain metal atoms.
In the present specification, the metal atoms also include metalloid atoms such as boron, silicon, germanium, arsenic, antimony, and tellurium.
The metal atoms may be contained in the magnetic particles, as an alloy containing a metal element (preferably a magnetic alloy), a metal oxide (preferably a magnetic oxide), a metal nitride (preferably a magnetic nitride), or a metal carbide (preferably a magnetic carbide).
The content of the metal atoms with respect to the total mass of the magnetic particles is preferably 50% to 100% by mass, more preferably 75% to 100% by mass, and even more preferably 95% to 100% by mass.
The metal atoms are not particularly limited, and preferably include at least one kind of metal atoms selected from the group consisting of Fe, Ni, and Co.
The content of at least one kind of metal atoms selected from the group consisting of Fe, Ni, and Co (total content of metal atoms in a case where the magnetic particles contain two or more kinds of metal atoms) with respect to the total mass of metal atoms in the magnetic particles is preferably 50% by mass or more, more preferably 60% by mass or more, and even more preferably 70% by mass or more. The upper limit of the content is not limited. For example, the upper limit is 100% by mass or less, preferably 98% by mass or less, and more preferably 95% by mass or less.
The magnetic particles may contain materials other than Fe, Ni, and Co, and specific examples thereof include Al, Si, S, Sc, Ti, V, Cu, Y, Mo, Rh, Pd, Ag, Sn, Sb, Te, Ba, Ta, W, Re, Au, Bi, La, Ce, Pr, Nd, P, Zn, Sr, Zr, Mn, Cr, Nb, Pb, Ca, B, C, N, and O.
In a case where the magnetic particles contain metal atoms other than Fe, Ni, and Co, it is preferable that the magnetic particles contain one or more metals selected from the group consisting of Si, Cr, B, and Mo.
Specific examples of the magnetic particles include an alloy such as an Fe-Co-based alloy (preferably permendur), an Fe-Ni-based alloy (for example, permalloy), an Fe-Zr-based alloy, an Fe-Mn-based alloy, an Fe-Si based alloy, an Fe-Al based alloy, an Ni-Mo-based alloy (preferably supermalloy), an Fe-Ni-Co-based alloy, an Fe-Si-Cr-based alloy, an Fe-Si-B-based alloy, an Fe-Si-Al-based alloy (preferably sendust), an Fe-Si-B-C-based alloy, an Fe-Si-B-Cr-based alloy, an Fe-Si-B-Cr-C-based alloy, an Fe-Co-Si-B-based alloy, an Fe-Si-B-Nb-based alloy, an Fe nanocrystalline alloy,

an Fe-based amorphous alloy, or a Co-based amorphous alloy, and a ferrite such as a Ni ferrite, a Mn ferrite, a spinel ferrite (preferably an Ni-Zn-based ferrite or an Mn-Zn-based ferrite), or a hexagonal ferrite (preferably barium ferrite or a magnetoplumbite-type hexagonal ferrite). The above alloys may be amorphous.

As the magnetic particles, among the above, soft magnetic particles are preferable because a loss of these particles is lower. Examples of the soft magnetic particles include an Fe-based amorphous alloy, an Fe-Si-Cr-based alloy, an Fe nanocrystalline alloy, an Fe-Ni-Co-based alloy, a Co-based amorphous alloy, a Ni-Mo-based alloy, a Ni ferrite, a Mn ferrite, and the like.

One kind of magnetic particles may be used alone, or two or more kinds of magnetic particles may be used in combination.

The surface of each of the magnetic particles may be provided with a surface layer. In a case where the magnetic particles have a surface layer, it is possible to add functions to the magnetic particles according to the material of the surface layer.

Examples of the surface layer include an inorganic layer or an organic layer.

As a compound for forming an inorganic layer, in view of making it possible to form a surface layer excellent in at least one of the insulating properties, gas barrier properties, and chemical stability, a metal oxide, a metal nitride, a metal carbide, a phosphoric acid metal salt compound, a boric acid metal salt compound, or a silicic acid compound (for example, a silicic acid ester such as tetraethyl orthosilicate or a silicate such as sodium silicate) is preferable. Specific examples of elements contained in these compounds include Fe, Al, Ca, Mn, Zn, Mg, V, Cr, Y, Ba, Sr, Ge, Zr, Ti, Si, and rare earth elements.

Examples of the material constituting the inorganic layer obtained using the compound for forming an inorganic layer include silicon oxide, germanium oxide, titanium oxide, aluminum oxide, zirconium oxide, magnesium oxide, and the like. The inorganic layer may be a layer that contains two or more of these materials.

Examples of a compound for forming an organic layer include an acrylic monomer. Specific examples of the acrylic monomer include the compounds described in paragraphs "0022" and "0023" of JP2019-067960A.

Examples of the material constituting the organic layer obtained using the compound for forming an organic layer include an acrylic resin.

The thickness of the surface layer is not particularly limited. In view of enabling the surface layer to more effectively function, the thickness of the surface layer is preferably 3 to 1,000 nm.

The lower limit of the average primary particle diameter of the magnetic particles is, for example, 0.1 μm or more, preferably 1 μm or more, more preferably 4 μm or more, and even more preferably 5 μm or more. The upper limit of the average primary particle diameter of the magnetic particles is preferably 100 μm or less, more preferably 50 μm or less, even more preferably 30 μm or less, particularly preferably 20 μm or less, and most preferably 7 μm or less.

The particle diameter of primary particles of the magnetic particles can be measured, for example, by imaging the magnetic particles by using a transmission electron microscope at 100,000X photographing magnification, printing the image on printing paper at total magnification of 500,000X to obtain an image of the particles, tracing the contour of the particles (primary particles) with a digitizer, and calculating the diameter of circles having the same area as the area of the traced regions (equivalent circular area diameter). Here, the primary particles refer to independent particles not being aggregated. The imaging using a transmission electron microscope is performed by a direct method by using a transmission electron microscope at an acceleration voltage of 300 kV. The observation and measurement with the transmission electron microscope can be performed using, for example, a transmission electron microscope H-9000 manufactured by Hitachi, Ltd., and image analysis software KS-400 manufactured by Carl Zeiss AG.

For determining the average primary particle diameter, 1,000 particles are randomly selected in the aforementioned image of particles, and the volume of each particle is calculated based on the diameter of the circle described above, and a volume-based arithmetic average primary particle diameter is determined.

The shape of the magnetic particles is not particularly limited, and may be any of flat, elliptical, spherical, and amorphous shapes.

In the magnetic particles, the content of magnetic particles having a primary particle diameter of 4 μm or more is 25% by mass or less with respect to the total mass of the magnetic particles. In a case where the content of the magnetic particles having a primary particle diameter of 4 μm or more is 25% by mass or more with respect to the total mass of the magnetic particles, the cured substance formed of the composition is likely to achieve both the excellent magnetic properties and excellent filling suitability. In the magnetic particles, the content of the magnetic particles having a primary particle diameter of 4 μm or more with respect to the total mass of the magnetic particles is preferably 30% by mass or more, more preferably 45% by mass or more, even more preferably 50% by mass or more, and particularly preferably 60% by mass or more. The upper limit thereof is preferably 100% by mass or less.

Particularly, in the magnetic particles, in view of further improving the effects of the present invention, the content of magnetic particles having a primary particle diameter of 4 to 7 μm with respect to the total mass of the magnetic particles is preferably 55% by mass or more, more preferably 65% by mass or more, and even more preferably 70% by mass or more. The upper limit thereof is not particularly limited, and is, for example, 100% by mass or less.

The content of the magnetic particles having a primary particle diameter of 4 μm or more in the magnetic particles can be determined, for example, with reference to average primary particle diameters of the magnetic particles obtained using a transmission electron microscope, volume ratio and specific gravity of the magnetic particles, and the like, based on a particle size distribution curve showing the volume-based frequency distribution of the magnetic particles obtained using a laser diffraction/scattering-type particle size distribution analyzer (for example, "LA960N" (trade name) manufactured by Horiba, Ltd., and the like).

One kind of magnetic particles may be used alone, or two or more kinds of magnetic particles may be used.

In the composition, the content of the magnetic particles (total content in a case where the composition contains two or more kinds of magnetic particles) is 91% by mass or more with respect to the total solid content of the composition. In a case where the content of the magnetic particles is 91% by mass or more with respect to the total solid content of the composition, the cured substance formed of the composition has excellent magnetic properties. Particularly, in view of further improving the effects of the present invention, the content of the magnetic particles with respect to the total solid content of the composition is preferably 92% by mass or more, and more preferably 95% by mass or more. The upper limit of the content is not particularly limited, and is preferably 99% by mass or less.

[Binder component]

The composition contains one or more components (binder component) selected from the group consisting of a resin and a resin precursor. That is, the binder component may be a resin itself or a precursor of a resin precursor (resin precursor).

Examples of the composition using a resin include a composition containing magnetic particles, a solvent, and a resin dissolved in the solvent. By the evaporation of the solvent of the composition, the resin is precipitated, and a composition in which the resin functions as a binder is obtained.

The resin precursor is a component capable of forming a resin by undergoing polymerization and/or crosslinking through a predetermined curing treatment with heat, light (such as ultraviolet light), or the like. The resin formed in this way functions as a binder in the cured substance.

Specific examples of the resin precursor include a thermosetting compound and a photocurable compound. These compounds may be any of a monomer, an oligomer, and a polymer.

Specific examples of the binder component will be described below.

Examples of the binder component include a (meth)acrylic resin, an epoxy resin, an ene·thiol resin, a polycarbonate resin, a polyether resin, a polyarylate resin, a polysulfone resin, a polyethersulfone resin, a polyphenylene resin, a polyarylene ether phosphine oxide resin, a polyimide resin, a polyamide imide resin, a polyolefin resin, a cyclic olefin resin, a polyester resin, a styrene resin, a phenoxy resin, and the like. One of these resins may be used alone, or two or more of these resins may be used by being mixed together.

As the cyclic olefin resin, from the viewpoint of improving heat resistance, a norbornene resin is preferable. Examples of commercially available products of the norbornene resin include ARTON series manufactured by JSR Corporation (for example, ARTON F4520) and the like.

Examples of commercially available products of the polyvinyl acetal resin include "KS-1" manufactured by SEKISUI CHEMICAL CO., LTD., and the like.

Examples of a commercially available products of the phenoxy resin include "YX7553BH30" (manufactured by Mitsubishi Chemical Corporation.).

Examples of the epoxy resin include an epoxy resin that is a glycidyl etherification product of a phenol compound, an epoxy resin that is a glycidyl etherification product of various novolac resins, an alicyclic epoxy resin, an aliphatic epoxy resin, a heterocyclic epoxy resin, a glycidyl ester-based epoxy resin, a glycidyl amine-based epoxy resin, an epoxy resin obtained by glycidylation of halogenated phenols, a condensate of a silicon compound having an epoxy group and another silicon compound, a copolymer of a polymerizable unsaturated compound having an epoxy group and another polymerizable unsaturated compound, and the like.

As the epoxy resin, MARPROOF G-0150M, G-0105SA, G-0130SP, G-0250SP, G-1005S, G-1005SA, G-1010S, G-2050M, G-01100, and G-01758 (manufactured by NOF CORPORATION., epoxy group-containing polymers) and the like may also be used.

In addition, as the binder component, the resin described in Examples of WO2016/088645A may also be used.

As the binder component, a resin is also preferable which has an ethylenically unsaturated group (for example, a (meth)acryloyl group) on a side chain and in which the main chain is bonded to the ethylenically unsaturated group via a divalent linking group having an alicyclic structure.

As the binder component, a resin or resin precursor is also preferable which has a cyclic polymerizable group such as an epoxy group or an oxetanyl group.

Examples of the resin or resin precursor having a cyclic polymerizable group such as an epoxy group or an oxetanyl group include a polymer having an epoxy group on a side chain and a polymerizable monomer or oligomer

having two or more epoxy groups in the molecule. Specific examples thereof include a bisphenol A-type epoxy resin, a bisphenol F-type epoxy resin, a phenol novolac-type epoxy resin, a cresol novolac-type epoxy resin, an aliphatic epoxy resin, and the like.

As these resins, commercially available products may also be used. Furthermore, these resins may be obtained by introducing an epoxy group into a side chain of a polymer.

As for the commercially available products, for example, the description in paragraph "0191" of JP2012-155288A and the like can be referred to, and what are described in the paragraph are incorporated into the present specification.

Examples of the commercially available product also include ADEKA RESIN EP-4000S, ADEKA RESIN EP-4003S, ADEKA RESIN EP-4010S, and ADEKA RESIN EP-4011S (all are manufactured by ADEKA CORPORATION), NC-2000, NC-3000, NC-7300, XD-1000, EPPN-501, and EPPN-502 (all are manufactured by ADEKA CORPORATION), JER103 1S, and the like.

Specific examples of the bisphenol A-type epoxy resin and the bisphenol F-type epoxy resin include ZX1059 (manufactured by NIPPON STEEL Chemical & Material Co., Ltd.) and 828US (manufactured by Mitsubishi Chemical Corporation.).

Examples of commercially available products of the phenol novolac-type epoxy resin include JER-157S65, JER-152, JER-154, and JER-157S70 (all are manufactured by Mitsubishi Chemical Corporation.) and the like.

As the polymerizable monomer or oligomer having two or more epoxy groups in the molecule, it is also possible to use ZX1658GS (liquid 1,4-glycidylcyclohexane-type epoxy resin, manufactured by NIPPON STEEL Chemical & Material Co., Ltd.), HP-4700 (naphthalene-type tetrafunctional epoxy resin, manufactured by DIC Corporation), NC3000L (biphenyl-type epoxy resin, manufactured by Nippon Kayaku Co., Ltd.), and the like.

Specifically, as the polymer having an oxetanyl group on a side chain and the aforementioned polymerizable monomer or oligomer having two or more oxetanyl groups in the molecule, for example, ARON OXETANE OXT-121, OXT-221, OX-SQ, and PNOX (all are manufactured by TOAGOSEI CO., LTD.) can be used.

In a case where an epoxy group is introduced into a side chain of a polymer such that a resin having an epoxy group is synthesized, the introduction reaction is performed by causing the reaction in an organic solvent at a reaction temperature of 50°C to 150°C for a predetermined time by using, for example, a tertiary amine such as triethylamine or benzylmethylamine, a quaternary ammonium salt such as dodecyltrimethylammonium chloride, tetramethylammonium chloride, or tetraethylammonium chloride, pyridine, triphenylphosphine or the like as a catalyst. The amount of the alicyclic epoxy unsaturated compound to be introduced can be controlled such that the acid value of the obtained resin falls into a range of 5 to 200 KOH·mg/g. The weight-average molecular weight of the resin can be in a range of 500 to 5,000,000, and preferably in a range of 1,000 to 500,000.

Instead of the alicyclic epoxy unsaturated compound, it is also possible to use a compound having a glycidyl group as an epoxy group, such as glycidyl (meth)acrylate or allyl glycidyl ether. As for such a compound, for example, the description in paragraph "0045" of JP2009-265518A and the like can be referred to, and what are described in the paragraph are incorporated into the present specification.

Examples of the binder component also include a resin having an acid group, a basic group, or an amide group. In view of further improving the effects of the present invention, the resin having an acid group, a basic group, or an amide group is suitable because such a resin is likely to function as a dispersant for dispersing the magnetic particles.

Examples of the acid group include a carboxy group, a phosphoric acid group, a sulfo group, a phenolic hydroxyl group, and the like. In view of further improving the effects of the present invention, a carboxy group is preferable.

Examples of the basic group include an amino group (ammonia, a group obtained by removing one hydrogen atom from a primary amine or a secondary amine) and an imino group.

In view of further improving the effects of the present invention, it is preferable that the resin have a carboxy group or an amide group among the above.

In a case where the resin has an acid group, in view of further improving the effects of the present invention, the acid value of the resin is preferably 10 to 500 mgKOH/g, and more preferably 30 to 400 mgKOH/g.

In view of further improving the dispersibility of the binder component in the composition such that the effects of the present invention are further improved, as the binder component, a binder component having a solubility of 10 g/L or more in a solvent is preferably used, and a binder component having a solubility of 20 g/L or more in a solvent is more preferably used.

The upper limit of the solubility of the binder component in a solvent is preferably 2,000 g/L or less, and more preferably 1,000 g/L or less.

The solubility of the binder component in a solvent means the amount (g) of the binder component dissolved in 1 L of a solvent at 25°C.

The content of the binder component with respect to the total mass of the composition is preferably 1% to 24% by mass, more preferably 1% to 15% by mass, even more preferably 1% to 12% by mass, particularly preferably 1% to 10% by mass, and most preferably 1% to 7% by mass.

The content of the binder component with respect to the total solid content of the composition is preferably

0.8% to 24% by mass, more preferably 0.8% to 15% by mass, even more preferably 0.8% to 12% by mass, still more preferably 0.8% to 10% by mass, particularly preferably 0.8% to 8% by mass, and most preferably 0.8% to 7% by mass.

<Resin having repeating unit having graft chain (resin A)>

Examples of the binder component include a resin having a repeating unit having a graft chain (hereinafter, this resin will be also called "resin A"). The resin A can function as a dispersant for magnetic particles.

In a case where the composition contains the resin A, the content of the resin A with respect to the total mass of the composition is preferably 1% to 24% by mass, more preferably 1% to 15% by mass, even more preferably 1% to 12% by mass, particularly preferably 1% to 10% by mass, and most preferably 1% to 7% by mass.

The content of the resin A with respect to the total solid content of the composition is preferably 0.8% to 24% by mass, more preferably 0.8% to 15% by mass, even more preferably 0.8% to 12% by mass, still more preferably 0.8% to 10% by mass, particularly preferably 0.8% to 8% by mass, and most preferably 0.8% to 7% by mass.

(Repeating unit having graft chain)

The longer the graft chain in the repeating unit having a graft chain, the higher the effect of steric repulsion, which improves the dispersibility of the magnetic particles. In contrast, in a case where the graft chain is too long, the adsorptive force with respect to the magnetic particles is reduced, which tends to deteriorate the dispersibility of the magnetic particles. Therefore, the number of atoms constituting the graft chain excluding a hydrogen atom is preferably 40 to 10,000, more preferably 50 to 2,000, and even more preferably 60 to 500.

The graft chain mentioned herein refers to a portion from the root of the main chain (atom bonded to the main chain in a group branching off from the main chain) to the terminal of the group branching off from the main chain.

It is preferable that the graft chain contain a polymer structure. Examples of such a polymer structure include a poly(meth)acrylate structure (for example, a poly(meth)acrylic structure), a polyester structure, a polyurethane structure, a polyurea structure, a polyamide structure, a polyether structure, and the like.

In order to improve the interactivity between the graft chain and a solvent such that the dispersibility of the magnetic particles is improved, the graft chain is preferably a graft chain containing at least one structure selected from the group consisting of a polyester structure, a polyether structure, and a poly(meth)acrylate structure, and more preferably a graft chain containing at least either a polyester structure or a polyether structure.

The resin A may be a resin obtained using a macromonomer having a graft chain (a monomer that has a polymer structure and is bonded to a main chain to constitute a graft chain).

The macromonomer having a graft chain (monomer that has a polymer structure and is bonded to a main chain to constitute a graft chain) is not particularly limited. As this macromonomer, a macromonomer containing a reactive double bond-forming group can be suitably used.

As commercially available macromonomers that correspond to the aforementioned repeating unit having a graft chain and suitably used for the synthesis of the resin A, AA-6, AA-10, AB-6, AS-6, AN-6, AW-6, AA-714, AY-707, AY-714, AK-5, AK-30, and AK-32 (all are trade names, manufactured by TOAGOSEI CO., LTD.), and BLEMMER PP-100, BLEMMER PP-500, BLEMMER PP-800, BLEMMER PP-1000, BLEMMER 55-PET-800, BLEMMER PME-4000, BLEMMER PSE-400, BLEMMER PSE-1300, and BLEMMER 43PAPE-600B (all are trade names, manufactured by NOF CORPORATION.) are used. Among these, AA-6, AA-10, AB-6, AS-6, AN-6, or BLEMMER PME-4000 is preferable.

The resin A preferably contains at least one structure selected from the group consisting of polymethyl acrylate, polymethyl methacrylate, and cyclic or chain-like polyester, more preferably contains at least one structure selected from the group consisting of polymethyl acrylate, polymethyl methacrylate, and chain-like polyester, and even more preferably contains at least one structure selected from the group consisting of a polymethyl acrylate structure, a polymethyl methacrylate structure, a polycaprolactone structure, and a polyvalerolactone structure. The resin A may contain only one structure described above or a plurality of structures described above.

The polycaprolactone structure mentioned herein refers to a structure containing, as a repeating unit, a structure formed by ring opening of ε-caprolactone. The polyvalerolactone structure refers to a structure containing, as a repeating unit, a structure formed by ring opening of δ-valerolactone.

In a case where the resin A contains repeating units represented by Formula (1) and Formula (2), which will be described later, where each of j and k is 5, the aforementioned polycaprolactone structure can be introduced into the resin A.

In a case where the resin A contains repeating units represented by Formula (1) and Formula (2), which will be described later, where each of j and k is 4, the aforementioned polyvalerolactone structure can be introduced into the resin A.

In a case where the resin A contains a repeating unit represented by Formula (4), which will be described later, where $X^5$ is a hydrogen atom and $R^4$ is a methyl group, the aforementioned polymethyl acrylate structure can be

introduced into the resin A.

In a case where the resin A contains a repeating unit represented by Formula (4), which will be described later, where $X^5$ and $R^4$ both represent a methyl group, the aforementioned polymethyl methacrylate structure can be introduced into the resin A.

In a case where the resin A contains the repeating unit represented by Formula (5), which will be described later, where j is 5, the aforementioned polycaprolactone structure can be introduced into the resin A.

In a case where the resin A contains the repeating unit represented by Formula (5), which will be described later, where j is 4, the aforementioned polyvalerolactone structure can be introduced into the resin A.

As the repeating unit having a graft chain that the resin A is to contain, a repeating unit represented by any of the following Formula (1) to Formula (4) is preferable, and a repeating unit represented by any of the following Formula (1A), the following Formula (2A), the following Formula (3A), the following Formula (3B), and the following Formula (4) is more preferable.

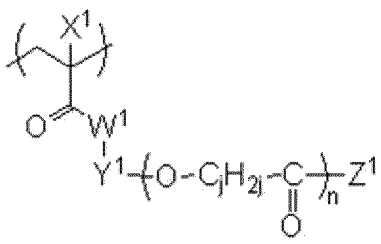
(1)

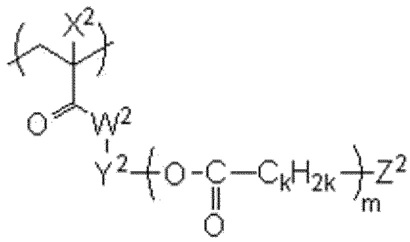
(2)

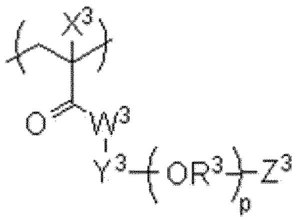
(3)

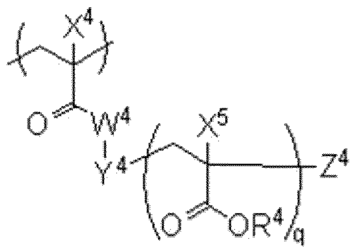
(4)

In Formulas (1) to (4), $W^1$, $W^2$, $W^3$, and $W^4$ each independently represent an oxygen atom or NH. $W^1$, $W^2$, $W^3$, and $W^4$ are preferably oxygen atoms.

In Formulas (1) to (4), $X^1$, $X^2$, $X^3$, $X^4$, and $X^5$ each independently represent a hydrogen atom or a monovalent organic group. In view of restrictions on synthesis, $X^1$, $X^2$, $X^3$, $X^4$, and $X^5$ preferably each independently represent a hydrogen atom or an alkyl group with a carbon number (the number of carbon atoms) of 1 to 12, more preferably each independently represent a hydrogen atom or a methyl group, and even more preferably each independently represent a methyl group.

In Formulas (1) to (4), $Y^1$, $Y^2$, $Y^3$, and $Y^4$ each independently represent a divalent linking group. The structure of the linking group is not particularly restricted. Specific examples of the divalent linking group represented by $Y^1$, $Y^2$, $Y^3$, and $Y^4$ include the following linking groups (Y-1) to (Y-21) and the like. In the following structures, A means a bonding site to the left terminal group in Formulas (1) to (4), and B means a bonding site to the right terminal group in Formulas (1) to (4). Among the following structures, in view of ease of synthesis, (Y-2) or (Y-13) is more preferable.

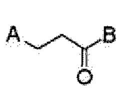
(Y-1)

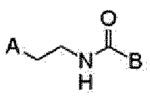
(Y-2)

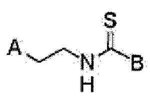
(Y-3)

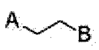
(Y-4)

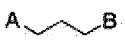
(Y-5)

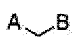
(Y-6)

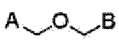
(Y-7)

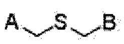
(Y-8)

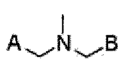
(Y-9)

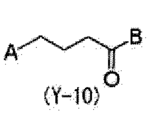
(Y-10)

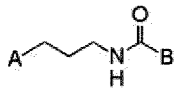
(Y-11)

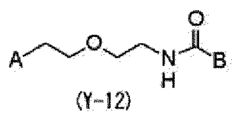
(Y-12)

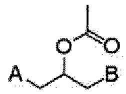
(Y-13)

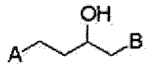
(Y-14)

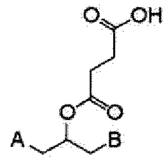
(Y-15)

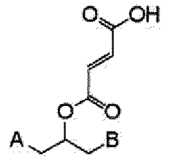
(Y-16)

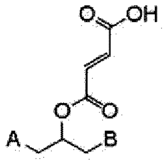
(Y-17)

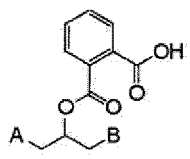
(Y-18)

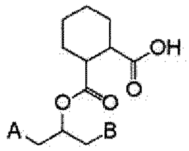
(Y-19)

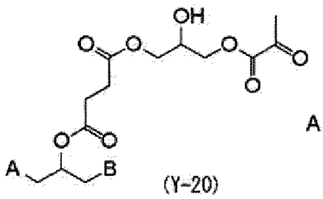
(Y-20)

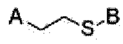
(Y-21)

In Formulas (1) to (4), $Z^1$, $Z^2$, $Z^3$, and $Z^4$ each independently represent a hydrogen atom or a monovalent substituent. The structure of the substituent is not particularly limited. Specific examples of the substituent include an alkyl group, a hydroxyl group, an alkoxy group, an aryloxy group, a heteroaryloxy group, an alkylthioether group, an arylthioether group, a heteroarylthioether group, an amino group, and the like. Among these, as the group represented by $Z^1$, $Z^2$, $Z^3$, and $Z^4$, particularly, in view of improving dispersibility, a group that brings about a steric repulsion effect is preferable. $Z^1$, $Z^2$, $Z^3$, and $Z^4$ more preferably each independently represent an alkyl or alkoxy group with a carbon number of 5 to 24. Especially, $Z^1$, $Z^2$, $Z^3$, and $Z^4$ even more preferably each independently represent a branched alkyl group with a carbon number of 5 to 24, a cyclic alkyl group with a carbon number of 5 to 24, or an alkoxy group with a carbon number of 5 to 24. Note that the alkyl group contained in the alkoxy group may be linear, branched, or cyclic.

The substituent represented by $Z^1$, $Z^2$, $Z^3$, and $Z^4$ is also preferably a group containing a curable group such as a (meth)acryloyl group, an epoxy group, and/or an oxetanyl group. Examples of the group containing a curable group include "-O-alkylene group-(-O-alkylene group-)$_{AL}$-(meth)acryloyloxy group". AL represents an integer of 0 to 5. AL is preferably 1. The aforementioned alkylene groups preferably each independently have a carbon number of 1 to 10. In a case where each of the alkylene groups has a substituent, the substituent is preferably a hydroxyl group.

The substituent may be a group containing an onium structure.

The group containing an onium structure is a group having an anionic moiety and a cationic moiety. Examples of the anionic moiety include a partial structure containing an oxygen anion ($-O^-$). Particularly, the oxygen anion ($-O^-$) is preferably directly bonded to the terminal of the repeating structure having n, m, p, or q in the repeating unit represented by any of Formulas (1) to (4), and more preferably directly bonded to the terminal of the repeating structure having n in the repeating unit represented by Formula (1) (that is, the right terminal in $-(-O-C_jH_{2j}-CO-)_n-$).

Examples of the cation in the cationic moiety of the group containing an onium structure include an ammonium cation. In a case where the cationic moiety is an ammonium cation, the cationic moiety is a partial structure containing a cationic nitrogen atom ($>N^+<$). The cationic nitrogen atom ($>N^+<$) is preferably bonded to 4 substituents (preferably organic groups), and 1 to 4 out of the substituents are preferably an alkyl group with a carbon number of 1 to 15. One or more out of the 4 substituents (preferably one of the 4 substituents) are also preferably a group containing a curable group such as a (meth)acryloyl, an epoxy group, and/or an oxetanyl group. Examples of the group containing a curable group that can be the substituent include "-O-alkylene group-(-O-alkylene group-)$_{AL}$-(meth)acryloyloxy group" described above and "-alkylene group-(-O-alkylene group-)$_{AL1}$-(meth)acryloyloxy group". AL1 represents an integer of 1 to 5. AL is preferably 1. The aforementioned alkylene groups preferably each independently have a carbon number

of 1 to 10. In a case where each of the alkylene groups has a substituent, the substituent is preferably a hydroxyl group.

In Formulas (1) to (4), n, m, p, and q each independently represent an integer of 1 to 500.

In Formulas (1) and (2), j and k each independently represent an integer of 2 to 8. Each of j and k in Formulas (1) and (2) is preferably an integer of 4 to 6, and more preferably 5.

In Formulas (1) and (2), each of n and m is, for example, an integer of 2 or more, preferably an integer of 6 or more, more preferably an integer of 10 or more, and even more preferably an integer of 20 or more. In a case where the resin A contains a polycaprolactone structure and a polyvalerolactone structure, the sum of the repetition number of the polycaprolactone structure and the repetition number of polyvalerolactone is preferably an integer of 10 or more, and more preferably an integer of 20 or more.

In Formula (3), $R^3$ represents a branched or linear alkylene group which is preferably an alkylene group with a carbon number of 1 to 10, and more preferably an alkylene group with a carbon number of 2 or 3. In a case where p is 2 to 500, a plurality of $R^3$'s may be the same or different from each other.

In Formula (4), $R^4$ represents a hydrogen atom or a monovalent organic group, and the structure of the monovalent substituent is not particularly limited. $R^4$ is preferably a hydrogen atom, an alkyl group, an aryl group, or a heteroaryl group, and more preferably a hydrogen atom or an alkyl group. In a case where $R^4$ is an alkyl group, the alkyl group is preferably a linear alkyl group with a carbon number of 1 to 20, a branched alkyl group with a carbon number of 3 to 20, or a cyclic alkyl group with a carbon number of 5 to 20, more preferably a linear alkyl group with a carbon number of 1 to 20, and even more preferably a linear alkyl group with a carbon number of 1 to 6. In a case where q in Formula (4) is 2 to 500, a plurality of $X^5$'s and $R^4$' s in the graft chain may be the same or different from each other.

The resin A may contain two or more repeating units having different structures and having a graft chain. That is, the molecule of the resin A may contain repeating units represented by Formulas (1) to (4) having different structures. Furthermore, in a case where n, m, p, and q in Formulas (1) to (4) each represent an integer of 2 or more, the side chains in Formulas (1) and (2) may contain structures where j and k represent different integers, and a plurality of $R^3$' s, $R^4$'s, and $X^5$'s in the molecules of Formulas (3) and (4) may be the same or different from each other.

The repeating unit represented by Formula (1) is more preferably a repeating unit represented by the following Formula (1A).

The repeating unit represented by Formula (2) is more preferably a repeating unit represented by the following Formula (2A).

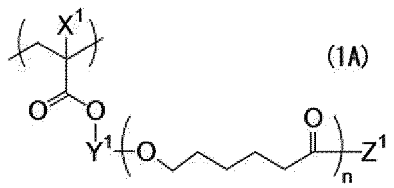
(1A)

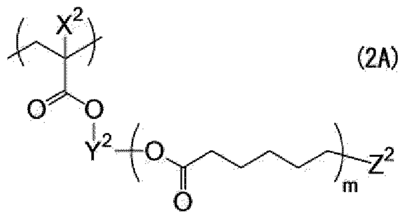
(2A)

$X^1$, $Y^1$, $Z^1$, and n in Formula (1A) have the same definitions as $X^1$, $Y^1$, $Z^1$, and n in Formula (1), and preferable ranges thereof are the same as well. $X^2$, $Y^2$, $Z^2$, and m in Formula (2A) have the same definitions as $X^2$, $Y^2$, $Z^2$, and m in Formula (2), and preferable ranges thereof are the same as well.

The repeating unit represented by Formula (3) is more preferably a repeating unit represented by the following Formula (3A) or the following Formula (3B).

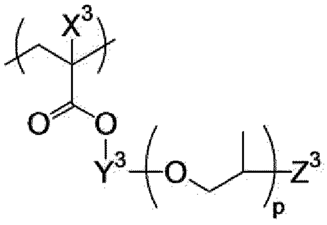

(3A)

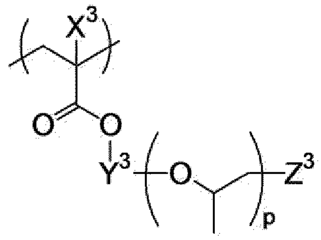

(3B)

$X^3$, $Y^3$, $Z^3$, and p in Formula (3A) or (3B) have the same definitions as $X^3$, $Y^3$, $Z^3$, and p in Formula (3), and preferable ranges thereof are the same as well.

It is more preferable that the resin A contain the repeating unit represented by Formula (1A) as the repeating unit having a graft chain.

In a case where the resin A contains the repeating unit represented by Formulas (1) to (4), it is also preferable that the resin A further contain, as another repeating unit having a graft chain, a repeating unit represented by the following Formula (5).

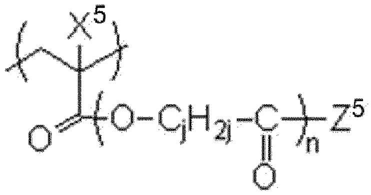

(5)

In Formula (5), n represents an integer of 1 to 50. n is preferably an integer of 2 to 30, more preferably an integer of 2 to 10, and even more preferably an integer of 2 to 5.

j represents an integer of 2 to 8. j is preferably an integer of 4 to 6, and more preferably 5.

$X^5$ and $Z^5$ in Formula (5) have the same definitions as $X^1$ and $Z^1$ in Formula (1) respectively, and suitable aspects thereof are also the same.

It is also preferable that the resin A contain a repeating unit containing a polyalkylene imine structure and a polyester structure. It is preferable that the repeating unit containing a polyalkylene imine structure and a polyester structure contain the polyalkylene imine structure on the main chain and contain the polyester structure as a graft chain.

The polyalkylene imine structure is a polymerization structure having two or more identical or different alkylene imine chains. Specific examples of the alkylene imine chain include alkylene imine chains represented by the following Formula (4A) and the following Formula (4B).

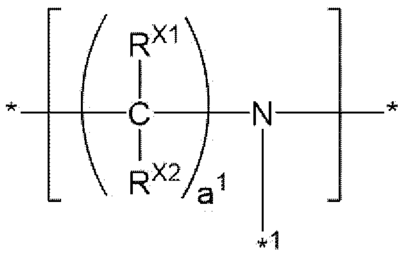

(4A)

In Formula (4A), $R^{x1}$ and $R^{x2}$ each independently represent a hydrogen atom or an alkyl group. $a^1$ represents an integer of 2 or more. $*^1$ represents a bonding position to a polyester chain, an adjacent alkylene imine chain, a hydrogen atom, or a substituent.

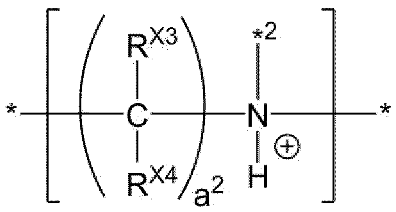

(4B)

In Formula (4B), $R^{x3}$ and $R^{x4}$ each independently represent a hydrogen atom or an alkyl group. $a^2$ represents an integer of 2 or more. The alkylene imine chain represented by Formula (4B) is bonded to a polyester chain having an anionic group by the formation of a salt crosslinking group of $N^+$ shown in Formula (4B) and an anionic group contained in the polyester chain.

* in Formula (4A) and Formula (4B) and $*^2$ in Formula (4B) each independently represent a position to be bonded to an adjacent alkylene imine chain, a hydrogen atom, or a substituent.
* in Formula (4A) and Formula (4B) particularly preferably represent a position to be bonded to an adjacent alkylene imine chain.

$R^{X1}$ and $R^{X2}$ in Formula (4A) and $R^{X3}$ and $R^{X4}$ in Formula (4B) each independently represent a hydrogen atom or an alkyl group.
The carbon number of the alkyl group is preferably 1 to 6, and more preferably 1 to 3.
It is preferable that $R^{x1}$ and $R^{x2}$ in Formula (4A) both represent a hydrogen atom.
It is preferable that $R^{x3}$ and $R^{x4}$ in Formula (4B) both represent a hydrogen atom.
$a^1$ in Formula (4A) and $a^2$ in Formula (4B) are not particularly limited as long as $a^1$ and $a^2$ each represent an integer of 2 or more. The upper limit of $a^1$ and $a^2$ is preferably 10 or less, more preferably 6 or less, even more preferably 4 or less, still more preferably 2 or 3, and particularly preferably 2.
**[0147]** * in Formula (4A) and Formula (4B) represents a bonding position to an adjacent alkylene imine chain, a hydrogen atom, or a substituent.
Examples of the aforementioned substituent include a substituent such as an alkyl group (for example, an alkyl group with a carbon number of 1 to 6). Furthermore, a polyester chain may be bonded thereto as a substituent.
The alkylene imine chain represented by Formula (4A) is preferably linked to the polyester chain at the position represented by $*^1$ described above. Specifically, it is preferable that the carbonyl carbon in the polyester chain be bonded at the position represented by $*^1$ described above.
Examples of the polyester chain include a polyester chain represented by the following formula (5A).

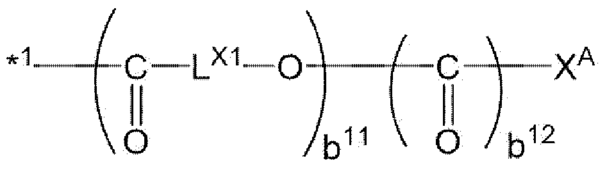

(5A)

In a case where the alkylene imine chain is an alkylene imine chain represented by Formula (4B), it is preferable that the polyester chain contain an anion (preferably an oxygen anion $O^-$), and that the anion and $N^+$ in Formula (4B) form a salt crosslinking group.
Examples of such a polyester chain include a polyester chain represented by the following Formula (5B).

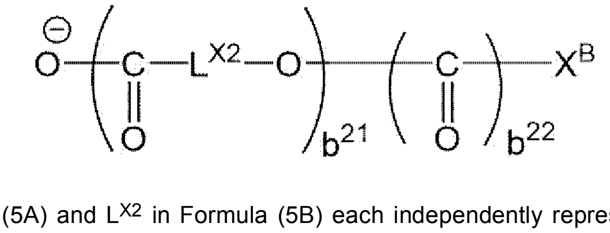

(5B)

$L^{X1}$ in Formula (5A) and $L^{X2}$ in Formula (5B) each independently represent a divalent linking group. Preferred examples of the divalent linking group include an alkylene group with a carbon number of 3 to 30.
$b^{11}$ in Formula (5A) and $b^{21}$ in Formula (5B) each independently represent an integer of 2 or more. Each of $b^{11}$ and $b^{21}$ is preferably an integer of 6 or more, and the upper limit thereof is, for example, 200 or less.

$b^{12}$ in Formula (5A) and $b^{22}$ in Formula (5B) each independently represent 0 or 1.

$X^A$ in Formula (5A) and $X^B$ in Formula (5B) each independently represent a hydrogen atom or a substituent. Examples of the substituent include an alkyl group, an alkoxy group, a polyalkyleneoxyalkyl group, an aryl group, and the like.

The carbon number of the aforementioned alkyl group (the alkyl group may be any of linear, branch, and cyclic alkyl groups) and the carbon number of an alkyl group (the alkyl group may be any of linear, branch, and cyclic alkyl groups) contained in the aforementioned alkoxy group are, for example, 1 to 30, and preferably 1 to 10. The aforementioned alkyl group may further have a substituent. Examples of the substituent include a hydroxyl group and a halogen atom (the halogen atom includes a fluorine atom, a chlorine atom, a bromine atom, an iodine atom, and the like).

The polyalkyleneoxyalkyl group is a substituent represented by $R^{X6}(OR^{X7})_p(O)_q$-. $R^{X6}$ represents an alkyl group, $R^{X7}$ represents an alkylene group, p represents an integer of 2 or more, and q represents 0 or 1.

The alkyl group represented by $R^{X6}$ has the same definition as the alkyl group represented by $X^A$. Examples of the alkylene group represented by $R^{X7}$ include a group obtained by removing one hydrogen atom from the alkyl group represented by $X^A$.

p is an integer of 2 or more, and the upper limit thereof is, for example, 10 or less, and preferably 5 or less.

Examples of the aryl group include an aryl group (which may be monocyclic or polycyclic) with a carbon number of 6 to 24.

The aforementioned aryl group may further have a substituent. Examples of the substituent include an alkyl group, a halogen atom, a cyano group, and the like.

The aforementioned polyester chain is preferably a structure established by ring opening of lactones such as ε-caprolactone, δ-caprolactone, β-propiolactone, γ-butyrolactone, δ-valerolactone, y-valerolactone, enanthonolactone, β-butyrolactone, γ-hexanolactone, γ-octanolactone, δ-hexanolactone, δ-octanolactone, δ-dodecanolactone, α-methyl-γ-butyrolactone, and lactide (which may be L-lactide or D-lactide), and more preferably a structure established by ring opening of ε-caprolactone or δ-valerolactone.

The aforementioned repeating unit containing a polyalkylene imine structure and a polyester structure can be synthesized according to the synthesis method described in JP5923557B.

In the resin A, the content of the repeating unit having a graft chain expressed in terms of mass with respect to the total mass of the resin A is, for example, 2% to 100% by mass, preferably 2% to 95% by mass, more preferably 2% to 90% by mass, and even more preferably 5% to 30% by mass. In a case where the content of the repeating unit having a graft chain is in this range, the effects of the present invention are further improved.

(Hydrophobic repeating unit)

The resin A may contain a hydrophobic repeating unit that is different from the repeating unit having a graft chain (that is, does not correspond to the repeating unit having a graft chain). In the present specification, the hydrophobic repeating unit refers to a repeating unit having no acid group (for example, a carboxylic acid group, a sulfonic acid group, a phosphoric acid group, a phenolic hydroxyl group, and the like).

The hydrophobic repeating unit is preferably a repeating unit derived from (corresponding to) a compound (monomer) having a ClogP value of 1.2 or more, and is more preferably a repeating unit derived from a compound having a ClogP value of 1.2 to 8. In a case where this hydrophobic repeating unit is used, the effects of the present invention can be more reliably expressed.

The ClogP value is a value calculated by a program "CLOGP" available from Daylight Chemical Information System, Inc. This program provides a value of "calculated logP" calculated by the fragment approach (see the following documents) of Hansch and Leo. The fragment approach is based on the chemical structure of a compound. In this method, the chemical structure is divided into partial structures (fragments), and degrees of contribution to logP that are assigned to the fragments are summed up, thereby estimating the logP value of the compound. Details of the method are described in the following documents. In the present specification, a ClogP value calculated by a program CLOGP v 4.82 is used.

A. J. Leo, Comprehensive Medicinal Chemistry, Vol. 4, C. Hansch, P. G. Sammnens, J. B. Taylor and C. A. Ramsden, Eds., p. 295, Pergamon press, 1990, C. Hansch & A. J. Leo. Substituent Constants For Correlation Analysis in Chemistry and Biology. John Wiley & Sons. A. J. Leo. Calculating logPoct from structure. Chem. Rev., 93, 1281-1306, 1993.

logP means a common logarithm of a partition coefficient P. logP is a value of physical properties that shows how a certain organic compound is partitioned in an equilibrium of two-phase system consisting of oil (generally, 1-octanol) and water by using a quantitative numerical value. logP is represented by the following equation.

$$\log P = \log(\mathrm{Coil}/\mathrm{Cwater})$$

In the formula, Coil represents a molar concentration of a compound in an oil phase, and Cwater represents a molar concentration of the compound in a water phase.

The greater the positive logP value based on 0, the higher the oil solubility. The greater the absolute value of negative logP, the higher the water solubility. The value of logP is negatively correlated with the water solubility of an organic compound, and widely used as a parameter for estimating the hydrophilicity and hydrophobicity of an organic compound.

It is preferable that the resin A contain, as the hydrophobic repeating unit, one or more repeating units selected from repeating units derived from the monomers represented by the following Formulas (i) to (iii).

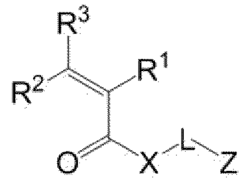

(i)

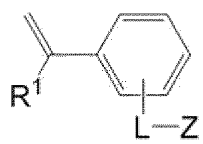

(ii)

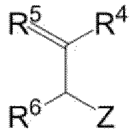

(iii)

In the above Formulas (i) to (iii), $R^1$, $R^2$, and $R^3$ each independently represent a hydrogen atom, a halogen atom (for example, a fluorine atom, a chlorine atom, a bromine atom, or the like), or an alkyl group with a carbon number of 1 to 6 (for example, a methyl group, an ethyl group, a propyl group, or the like).

Each of $R^1$, $R^2$, and $R^3$ is preferably a hydrogen atom or an alkyl group with a carbon number of 1 to 3, and more preferably a hydrogen atom or a methyl group. Each of $R^2$ and $R^3$ is even more preferably a hydrogen atom.

X represents an oxygen atom (-O-) or an imino group (-NH-), and is preferably an oxygen atom.

L represents a single bond or a divalent linking group. Examples of the divalent linking group include a divalent aliphatic group (for example, an alkylene group, a substituted alkylene group, an alkenylene group, a substituted alkenylene group, an alkynylene group, or a substituted alkynylene group), a divalent aromatic group (for example, an arylene group or a substituted arylene group), a divalent heterocyclic group, an oxygen atom (-O-), a sulfur atom (-S-), an imino group (-NH-), a substituted imino group ($-NR^{31}-$, where $R^{31}$ is an aliphatic group, an aromatic group, or a heterocyclic group), a carbonyl group (-CO-), a combination of these, and the like.

The divalent aliphatic group may have a cyclic structure or a branched structure. The carbon number of the aliphatic group is preferably 1 to 20, more preferably 1 to 15, and even more preferably 1 to 10. The aliphatic group may be an unsaturated aliphatic group or a saturated aliphatic group, and is preferably a saturated aliphatic group. Furthermore, the aliphatic group may have a substituent. Examples of the substituent include a halogen atom, an aromatic group, a heterocyclic group, and the like.

The carbon number of the divalent aromatic group is preferably 6 to 20, more preferably 6 to 15, and even more preferably 6 to 10. Furthermore, the aromatic group may have a substituent. Examples of the substituent include a halogen atom, an aliphatic group, an aromatic group, a heterocyclic group, and the like.

It is preferable that the divalent heterocyclic group contain a 5-membered ring or a 6-membered ring as the heterocycle. Another heterocycle, aliphatic ring, or aromatic ring may be condensed with the heterocycle. Furthermore, the heterocyclic group may have a substituent. Examples of the substituent include a halogen atom, a hydroxyl group, an oxo group (=O), a thioxo group (=S), an imino group (=NH), a substituted imino group ($=N-R^{32}$, where $R^{32}$ is an aliphatic group, an aromatic group, or a heterocyclic group), an aliphatic group, an aromatic group, and a heterocyclic group.

L is preferably a single bond or a divalent linking group containing an alkylene group or an oxyalkylene structure. The oxyalkylene structure is more preferably an oxyethylene structure or an oxypropylene structure. Furthermore, L may contain a polyoxyalkylene structure containing two or more repeating oxyalkylene structures. As the polyoxyalkylene structure, a polyoxyethylene structure or a polyoxypropylene structure is preferable. The polyoxyethylene structure is

represented by $-(OCH_2CH_2)n-$. n is preferably an integer of 2 or more, and more preferably an integer of 2 to 10.

Examples of Z include an aliphatic group (for example, an alkyl group, a substituted alkyl group, an unsaturated alkyl group, or a substituted unsaturated alkyl group), an aromatic group (for example, an aryl group, a substituted aryl group, an arylene group, or a substituted arylene group), a heterocyclic group, and a combination of these. These groups may contain an oxygen atom (-O-), a sulfur atom (-S-), an imino group (-NH-), a substituted imino group ($-NR^{31}-$, where $R^{31}$ is an aliphatic group, an aromatic group, or a heterocyclic group), or a carbonyl group (-CO-).

The aliphatic group may have a cyclic structure or a branched structure. The carbon number of the aliphatic group is preferably 1 to 20, more preferably 1 to 15, and even more preferably 1 to 10. The aliphatic group further contains a ring assembly hydrocarbon group and a crosslinked cyclic hydrocarbon group. Examples of the ring assembly hydrocarbon group include a bicyclohexyl group, a perhydronaphthalenyl group, a biphenyl group, a 4-cyclohexylphenyl group, and the like. Examples of a crosslinked cyclic hydrocarbon ring include a bicyclic hydrocarbon ring such as a pinane, bornane, norpinane, norbornane, or bicyclooctane ring (such as a bicyclo[2.2.2]octane ring or a bicyclo[3.2.1]octane ring), a tricyclic hydrocarbon ring such as a homobredane, adamantane, tricyclo[5.2.1.$0^{2,6}$]decane, or tricyclo[4.3.1.$1^{2,5}$]undecane ring, a tetracyclic hydrocarbon ring such as a tetracyclo[4.4.0.$1^{2,5}$.$1^{7,10}$]dodecane or perhydro-1,4-methano-5,8-methanonaphthalene ring, and the like. In addition, the crosslinked cyclic hydrocarbon ring also includes fused hydrocarbon rings, for example, fused rings consisting of a plurality of condensed 5- to 8-membered cycloalkane rings such as perhydronaphthalene (decalin), perhydroanthracene, perhydrophenanthrene, perhydroacenaphtene, perhydrofluorene, perhydroindene, and perhydrophenanthrene rings.

As the aliphatic group, a saturated aliphatic group is preferred over an unsaturated aliphatic group. Furthermore, the aliphatic group may have a substituent. Examples of the substituent thereof include a halogen atom, an aromatic group, and a heterocyclic group. Here, the aliphatic group does not have an acid group as a substituent.

The carbon number of the aromatic group is preferably 6 to 20, more preferably 6 to 15, and even more preferably 6 to 10. Furthermore, the aromatic group may have a substituent. Examples of the substituent include a halogen atom, an aliphatic group, an aromatic group, and a heterocyclic group. Here, the aromatic group does not have an acid group as a substituent.

It is preferable that the heterocyclic group contain a 5-membered ring or a 6-membered ring as the heterocycle. Another heterocycle, aliphatic ring, or aromatic ring may be condensed with the heterocycle. Furthermore, the heterocyclic group may have a substituent. Examples of the substituent include a halogen atom, a hydroxyl group, an oxo group (=O), a thioxo group (=S), an imino group (=NH), a substituted imino group ($=N-R^{32}$, where $R^{32}$ is an aliphatic group, an aromatic group, or a heterocyclic group), an aliphatic group, an aromatic group, and a heterocyclic group. Here, the heterocyclic group does not have an acid group as a substituent.

In the above Formula (iii), $R^4$, $R^5$, and $R^6$ each independently represent a hydrogen atom, a halogen atom (for example, a fluorine atom, a chlorine atom, a bromine atom, or the like), an alkyl group with a carbon number of 1 to 6 (for example, a methyl group, an ethyl group, a propyl group, or the like), Z, or L-Z. Here, L and Z have the same definition as the aforementioned groups represented by L and Z. Each of $R^4$, $R^5$, and $R^6$ is preferably a hydrogen atom or an alkyl group with a carbon number of 1 to 3, and more preferably a hydrogen atom.

As the monomer represented by the above Formula (i), a compound is preferably in which each of $R^1$, $R^2$, and $R^3$ is a hydrogen atom or a methyl group, L is a single bond or a divalent linking group containing an alkylene group or an oxyalkylene structure, X is an oxygen atom or an imino group, and Z is an aliphatic group, a heterocyclic group, or an aromatic group.

As the monomer represented by the above Formula (ii), a compound is preferable in which $R^1$ is a hydrogen atom or a methyl group, L is an alkylene group, and Z is an aliphatic group, a heterocyclic group, or an aromatic group. Furthermore, as the monomer represented by the above Formula (iii), a compound is preferable in which each of $R^4$, $R^5$, and $R^6$ is a hydrogen atom or a methyl group, and Z is an aliphatic group, a heterocyclic group, or an aromatic group.

Examples of typical compounds represented by Formulas (i) to (iii) include a radically polymerizable compound selected from acrylic acid esters, methacrylic acid esters, styrenes, and the like.

As examples of the typical compounds represented by Formulas (i) to (iii), the compounds described in paragraphs "0089" to "0093" of JP2013-249417A can be referred to, and what are described in the paragraphs are incorporated into the present specification.

In the resin A, the content of the hydrophobic repeating unit, expressed in terms of mass, with respect to the total mass of the resin A is preferably 10% to 90% by mass, and more preferably 20% to 80% by mass.

(Functional group capable of interacting with magnetic particles)

The resin A may have a functional group capable of interacting with the magnetic particles.

It is preferable that the resin A further contain a repeating unit containing a functional group that is capable of interacting with the magnetic particles.

Examples of the functional group capable of interacting with the magnetic particles include an acid group, a

basic group, a coordinating group, a reactive functional group, and the like.

In a case where the resin A contains an acid group, a basic group, a coordinating group, or a reactive functional group, it is preferable that the resin A contain a repeating unit containing an acid group, a repeating unit containing a basic group, a repeating unit containing a coordinating group, or a repeating unit having a reactive functional group.

The repeating unit containing an acid group may be a repeating unit that is the same as or different from the aforementioned repeating unit having a graft chain. However, the repeating unit containing an acid group is a repeating unit different from the aforementioned hydrophobic repeating unit (that is, does not correspond to the aforementioned hydrophobic repeating unit).

Examples of the acid group which is a functional group capable of interacting with the magnetic particles include a carboxylic acid group, a sulfonic acid group, a phosphoric acid group, a phenolic hydroxyl group, and the like. The acid group is preferably at least one group among a carboxylic acid group, a sulfonic acid group, and a phosphoric acid group, and more preferably a carboxylic acid group. The carboxylic acid group has excellent adsorptive force with respect to the magnetic particles and has high dispersibility.

That is, it is preferable that the resin A further contain a repeating unit containing at least one group among a carboxylic acid group, a sulfonic acid group, and a phosphoric acid group.

The resin A may have one repeating unit containing an acid group or two or more such repeating units.

In a case where the resin A contains the repeating unit containing an acid group, the content of the repeating unit expressed in terms of mass with respect to the total mass of the resin A is preferably 5% to 80% by mass, and more preferably 10% to 60% by mass.

Examples of the basic group which is a functional group capable of interacting with the magnetic particles include a primary amino group, a secondary amino group, a tertiary amino group, a heterocycle containing a N atom, an amide group, and the like. As the basic group, in view of excellent adsorptive force with respect to the magnetic particles and high dispersibility, a tertiary amino group is preferable. The resin A may contain one basic group described above or two or more basic groups described above.

In a case where the resin A contains the repeating unit containing a basic group, the content of the repeating unit expressed in terms of mass with respect to the total mass of the resin A is preferably 0.01% to 50% by mass, and more preferably 0.01% to 30% by mass.

Examples of the coordinating group and the reactive functional group which are functional groups capable of interacting with the magnetic particles include an acetylacetoxy group, a trialkoxysilyl group, an isocyanate group, an acid anhydride, an acid chloride, and the like. As these functional groups, in view of excellent adsorptive force with respect to the magnetic particles and high dispersibility of the magnetic particles, an acetylacetoxy group is preferable. The resin A may have one of these groups or two or more of these groups.

In a case where the resin A contains the repeating unit containing a coordinating group or the repeating unit containing a reactive functional group, the content of the repeating unit expressed in terms of mass with respect to the total mass of the resin A is preferably 10% to 80% by mass, and more preferably 20% to 60% by mass.

In a case where the resin A contains, in addition to a graft chain, a functional group capable of interacting with the magnetic particles, the resin A may contain a functional group capable of interacting with various magnetic particles described above, and the way the functional group is introduced into the resin A is not particularly limited. For example, it is preferable that the resin to be incorporated into the composition contain one or more repeating units selected from repeating units derived from the monomers represented by the following Formulas (iv) to (vi).

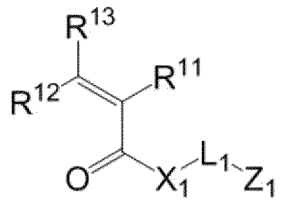

(iv)

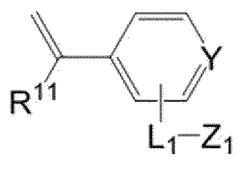

(v)

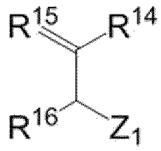

(vi)

In Formulas (iv) to (vi), $R^{11}$, $R^{12}$, and $R^{13}$ each independently represent a hydrogen atom, a halogen atom (for example, a fluorine atom, a chlorine atom, a bromine atom, or the like), or an alkyl group with a carbon number of 1 to 6 (for example, a methyl group, an ethyl group, a propyl group, or the like).

In Formulas (iv) to (vi), each of $R^{11}$, $R^{12}$, and $R^{13}$ is preferably a hydrogen atom or an alkyl group with a carbon number of 1 to 3, and more preferably a hydrogen atom or a methyl group. Each of $R^{12}$ and $R^{13}$ in Formula (iv) is even more preferably a hydrogen atom.

$X_1$ in Formula (iv) represents an oxygen atom (-O-) or an imino group (-NH-), and is preferably an oxygen atom. Y in Formula (v) represents a methine group or a nitrogen atom.

$L_1$ in Formulas (iv) to (v) represents a single bond or a divalent linking group. The divalent linking group has the same definition as the divalent linking group represented by L in Formula (i) described above.

$L_1$ is preferably a single bond or a divalent linking group containing an alkylene group or an oxyalkylene structure. The oxyalkylene structure is more preferably an oxyethylene structure or an oxypropylene structure. Furthermore, $L_1$ may contain a polyoxyalkylene structure including two or more repeating oxyalkylene structures. As the polyoxyalkylene structure, a polyoxyethylene structure or a polyoxypropylene structure is preferable. The polyoxyethylene structure is represented by $-(OCH_2CH_2)n-$. n is preferably an integer of 2 or more, and more preferably an integer of 2 to 10.

In Formulas (iv) to (vi), $Z_1$ represents a functional group that is capable of interacting with the magnetic particles as well in addition to the graft chain. $Z_1$ is preferably a carboxylic acid group or a tertiary amino group, and more preferably a carboxylic acid group.

In Formula (vi), $R^{14}$, $R^{15}$, and $R^{16}$ each independently represent a hydrogen atom, a halogen atom (for example, a fluorine atom, a chlorine atom, a bromine atom, or the like), an alkyl group with a carbon number of 1 to 6 (for example, a methyl group, an ethyl group, a propyl group, or the like), $-Z_1$, or $L_1-Z_1$. Here, $L_1$ and $Z_1$ have the same definitions as $L_1$ and $Z_1$ described above, and preferred examples thereof are also the same. Each of $R^{14}$, $R^{15}$, and $R^{16}$ is preferably a hydrogen atom or an alkyl group with a carbon number of 1 to 3, and more preferably a hydrogen atom.

As the monomer represented by Formula (iv), a compound is preferable in which $R^{11}$, $R^{12}$, and $R^{13}$ each independently represent a hydrogen atom or a methyl group, $L_1$ is a divalent linking group containing an alkylene group or an oxyalkylene structure, $X_1$ is an oxygen atom or an imino group, and $Z_1$ is a carboxylic acid group.

As the monomer represented by Formula (v), a compound is preferable in which $R^{11}$ is a hydrogen atom or a methyl group, $L_1$ is an alkylene group, $Z_1$ is a carboxylic acid group, and Y is a methine group.

Furthermore, as the monomer represented by Formula (vi), a compound is preferable in which $R^{14}$, $R^{15}$, and $R^{16}$ each independently represent a hydrogen atom or a methyl group, and $Z_1$ is a carboxylic acid group.

Typical examples of the monomers (compounds) represented by Formulas (iv) to (vi) will be shown below.

Examples of the monomers include methacrylic acid, crotonic acid, isocrotonic acid, a reactant of a compound containing an addition-polymerizable double bond and a hydroxyl group in a molecule (for example, 2-hydroxyethyl methacrylate) and a succinic anhydride, a reactant of a compound containing an addition-polymerizable double bond and a hydroxyl group in a molecule and a phthalic anhydride, a reactant of a compound containing an addition-polymerizable double bond and a hydroxyl group in a molecule and a tetrahydroxyphthalic anhydride, a reactant of a compound containing an addition-polymerizable double bond and a hydroxyl group in a molecule and a trimellitic anhydride, a reactant of a compound containing an addition-polymerizable double bond and a hydroxyl group in a molecule and a pyromellitic anhydride, acrylic acid, an acrylic acid dimer, an acrylic acid oligomer, maleic acid, itaconic acid, fumaric acid, 4-vinylbenzoic acid, vinylphenol, 4-hydroxyphenyl methacrylamide, and the like.

In view of interaction with the magnetic particles, temporal stability, and permeability with respect to a developer, the content of the repeating unit containing a functional group capable of interacting with the magnetic particles, the content being expressed in terms of mass, with respect to the total mass of the resin A is preferably 0.05% to 90% by mass, more preferably 1.0% to 80% by mass, and even more preferably 10% to 70% by mass.

(Ethylenically unsaturated group)

The resin A may contain an ethylenically unsaturated group.

The ethylenically unsaturated group is not particularly limited, and examples thereof include a (meth)acryloyl group, a vinyl group, a styryl group, and the like. Among these, a (meth)acryloyl group is preferable.

Particularly, the resin A preferably contains a repeating unit that contains an ethylenically unsaturated group on a side chain, and more preferably contains a repeating unit that contains an ethylenically unsaturated group on a

side chain and is derived from (meth)acrylate (hereinafter, such a repeating unit will be also called "(meth)acrylic repeating unit containing an ethylenically unsaturated group on a side chain").

The (meth)acrylic repeating unit containing an ethylenically unsaturated group on a side chain is obtained, for example, by causing an addition reaction between a carboxylic acid group in the resin A containing a (meth)acrylic repeating unit containing the carboxylic acid group and an ethylenically unsaturated compound containing a glycidyl group or an alicyclic epoxy group. Introducing an ethylenically unsaturated group in this way makes it possible to obtain a (meth)acrylic repeating unit containing an ethylenically unsaturated group on a side chain.

In a case where the resin A contains the repeating unit containing an ethylenically unsaturated group, the content of the repeating unit expressed in terms of mass with respect to the total mass of the resin A is preferably 30% to 70% by mass, and more preferably 40% to 60% by mass.

(Other curable groups)

The resin A may contain other curable groups in addition to the ethylenically unsaturated group.

Examples of those other curable groups include an epoxy group and an oxetanyl group.

Particularly, the resin A preferably contains a repeating unit that contains those other curable groups on a side chain, and more preferably contains a repeating unit that contains those other curable groups on a side chain and is derived from (meth)acrylate (hereinafter, such a repeating unit will be also called "(meth)acrylic repeating unit containing other curable groups on a side chain").

Examples of the (meth)acrylic repeating unit containing other curable groups on a side chain include a repeating unit derived from glycidyl (meth)acrylate.

In a case where the resin A contains the repeating unit containing other curable groups, the content of the repeating unit expressed in terms of mass with respect to the total mass of the resin A is preferably 5% to 50% by mass, and more preferably 10% to 30% by mass.

(Other repeating units)

For the purpose of improving various performances such as film forming performance, as long as the effects of the present invention are not impaired, the resin A may further have other repeating units having various functions different from the repeating unit described above.

Examples of those other repeating units include repeating units derived from radically polymerizable compounds selected from acrylonitriles, methacrylonitriles, and the like.

For the resin A, one of those other repeating units or two or more of those other repeating units can be used. The content of those other repeating units expressed in terms of mass with respect to the total mass of the resin A is preferably 0% to 80% by mass, and more preferably 10% to 60% by mass.

(Physical properties of resin A)

The acid value of the resin A is not particularly limited. For example, the acid value is preferably 0 to 400 mgKOH/g, more preferably 10 to 350 mgKOH/g, even more preferably 30 to 300 mgKOH/g, and particularly preferably in a range of 50 to 200 mgKOH/g.

In a case where the acid value of the resin A is 50 mgKOH/g or more, the sedimentation stability of the magnetic particles can be further improved.

In the present specification, the acid value can be calculated, for example, from the average content of acid groups in a compound. Furthermore, changing the content of the repeating unit containing an acid group in the resin makes it possible to obtain a resin having a desired acid value.

The weight-average molecular weight of the resin A is not particularly limited. For example, the weight-average molecular weight is preferably 3,000 or more, more preferably 4,000 or more, even more preferably 5,000 or more, and particularly preferably 6,000 or more. The upper limit of the weight-average molecular weight is, for example, preferably 300,000 or less, more preferably 200,000 or less, even more preferably 100,000 or less, and particularly preferably 50,000 or less.

The resin A can be synthesized based on a known method.

For specific examples of the resin A, the polymer compounds described in paragraphs "0127" to "0129" of JP2013-249417A can be referred to, and what are described in the paragraphs are incorporated into the present specification.

As the resin A, the graft copolymers in paragraphs "0037" to "0115" of JP2010-106268A (paragraphs "0075" to "0133" of US2011/0124824 corresponding to JP2010-106268A) can also be used, and what are described in the paragraphs can be cited and incorporated into the present specification.

<Alkali-soluble resin>

The binder component may include an alkali-soluble resin.

In the present specification, the alkali-soluble resin means a resin that contains a group (alkali-soluble group, for example, an acid group such as a carboxylic acid group) enhancing alkali solubility and is different from the resin A described above.

Examples of the alkali-soluble resin include a resin containing at least one alkali-soluble group in a molecule. Examples thereof include a polyhydroxystyrene resin, a polysiloxane resin, a (meth)acrylic resin, a (meth)acrylamide resin, a (meth)acrylic/(meth)acrylamide copolymer, an epoxy resin, a polyimide resin, and the like.

Specific examples of the alkali-soluble resin include a copolymer of an unsaturated carboxylic acid and an ethylenically unsaturated compound.

The unsaturated carboxylic acid is not particularly limited, and examples thereof include monocarboxylic acid such as (meth)acrylic acid, crotonic acid, and vinylacetic acid; dicarboxylic acids such as itaconic acid, maleic acid, and fumaric acid or anhydrides of these acids; polyvalent carboxylic acid monoesters such as mono(2-(meth)acryloyloxyethyl)phthalate; and the like.

Examples of copolymerizable ethylenically unsaturated compounds include methyl (meth)acrylate and the like. Furthermore, the compounds described in paragraphs "0027" of JP2010-097210A and paragraphs "0036" and "0037" of JP2015-068893A can also be used, and what are described in the above paragraphs are incorporated into the present specification.

Furthermore, a compound that is a copolymerizable ethylenically unsaturated compound and contains an ethylenically unsaturated group on a side chain may also be used in combination. That is, the alkali-soluble resin may contain a repeating unit containing an ethylenically unsaturated group on a side chain.

As the ethylenically unsaturated group contained on a side chain, a (meth)acrylic acid group is preferable.

The repeating unit containing an ethylenically unsaturated group on a side chain is obtained, for example, by causing an addition reaction between a carboxylic acid group of a (meth)acrylic repeating unit containing the carboxylic acid group and an ethylenically unsaturated compound containing a glycidyl group or an alicyclic epoxy group.

As the alkali-soluble resin, an alkali-soluble resin containing a curable group is also preferable.

Examples of the curable group include an ethylenically unsaturated group (for example, a (meth)acryloyl group, a vinyl group, a styryl group, or the like), a cyclic ether group (for example, an epoxy group, an oxetanyl group, or the like), and the like. However, the curable group is not limited to these.

As the curable group, among these, in view of making it possible to control polymerization by a radical reaction, an ethylenically unsaturated group is preferable, and a (meth)acryloyl group is more preferable.

As the alkali-soluble resin containing a curable group, an alkali-soluble resin having a curable group on a side chain or the like is preferable. Examples of the alkali-soluble resin containing a curable group include DIANAL NR series (manufactured by MITSUBISHI RAYON CO., LTD.), Photomer 6173 (COOH-containing polyurethane acrylic oligomer, manufactured by Diamond Shamrock Co., Ltd.), VISCOAT R-264 and KS Resist 106 (all are manufactured by OSAKA ORGANIC CHEMICAL INDUSTRY LTD.), CYCLOMER P series (for example, ACA230AA) and PLACCEL CF200 series (all are manufactured by Daicel Corporation), Ebecryl 3800 (manufactured by DAICEL-ALLNEX LTD.), and ACRYCURE RD-F8 (manufactured by NIPPON SHOKUBAI CO., LTD.), and the like.

As the alkali-soluble resin, for example, it is possible to use a radical polymer containing a carboxylic acid group on a side chain described in JP1984-044615A (JP-S59-044615A), JP1979-034327B (JP-S54-034327AB), JP1983-012577B (JP-S58-012577B), JP1979-025957B (JP-S54-025957B), JP1979-092723B (JP-S54-092723B), JP1984-053836A (JP-S59-053836A), and JP1984-071048A (JP-S59-071048A); an acetal-modified polyvinyl alcohol-based binder resin containing an alkali-soluble group described in EP993966B, EP1204000B, and JP2001-318463A; polyvinylpyrrolidone; polyethylene oxide; alcohol-soluble nylon, polyether as a reactant of 2,2-bis-(4-hydroxyphenyl)-propane and epichlorohydrin, and the like; the polyimide resin described WO2008/123097A; and the like.

As the alkali-soluble resin, for example, the compounds described in paragraphs "0225" to "0245" of JP2016-075845A can also be used, and what are described in the above paragraphs are incorporated into the present specification.

As the alkali-soluble resin, a polyimide precursor can also be used. The polyimide precursor means a resin obtained by causing an addition polymerization reaction between a compound containing an acid anhydride group and a diamine compound at 40°C to 100°C.

Specific examples of the polyimide precursor include the compounds described in paragraphs "0011" to "0031" of JP2008-106250A, the compounds described in paragraphs "0022" to "0039" of JP2016-122101A, the compounds described in paragraphs "0061" to "0092" of JP2016-068401A, the resins described in paragraph "0050" of JP2014-137523A, the resins described in paragraph "0058" of JP2015-187676A, the resins described in paragraphs "0012" and "0013" of JP2014-106326A, and the like. What are described in the above paragraphs are incorporated into the present specification.

As the alkali-soluble resin, a [benzyl (meth)acrylate/(meth)acrylic acid/other addition-polymerizable vinyl monomers used as necessary] copolymer and an [allyl(meth)acrylate/(meth)acrylic acid/other addition-polymerizable vinyl monomers used as necessary] copolymer are suitable because these make film hardness, sensitivity, and developability well balanced.
One of the aforementioned other addition-polymerizable vinyl monomers may be used alone, or two or more of such monomers may be used in combination.
In view of further improving moisture resistance of a cured film, the aforementioned copolymers preferably have a curable group, and more preferably have an ethylenically unsaturated group such as a (meth)acryloyl group.
For example, monomers have a curable group may be used as the aforementioned other addition-polymerizable vinyl monomers such that the curable group is introduced into the copolymers. In addition, a curable group (preferably an ethylenically unsaturated group such as a (meth)acryloyl group) may be introduced into some or all of one or more units derived from (meth)acrylic acid and/or one or more units derived from the aforementioned other addition-polymerizable vinyl monomers in the copolymers.
Examples of the aforementioned other addition-polymerizable vinyl monomers include methyl (meth)acrylate, a styrene-based monomer (such as hydroxystyrene), and an ether dimer.
Examples of the ether dimer include a compound represented by the following General Formula (ED1) and a compound represented by the following General Formula (ED2).

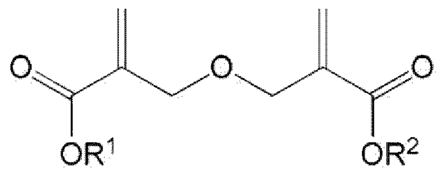

(ED1)

In General Formula (ED1), $R^1$ and $R^2$ each independently represent a hydrogen atom or a hydrocarbon group with a carbon number of 1 to 25.

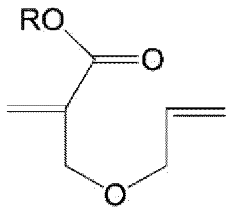

(ED2)

In General Formula (ED2), R represents a hydrogen atom or an organic group with a carbon number of 1 to 30. For specific examples of General Formula (ED2), the description of JP2010-168539A can be referred to.
For specific examples of the ether dimer, for example, paragraph "0317" of JP2013-029760A can be referred to, and what are described in the paragraph are incorporated into the present specification. Only one ether dimer may be used alone, or two or more ether dimers may be used.
The acid value of the alkali-soluble resin is not particularly limited. Generally, the acid value is preferably 30 to 500 mgKOH/g, and more preferably 50 to 200 mgKOH/g or more.
In a case where the composition contains an alkali-soluble resin, the content of the alkali-soluble resin with respect to the total mass of the composition is preferably 1% to 24% by mass, more preferably 1% to 15% by mass, even more preferably 1% to 12% by mass, particularly preferably 1% to 10% by mass, and most preferably 1% to 7% by mass.
In a case where the composition contains an alkali-soluble resin, the content of the alkali-soluble resin with respect to the total solid content of the composition is preferably 0.8% to 24% by mass, more preferably 0.8% to 15% by mass, even more preferably 0.8% to 12% by mass, still more preferably 0.8% to 10% by mass, particularly preferably 0.8% to 8% by mass, and most preferably 0.8% to 7% by mass.

<Resin-type rheology control agent>

The binder component may include a resin-type rheology control agent.
The rheology control agent is a component that imparts thixotropy to the composition such that the composition exhibits high viscosity in a case where shearing force (shear rate) is low and exhibits low viscosity in a case where shearing force (shear rate) is high.

In the present specification, the resin-type rheology control agent means a resin that has the above characteristics and is different from the aforementioned resin A.

Examples of the resin-type rheology control agent include a compound that has one or more (preferably two or more) adsorptive groups and also has a steric repulsive structural group.

The weight-average molecular weight of the resin-type rheology control agent is preferably 2,000 or more, and more preferably in a range of 2,000 to 50,000.

Among the organic rheology control agents which will be described later, a resin-type organic rheology control agent corresponds to an example of specific aspects of the resin-type rheology control agent.

In a case where the binder component includes a resin-type rheology control agent, the content of the resin-type rheology control agent with respect to the total mass of the composition is preferably 1% to 24% by mass, more preferably 1% to 15% by mass, even more preferably 1% to 12% by mass, particularly preferably 1% to 10% by mass, and most preferably 1% to 7% by mass.

Furthermore, in a case where the binder component includes a resin-type rheology control agent, the content of the resin-type rheology control agent with respect to the total solid content of the composition is preferably 0.8% to 24% by mass, more preferably 0.8% to 15% by mass, even more preferably 0.8% to 12% by mass, still more preferably 0.8% to 10% by mass, particularly preferably 0.8% to 8% by mass, and most preferably 0.8% to 7% by mass.

As the binder component, for example, it is also possible to use "C-2093I" (manufactured by NOF CORPORATION.) which is a commercially available wet dispersant.

<Polymerizable compound>

The binder component may include a polymerizable compound.

The molecular weight (or weight-average molecular weight) of the polymerizable compound is not particularly limited, and is preferably 2,000 or less.

In a case where the binder component includes a polymerizable compound, the content of the polymerizable compound with respect to the total mass of the composition is preferably 1% to 24% by mass, more preferably 1% to 15% by mass, even more preferably 1% to 12% by mass, particularly preferably 1% to 10% by mass, and most preferably 1% to 7% by mass.

In a case where the binder component includes a polymerizable compound, the content of the polymerizable compound with respect to the total solid content of the composition is preferably 0.8% to 24% by mass, more preferably 0.8% to 15% by mass, even more preferably 0.8% to 12% by mass, still more preferably 0.8% to 10% by mass, particularly preferably 0.8% to 8% by mass, and most preferably 0.8% to 7% by mass.

(Compound containing group containing ethylenically unsaturated bond)

Examples of the polymerizable compound include a compound containing a group containing an ethylenically unsaturated bond (hereinafter, also simply called "ethylenically unsaturated group").

The polymerizable compound is preferably a compound containing one or more ethylenically unsaturated bonds, more preferably a compound containing two or more ethylenically unsaturated bonds, even more preferably a compound containing three or more ethylenically unsaturated bonds, and particularly preferably a compound containing five or more ethylenically unsaturated bonds. The upper limit of the number of ethylenically unsaturated bonds is, for example, 15 or less. Examples of the ethylenically unsaturated group include a vinyl group, a (meth)allyl group, a (meth)acryloyl group, and the like.

As the polymerizable compound, for example, it is possible to use the compounds described in paragraph "0050" of JP2008-260927A and paragraph "0040" of JP2015-068893A, and what are described in the paragraphs are incorporated into the present specification.

The polymerizable compound may be in any chemical form such as a monomer, a prepolymer, an oligomer, a mixture of these, and a multimer of these.

The polymerizable compound is preferably a (meth)acrylate compound having 3 to 15 functional groups, and more preferably a (meth)acrylate compound having 3 to 6 functional groups.

As the polymerizable compound, a compound that contains one or more ethylenically unsaturated groups and has a boiling point of 100°C or higher is also preferable. For example, the compounds described in paragraph "0227" of JP2013-029760A and paragraph "0254" to "0257" of JP2008-292970A can be referred to, and what are described in the paragraphs are incorporated into the present specification.

As the polymerizable compound, dipentaerythritol triacrylate (KAYARAD D-330 as a commercially available product; manufactured by Nippon Kayaku Co., Ltd.), dipentaerythritol tetraacrylate (KAYARAD D-320 as a commercially available product; manufactured by Nippon Kayaku Co., Ltd.), dipentaerythritol penta(meth)acrylate (KAYARAD D-310 as a commercially available product; manufactured by Nippon Kayaku Co., Ltd.), dipentaerythritol hexa(meth)acrylate

(KAYARAD DPHA as a commercially available product; manufactured by Nippon Kayaku Co., Ltd., A-DPH-12E; manufactured by SHIN-NAKAMURA CHEMICAL CO, LTD.), and the structure in which these (meth)acryloyl groups are mediated by an ethylene glycol residue or a propylene glycol residue (for example, SR454 and SR499 commercially available from Sartomer Company Inc.) are preferable. These compounds in oligomer types can also be used. Furthermore, NK ESTER A-TMMT (pentaerythritol tetraacrylate, manufactured by SHIN-NAKAMURA CHEMICAL CO, LTD.), KAYARAD RP-1040, KAYARAD DPEA-12LT, KAYARAD DPHA LT, KAYARAD RP-3060, and KAYARAD DPEA-12 (all are trade names, manufactured by Nippon Kayaku Co., Ltd.), and the like may also be used.

The polymerizable compound may have an acid group such as a carboxylic acid group, a sulfonic acid group, or a phosphoric acid group. The polymerizable compound containing an acid group is preferably an ester of an aliphatic polyhydroxy compound and an unsaturated carboxylic acid, more preferably a polymerizable compound obtained by reacting an unreacted hydroxyl group of an aliphatic polyhydroxy compound with a non-aromatic carboxylic anhydride such that an acid group is added, and even more preferably an ester of the aforementioned polymerizable compound having pentaerythritol and/or dipentaerythritol as the aliphatic polyhydroxy compound. Examples of commercially available products thereof include ARONIX TO-2349, M-305, M-510, and M-520 manufactured by TOAGOSEI CO., LTD., and the like.

The acid value of the polymerizable compound containing an acid group is preferably 0.1 to 40 mgKOH/g, and more preferably 5 to 30 mgKOH/g. In a case where the acid value of the polymerizable compound is 0.1 mgKOH/g or more, development and dissolution characteristics are excellent. In case where the acid value is 40 mgKOH/g or less, this is advantageous in terms of manufacturing and/or handling. Furthermore, excellent photopolymerization performance and excellent curing properties are obtained.

As the polymerizable compound, a compound containing a caprolactone structure is also a preferable aspect.

The compound containing a caprolactone structure is not particularly limited as long as the compound contains the caprolactone structure in a molecule. Examples thereof include ε-caprolactone-modified polyfunctional (meth)acrylate obtained by esterifying a polyhydric alcohol, such as trimethylolethane, ditrimethylolethane, trimethylolpropane, ditrimethylolpropane, pentaerythritol, dipentaerythritol, tripentaerythritol, glycerin, diglycerol, or trimethylol melamine, (meth)acrylic acid, and ε-caprolactone. Among these, a compound containing a caprolactone structure represented by the following Formula (Z-1) is preferable.

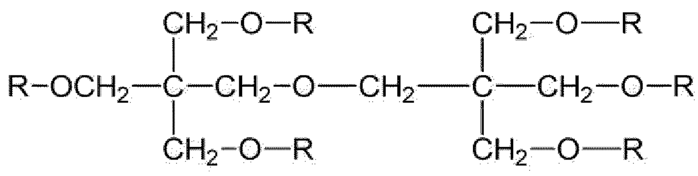

(Z-1)

In Formula (Z-1), all six Rs are groups represented by the following Formula (Z-2), or one to five out of six Rs are groups represented by the following Formula (Z-2) and others are groups represented by the following Formula (Z-3).

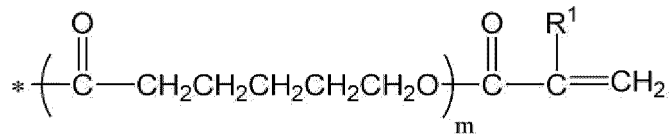

(Z-2)

In Formula (Z-2), $R^1$ represents a hydrogen atom or a methyl group, m represents a number of 1 or 2, and "*" represents a bonding site.

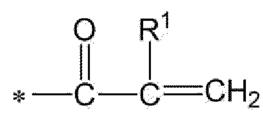

(Z-3)

In Formula (Z-3), $R^1$ represents a hydrogen atom or a methyl group, and "*" represents a bonding site.

The polymerizable compound containing a caprolactone structure is commercially available from Nippon Kayaku Co., Ltd., for example, as KAYARAD DPCA series. Examples thereof include DPCA-20 (compound where m in the above Formulas (Z-1) to (Z-3) is 1, the number of groups represented by Formula (Z-2) is 2, and $R^1$'s all represent a hydrogen atom), DPCA-30 (compound where m in the above Formulas (Z-1) to (Z-3) is 1, the number of groups represented by Formula (Z-2) is 3, and $R^1$'s all represent a hydrogen atom), DPCA-60 (compound where m in the above

Formulas (Z-1) to (Z-3) is 1, the number of groups represented by Formula (Z-2) is 6, and $R^1$'s all represent a hydrogen atom), DPCA-120 (compound where m in the above Formulas (Z-1) to (Z-3) is 2, the number of groups represented by Formula (Z-2) is 6, and $R^1$'s all represent a hydrogen atom), and the like. Furthermore, examples of commercially available products of the polymerizable compound containing a caprolactone structure include M-350 (trade name) (trimethylolpropane triacrylate) manufactured by TOAGOSEI CO., LTD.

As the polymerizable compound, a compound represented by the following Formula (Z-4) or (Z-5) can also be used.

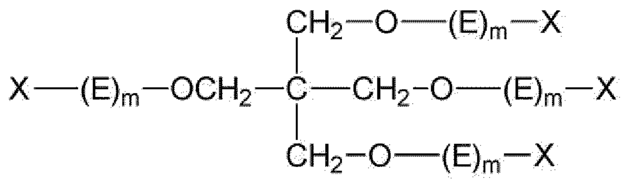

(Z-4)

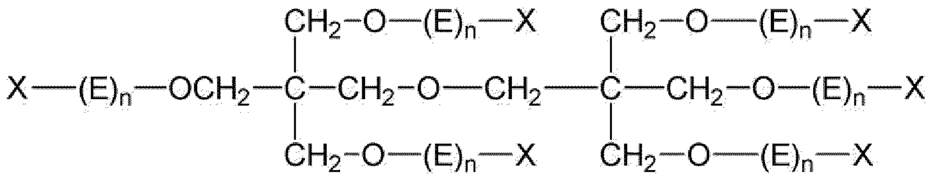

(Z-5)

In Formulas (Z-4) and (Z-5), E represents $-((CH_2)_yCH_2O)-$ or $((CH_2)_yCH(CH_3)O)-$, y represents an integer of 0 to 10, and X represents a (meth)acryloyl group, a hydrogen atom, or a carboxylic acid group.

In Formula (Z-4), the total number of (meth)acryloyl groups is 3 or 4, m represents an integer of 0 to 10, and the total of m's is an integer of 0 to 40.

In Formula (Z-5), the total number of (meth)acryloyl groups is 5 or 6, n represents an integer of 0 to 10, and the total of n's is an integer of 0 to 60.

In Formula (Z-4), m is preferably an integer of 0 to 6, and more preferably an integer of 0 to 4.

The total of m's is preferably an integer of 2 to 40, more preferably an integer of 2 to 16, and even more preferably an integer of 4 to 8.

In Formula (Z-5), n is preferably an integer of 0 to 6, and more preferably an integer of 0 to 4.

The total of n's is preferably an integer of 3 to 60, more preferably an integer of 3 to 24, and even more preferably an integer of 6 to 12.

In addition, as for $-((CH_2)_yCH_2O)-$ or $((CH_2)_yCH(CH_3)O)-$ in Formula (Z-4) or Formula (Z-5), it is preferable that the terminal on the oxygen atom side be bonded to X.

One compound represented by Formula (Z-4) or Formula (Z-5) may be used alone, or two or more such compounds may be used in combination. Especially, it is preferable to employ an aspect in which all of six Xs in Formula (Z-5) represent an acryloyl group or an aspect in which a compound represented by Formula (Z-5) where all of six Xs represent an acryloyl group and a compound represented by Formula (Z-5) where at least one of six Xs represents a hydrogen atom form a mixture. This constitution can further improve developability.

The total content of the compound represented by Formula (Z-4) or Formula (Z-5) in the polymerizable compound is preferably 20% by mass or more, and more preferably 50% by mass or more.

Among the compounds represented by Formula (Z-4) or Formula (Z-5), either or both of a pentaerythritol derivative and a dipentaerythritol derivative are more preferable.

The polymerizable compound may contain a cardo skeleton.

As the polymerizable compound containing a cardo skeleton, a polymerizable compound containing a 9,9-bisarylfluorene skeleton is preferable.

Examples of the polymerizable compound containing a cardo skeleton include, but are not limited to, ONCOAT EX series (manufactured by NAGASE & CO., LTD.), OGSOL (manufactured by Osaka Gas Chemicals Co., Ltd.), and the like.

As the polymerizable compound, a compound containing an isocyanuric acid skeleton as a core is also preferable. Examples of such a polymerizable compound include NK ESTER A-9300 (manufactured by SHIN-NAKAMURA CHEMICAL CO, LTD.).

The content of ethylenically unsaturated groups in the polymerizable compound (the content means a value obtained by dividing the number of ethylenically unsaturated groups in the polymerizable compound by the molecular weight (g/mol) of the polymerizable compound) is preferably 5.0 mmol/g or more. The upper limit of the content is not particularly limited, but is generally 20.0 mmol/g or less.

(Compound having epoxy group and/or oxetanyl group)

The polymerizable compound is also preferably a compound having an epoxy group and/or an oxetanyl group.
The polymerizable compound preferably has one or more epoxy groups and/or oxetanyl groups, and more preferably 2 to 10 epoxy groups and/or oxetanyl groups.
In the polymerizable compound, the epoxy group and/or oxetanyl group (preferably epoxy group) may be fused with a cyclic group (such as an alicyclic group). The cyclic group fused with an epoxy group and/or an oxetanyl group preferably has a carbon number of 5 to 15. In addition, in the above cyclic group, the portion other than the fused epoxy group and/or oxetanyl group may be monocyclic or polycyclic. One cyclic group may be fused with only one epoxy group or oxetanyl group, or may be fused with two or more epoxy groups and/or oxetanyl groups.
Examples of such a polymerizable compound include a monofunctional or polyfunctional glycidyl ether compound.
The polymerizable compound may be, for example, (poly)alkylene glycol diglycidyl ether.
The polymerizable compound may be a compound containing a caprolactone structure represented by Formula (Z-1) described above in which the group represented by Formula (Z-2) is changed to the following Formula (Z-2E) and the group represented by Formula (Z-3) is changed to a group represented by Formula (Z-3E).

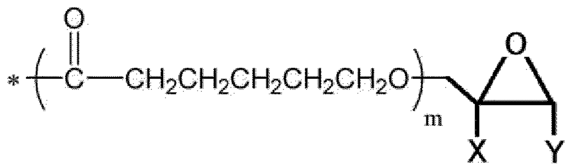
(Z-2E)

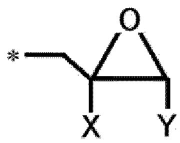
(Z-3E)

In Formula (Z-2E), m represents the number 1 or 2, X and Y each independently represent a hydrogen atom or a substituent (preferably an alkyl group preferably having a carbon number of 1 to 3), and "*" represents a bonding site.
In Formula (Z-3E), X and Y each independently represent a hydrogen atom or a substituent (preferably an alkyl group preferably having a carbon number of 1 to 3), and "*" represents a bonding site.
The polymerizable compound may be a compound represented by Formula (Z-4) described above in which X is changed to represent a group represented by Formula (Z-3E) or a hydrogen atom.
In Formula (Z-4) modified in this way, the total number of groups represented by formula (Z-3E) is 2 to 4.
The polymerizable compound may be a compound represented by Formula (Z-5) described above in which X is changed to represent a group represented by Formula (Z-3E) or a hydrogen atom.
In Formula (Z-5) modified in this way, the total number of groups represented by Formula (Z-3E) is 2 to 6 (preferably 5 or 6).
The polymerizable compound may be a compound having a structure to which N pieces of cyclic groups fused with an epoxy group and/or an oxetanyl group are bonded via a linking group.
N is an integer of 2 or more, preferably an integer of 2 to 6, and more preferably 2. In the linking group, the total number of atoms other than hydrogen atoms is preferably 1 to 20 and more preferably 2 to 6. In a case where N is 2, examples of the linking group include an alkyleneoxycarbonyl group.
Examples of commercially available products of the polymerizable compound include polyfunctional aliphatic glycidyl ether compounds such as DENACOL EX-212L, EX-214L, EX-216L, EX-321L, and EX-850L (all are manufactured by Nagase ChemteX Corporation.). Although these are low-chlorine products, EX-212, EX-214, EX-216, EX-321, EX-614, EX-850, and the like that are not low-chlorine products can also be used.
Furthermore, as a commercially available product, CELLOXIDE 2021P (manufactured by Daicel Corporation, a polyfunctional epoxy monomer) can also be used.
Furthermore, as a commercially available product, EHPE 3150 (manufactured by Daicel Corporation, a polyfunctional epoxy/oxiranyl monomer) can also be used.

[Solvent]

The composition contains a solvent.

Examples of the solvent include water and an organic solvent. As the solvent, an organic solvent is preferable.

The lower limit of the boiling point of the solvent is preferably 55°C or higher. In view of further improving the effects of the present invention, the lower limit of the boiling point is more preferably 80°C or higher, even more preferably 100°C or higher, and particularly preferably 160°C or higher. The upper limit of the boiling point of the solvent is not particularly limited, but is preferably 400°C or lower.

Examples of the organic solvent include acetone (boiling point 56°C), methyl ethyl ketone (boiling point 79.6°C), cyclohexane (boiling point 80.8°C), ethyl acetate (boiling point 77.1°C), ethylene dichloride (boiling point 83.5°C), tetrahydrofuran (boiling point 66°C), cyclohexanone (boiling point 155.6°C), toluene (boiling point 110°C), ethylene glycol monomethyl ether (boiling point 124°C), ethylene glycol monoethyl ether (boiling point 135°C), ethylene glycol dimethyl ether (boiling point 84°C), propylene glycol monomethyl ether (boiling point 120°C), propylene glycol monoethyl ether (boiling point 132°C), acetylacetone (boiling point 140°C), cyclopentanone (boiling point 131°C), ethylene glycol monomethyl ether acetate (boiling point 144.5°C), ethylene glycol ethyl ether acetate (boiling point 145°C), ethylene glycol monoisopropyl ether (boiling point 141°C), diacetone alcohol (boiling point 166°C), ethylene glycol monobutyl ether acetate (boiling point 192°C), 1,4-butanediol diacetate ("1,4-BDDA", boiling point 232°C), 1,6-hexanediol diacetate ("1,6-HDDA", boiling point 260°C), 1,3-butylene glycol diacetate ("1,3-BGDA", boiling point 232°C), propylene glycol diacetate ("PGDA", boiling point 190°C), glycerol triacetate (boiling point 260°C), 3-methoxy-1-propanol (boiling point 150°C), 3-methoxy-1-butanol (boiling point 161°C), diethylene glycol monomethyl ether (boiling point 194°C), diethylene glycol monoethyl ether (boiling point 202°C), diethylene glycol dimethyl ether (boiling point 162°C), diethylene glycol diethyl ether (boiling point 188°C), propylene glycol monomethyl ether acetate ("PGMEA", boiling point 146°C), propylene glycol monoethyl ether acetate (boiling point 146°C), N,N-dimethylformamide (boiling point 153°C), dimethyl sulfoxide (boiling point 189°C), γ-butyrolactone (boiling point 204°C), ethyl acetate (boiling point 77.1 °C), butyl acetate (boiling point 126°C), methyl lactate (boiling point 144°C), N-methyl-2-pyrrolidone (boiling point: 202°C), ethyl lactate (boiling point: 154°C), and the like. However, the organic solvent is not limited to these.

As a suitable aspect of the solvent, in view of further improving the effects of the present invention, an acetate-based solvent is also preferable.

The acetate-based solvent means a solvent containing one or more acetate groups in the molecule. In view of further improving the effects of the present invention, the number of acetate groups contained in the acetate-based solvent is preferably two or more. The upper limit thereof is not particularly limited, and is, for example, 6 or less. The boiling point of the acetate-based solvent is preferably 160°C or higher.

Examples of the acetate-based solvent containing two or more acetate groups in the molecule include a compound represented by Formula (1A).

Formula (1A) $M\text{-}(O\text{-}C(=O)\text{-}CH_3)_m$

In Formula (1A), M represents an m-valent linking group. m represents 2 to 6.

Examples of M as the m-valent (m = 2 to 6) linking group include linking groups represented by the following Formulas (M-1) to (M-5).

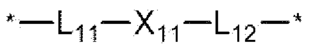

(M-1)

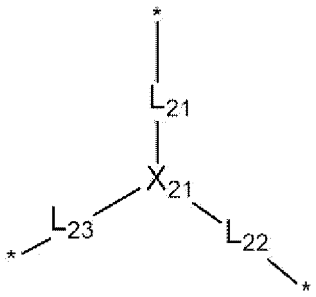

(M-2)

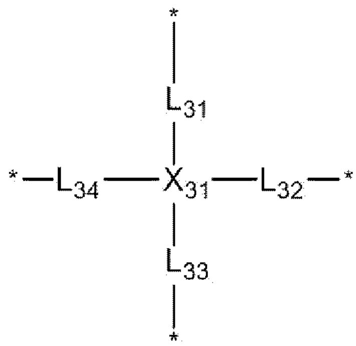

(M-3)

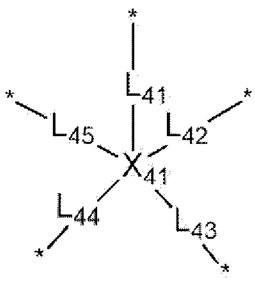

(M-4)

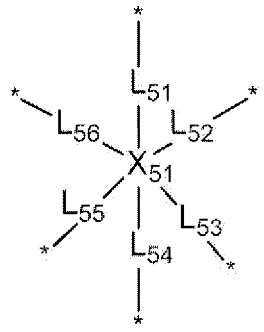

(M-5)

In Formulas (M-1) to (M-5), $X_{11}$, $X_{21}$, $X_{31}$, $X_{41}$, and $X_{51}$ each independently represent an organic group.

Specific examples of the organic group represented by $X_{11}$, $X_{21}$, $X_{31}$, $X_{41}$, and $X_{51}$ include a hydrocarbon group formed of a hydrocarbon which may contain a heteroatom (the heteroatom is, for example a nitrogen atom, an oxygen atom, or a sulfur atom and may be contained in the hydrocarbon group in the form of -O-, -S-, $-SO_2-$, $-NR^1-$, -CO-, or a linking group composed of a combination of two or more of these). Specifically, a linear or branched aliphatic hydrocarbon group which may contain a heteroatom, an aliphatic hydrocarbon ring group, an aromatic hydrocarbon ring group, a heterocyclic group, or a linking group composed of a combination of a plurality of these is preferable.

The hydrocarbon group which may contain a heteroatom as an organic group represented by $X_{11}$ is means a divalent group formed by removal of two hydrogen atoms from the aforementioned hydrocarbon which may contain a heteroatom. The hydrocarbon group which may contain a heteroatom as an organic group represented by $X_{21}$ is means a trivalent group formed by removal of three hydrogen atoms from the aforementioned hydrocarbon which may contain a heteroatom. The hydrocarbon group which may contain a heteroatom as an organic group represented by $X_{31}$ is means a tetravalent group formed by removal of four hydrogen atoms from the aforementioned hydrocarbon which may contain a heteroatom. The hydrocarbon group which may contain a heteroatom as an organic group represented by $X_{41}$ is means a pentavalent group formed by removal of five hydrogen atoms from the aforementioned hydrocarbon which may contain a heteroatom. The hydrocarbon group which may contain a heteroatom as an organic group represented by $X_{51}$ is means a hexavalent group formed by removal of six hydrogen atoms from the aforementioned hydrocarbon which may contain a heteroatom.

$R^1$ represents a hydrogen atom or a substituent. The substituent is not particularly limited, and is, for example, preferably an alkyl group (the alkyl group may be a linear or branched alkyl group preferably having 1 to 6 carbon atoms).

The linear or branched aliphatic hydrocarbon group, aliphatic hydrocarbon ring group, aromatic hydrocarbon ring group, and heterocyclic group which may contain a heteroatom as described above may further have a substituent.

The carbon number of the linear or branched aliphatic hydrocarbon group is not particularly limited, but is preferably 1 to 12, more preferably 1 to 10, and even more preferably 3 to 6.

Examples of the aliphatic hydrocarbon group include an alkylene group.

The carbon number of the aliphatic hydrocarbon ring group (alicyclic group) is not particularly limited, but is preferably 3 to 30, more preferably 6 to 20, even more preferably 6 to 15, and particularly preferably 6 to 12. The alicyclic group may be monocyclic or polycyclic or may be a spiro ring. Examples of the alicyclic ring that constitutes the monocyclic alicyclic group include monocyclic cycloalkane such as cyclopentane, cyclohexane, or cyclooctane. Examples of the alicyclic ring that constitutes the polycyclic alicyclic group include polycyclic cycloalkane such as norbornane, tricyclodecane, tetracyclodecane, tetracyclododecane, or adamantane.

The carbon number of the aromatic hydrocarbon ring constituting the aromatic hydrocarbon ring group is not particularly limited, but is preferably 6 to 30, more preferably 6 to 20, even more preferably 6 to 15, and particularly preferably 6 to 12. The aromatic hydrocarbon group may be monocyclic or polycyclic. Examples of the aromatic hydrocarbon ring include a benzene ring, a naphthalene ring, and the like.

The carbon number of the heterocyce constituting the heterocyclic group is not particularly limited, but is preferably 3 to 25, more preferably 3 to 20, even more preferably 6 to 20, particularly preferably 6 to 15, and most preferably 6 to 10. In addition, the heterocyce may be monocyclic or polycyclic, and may be any of an aromatic heterocycle or an aliphatic heterocycle. Furthermore, the heterocycle may be a spiro ring. Examples of the aromatic heterocycle include a furan ring, a thiophene ring, a benzofuran ring, a benzothiophene ring, a dibenzofuran ring, a dibenzothiophene ring, and a pyridine ring. Examples of the aliphatic heterocycle include a tetrahydropyran ring, a lactone ring, a sulton ring, a decahydroisoquinoline ring, and the like.

In Formulas (M-1) to (M-5), Ln, $L_{12}$, $L_{21}$ to $L_{23}$, $L_{31}$ to $L_{34}$, $L_{41}$ to $L_{45}$, and $L_{51}$ to $L_{56}$ each independently represent a single bond or a divalent linking group.

The divalent linking group represented by $L_{11}$, $L_{12}$, $L_{21}$ to $L_{23}$, $L_{31}$ to $L_{34}$, $L_{41}$ to $L_{45}$, and $L_{51}$ to $L_{56}$ is not particularly limited, but is preferably one or more groups selected from the group consisting of an alkylene group, -CO-, -CONR$^N$-, -O-, and -S- or a divalent linking group composed of a combination of two or more of the above groups.

The alkylene group may be linear, branched, or cyclic. The carbon number of the alkylene group is preferably 1 to 10, and more preferably 1 to 4.

The alkylene group may further have a substituent.

$R^N$ represents a hydrogen atom or a substituent. The substituent is not particularly limited, and is, for example, preferably an alkyl group (the alkyl group may be a linear or branched alkyl group preferably having 1 to 6 carbon atoms).

In Formulas (M-1) to (M-5), * represents a bonding position with an acetyl group ((O-C(=O)-$CH_3$)) specified in Formula (1A).

Examples of an aspect of M which is a divalent linking group include a substituted or unsubstituted alkylene group.

The alkylene group is preferably linear or branched. The number of carbon atoms in the alkylene group is preferably 1 to 12, more preferably 1 to 10, and even more preferably 3 to 6.

Examples of an aspect of M which is a trivalent linking group include a group represented by the following Formula (1a).

Formula (1a) $R^A$-C-($L^1$-*)$_3$

In Formula (1a), $R^A$ represents a hydrogen atom or a substituent. $L^1$ represents a single bond or an alkylene group having 1 to 6 carbon atoms which may have a substituent. * represents a bonding position with an acetyl group ((O-C(=O)-$CH_3$)) specified in Formula (1A). Three $L^1$'s may be the same as or different from each other.

The substituent represented by $R^A$ is not particularly limited, and examples thereof include a monovalent organic group which is preferably an alkyl group having 1 to 6 carbon atoms which may have a substituent, and more preferably an alkyl group having 1 to 3 carbon atoms which may have a substituent. The substituent is not particularly limited, and examples thereof include a hydroxyl group.

As $R^A$, a hydrogen atom is preferable.

The alkylene group represented by $L^1$ having 1 to 6 carbon atoms which may have a substituent is preferably an alkylene group having 1 to 3 carbon atoms which may have a substituent. The substituent is not particularly limited, and examples thereof include a hydroxyl group.

Specific examples of the compound represented by Formula (1A) include 1,4-BDDA, 1,6-HDDA, 1,3-BGDA, PGDA, glycerol triacetate, and the like.

One solvent may be used alone, or two or more solvents may be used.

In the composition, the content of the solvent (total content in a case where the composition contains two or more solvents) is 3% to 24% by mass with respect to the total mass of the composition. In a case where the content of the solvent is 3% by mass or more with respect to the total mass of the composition, the composition has excellent fluidity. On the other hand, in a case where the content of the solvent is 24% by mass or less with respect to the total mass of the composition, the filling suitability of the cured substance formed of the composition is excellent. Particularly, in view of further improving the effects of the present invention, the upper limit of the content is preferably 15% by mass or less, and more preferably 8% by mass or less.

In the composition, the content of the solvent having a boiling point of 160°C or higher is preferably 3% by mass or more with respect to the total mass of the composition. In a case where the content of the solvent having a boiling point of 160°C or higher is 3% by mass or more, cure shrinkage is unlikely to occur during film formation, and the occurrence of voids and cracks can be suppressed. As a result, the filling suitability of the cured substance formed of the composition is further improved.

The upper limit of the content of the solvent having a boiling point of 160°C or higher with respect to the total mass of the composition is 24% by mass or less, preferably 15% by mass or less, and more preferably 8% by mass or less.

[Rheology control agent]

The composition may contain a rheology control agent.
The rheology control agent is a component that imparts thixotropy to the composition such that the composition exhibits high viscosity in a case where shearing force (shear rate) is low and exhibits low viscosity in a case where shearing force (shear rate) is high.
The content of the rheology control agent with respect to the total mass of the composition is preferably 1% to 24% by mass, more preferably 1% to 15% by mass, even more preferably 1% to 12% by mass, particularly preferably 1% to 10% by mass, and most preferably 1% to 7% by mass.
The content of the rheology control agent with respect to the total solid content of the composition is preferably 0.8% to 24% by mass, more preferably 0.8% to 15% by mass, even more preferably 0.8% to 12% by mass, still more preferably 0.8% to 10% by mass, particularly preferably 0.8% to 8% by mass, and most preferably 0.8% to 7% by mass.
The content of the rheology control agent is a content that does not include the content of the resin-type rheology control agent. The resin-type rheology control agent corresponds to the resin which is the aforementioned binder component.
Examples of the rheology control agent include an organic rheology control agent and an inorganic rheology control agent. Among these, an organic rheology control agent is preferable.

<Organic rheology control agent>

The content of the organic rheology control agent with respect to the total mass of the composition is preferably 1% to 24% by mass, more preferably 1% to 15% by mass, even more preferably 1% to 12% by mass, particularly preferably 1% to 10% by mass, and most preferably 1% to 7% by mass.
The content of the organic rheology control agent with respect to the total solid content of the composition is preferably 0.8% to 24% by mass, more preferably 0.8% to 15% by mass, even more preferably 0.8% to 12% by mass, still more preferably 0.8% to 10% by mass, particularly preferably 0.8% to 8% by mass, and most preferably 0.8% to 7% by mass.
The content of the organic rheology control agent is a content that does not include the content of the resin-type rheology control agent. The resin-type rheology control agent corresponds to the resin which is the aforementioned binder component.
One organic rheology control agent may be used alone, or two or more organic rheology control agents may be used.
Examples of the organic rheology control agent include a compound that has one or more (preferably two or more) adsorptive groups and also has a steric repulsive structural group.
The adsorptive groups interact with the surface of the magnetic particles to make the organic rheology control agent adsorbed onto the surface of the magnetic particles.
Examples of the adsorptive groups include an acid group, a basic group, and an amide group.
Examples of the acid group include a carboxy group, a phosphoric acid group, a sulfo group, a phenolic hydroxyl group, and acid anhydride groups of these (such as an acid anhydride group of a carboxy group). In view of further improving the effects of the present invention, a carboxy group is preferable.
Examples of the basic group include an amino group (a group obtained by removing one hydrogen atom from ammonia, a primary amine, or a secondary amine) and an imino group.
As the adsorptive group, among these, a carboxy group or an amide group is preferable, and a carboxy group is more preferable.
Having a sterically bulky structure, the steric repulsive structural group introduces steric repulsion into the magnetic particles onto which the organic rheology control agent is adsorbed and maintains an appropriate space between the magnetic particles. As the steric repulsive structural group, for example, a chain-like group is preferable, a long-chain fatty acid group is more preferable, and a long-chain alkyl group is even more preferable.
The organic rheology control agent preferably has a hydrogen bonding unit.
The hydrogen bonding unit is a partial structure that functions to establish a hydrogen bonding network between the organic rheology control agents and between the organic rheology control agent and another component. The organic rheology control agent that contributes to the formation of the network may or may not be adsorbed onto the surface of the magnetic particles.
The hydrogen bonding unit may be the same as or different from the adsorptive group described above. In a case where the hydrogen bonding units are the same as the aforementioned adsorptive groups, some of the adsorptive

groups are bonded to the surface of the magnetic particles and the others function as hydrogen bonding units.

As the hydrogen bonding units, carboxy groups or amide groups are preferable. Carboxy groups as the hydrogen bonding units are preferable because the carboxy groups readily take part in a curing reaction during the preparation of the cured substance. Amide groups as the hydrogen bonding units are preferable because the amide groups further improve the temporal stability of the composition.

In a case where the organic rheology control agent is a resin, the organic rheology control agent as a resin may have or substantially may not have the aforementioned repeating unit having a graft chain. In a case where the organic rheology control agent as a resin substantially does not have the aforementioned repeating unit having a graft chain, the content of the repeating unit having a graft chain with respect to the total mass of the organic rheology control agent as a resin is preferably less than 2% by mass, more preferably 1% by mass or less, and even more preferably less than 0.1% by mass. The lower limit of the content of the repeating unit having a graft chain is 0% by mass or more.

The organic rheology control agent is preferably one or more substances selected from the group consisting of a polycarboxylic acid (compound having two or more carboxy groups), a polycarboxylic anhydride (compound having two or more acid anhydride groups consisting of carboxy groups), and an amide wax.

These may or may not be a resin.

In addition, these may correspond to an aggregation control agent and/or an anti-aggregation dispersant that will be described later.

Examples of organic rheology control agent include modified urea, a urea-modified polyamide, a fatty acid amide, polyurethane, a polyamide amide, a polymeric urea derivative, salts of these (such as carboxylates), and the like.

The modified urea is a reactant of an isocyanate monomer or an isocyanate monomer adduct and an organic amine. The modified urea is modified with a polyoxyalkylene polyol (such as polyoxyethylene polyol or polyoxypropylene polyol) and/or an alkyd chain, or the like. The urea-modified polyamide is, for example, a compound containing a urea bond and a compound obtained by introducing a medium-polarity group or a low-polarity group into the terminal of the compound containing a urea bond. Examples of the medium-polarity group or the low-polarity group include a polyoxyalkylene polyol (such as a polyoxyethylene polyol or polyoxypropylene polyol) and an alkyd chain. The fatty acid amide is a compound having a long-chain fatty acid group and an amide group in the molecule.

These may or may not be a resin.

In addition, these may correspond to an aggregation control agent and/or an anti-aggregation dispersant that will be described later.

The molecular weight of the organic rheology control agent (weight-average molecular weight in a case where the organic rheology control agent has a molecular weight distribution) is preferably in a range of 200 to 50,000.

In a case where the organic rheology control agent has an acid value, the acid value is preferably 5 to 400 mgKOH/g.

In a case where the organic rheology control agent has an amine value, the amine value is preferably 5 to 300 mgKOH/g.

(Aggregation control agent)

Examples of the organic rheology control agent also include an aggregation control agent. The aggregation control agent may or may not be a resin.

The aggregation control agent has functions of being bonded to aggregates having a relatively high density, such as the magnetic particles, and dispersing components such as a resin precursor in the composition such that bulky aggregates can be formed.

In a case where the composition contains an aggregation control agent, the magnetic particles in the composition are inhibited from forming a hard cake, and bulky aggregates are formed. Therefore, redispersibility can be improved.

Examples of the aggregation control agent include a cellulose derivative.

Examples of the cellulose derivative include carboxymethyl cellulose, methyl cellulose, hydroxyethyl cellulose, hydroxypropyl cellulose, hydroxypropyl methyl cellulose, hydroxypropyl ethyl cellulose, salts of these, and the like.

In a case where the composition contains an aggregation control agent, the content of the aggregation control agent with respect to the total mass of the composition is preferably 1% to 24% by mass, more preferably 1% to 15% by mass, even more preferably 1% to 12% by mass, particularly preferably 1% to 10% by mass, and most preferably 1% to 7% by mass.

The content of the aggregation control agent with respect to the total solid content of the composition is preferably 0.8% to 24% by mass, more preferably 0.8% to 15% by mass, even more preferably 0.8% to 12% by mass, still more preferably 0.8% to 10% by mass, particularly preferably 0.8% to 8% by mass, and most preferably 0.8% to 7% by mass.

The content of the aggregation control agent is a content that does not include the content of the resin-type rheology control agent. The resin-type rheology control agent corresponds to the resin which is the aforementioned binder component.

(Anti-aggregation dispersant)

Examples of the organic rheology control agent also include an anti-aggregation dispersant.

The anti-aggregation dispersant may or may not be a resin.

The anti-aggregation dispersant comprises a function of being adsorbed onto the surface of the magnetic particles such that the magnetic particles remain spaced apart from each other by at least a certain distance due to the interaction between the dispersants and that the magnetic particles are prevented from being directly aggregated with each other. As a result, the aggregation of the magnetic particles is suppressed, and even in a case where aggregates are formed, the density of the formed aggregates is relatively low. Furthermore, the anti-aggregation dispersant can form bulky aggregates by dispersing components such as a resin precursor in the composition. Therefore, redispersibility can be improved.

As the anti-aggregation dispersant, an alkylolammonium salt of a polybasic acid is preferable.

The polybasic acid may have two or more acid groups. Examples thereof include an acidic polymer containing a repeating unit having an acid group (for example, polyacrylic acid, polymethacrylic acid, polyvinyl sulfonic acid, polyphosphoric acid, and the like). Examples of polybasic acids other than the above include a polymer obtained by polymerizing an unsaturated fatty acid such as crotonic acid. The alkylolammonium salt of a polybasic acid is obtained by reacting these polybasic acids with alkylolammonium. The salt obtained by such a reaction usually contains the following partial structure.

$$-C(=O)-N(-R^1)(-R^2-OH)$$

Here, $R^1$ is an alkyl group, and $R^2$ is an alkylene group.

The alkylolammonium salt of a polybasic acid is preferably a polymer containing a plurality of partial structures described above. In a case where the alkylolammonium salt of a polybasic acid is a polymer, the weight-average molecular weight thereof is preferably 1,000 to 100,000, and more preferably 5,000 to 20,000. The polymer of the alkylolammonium salt of a polybasic acid is bonded to the surface of the magnetic particles and forms a hydrogen bond with molecules of other anti-aggregation dispersants, such that the main chain structure of the polymer goes in between the magnetic particles and the magnetic particles are spaced apart from each other.

Examples of one of the suitable aspects of the anti-aggregation dispersant include amide wax which is a condensate formed by dehydrocondensation of (a) saturated aliphatic monocarboxylic acids and hydroxy group-containing aliphatic monocarboxylic acids, (b) at least any acids among polybasic acids, and (c) at least any amines among diamines and tetramines.

It is preferable that aforementioned (a) to (c) be used such that (a):(b):(c) = 1 to 3:0 to 5:1 to 6 in terms of molar ratio.

The saturated aliphatic monocarboxylic acids preferably have a carbon number of 12 to 22. Specific examples thereof include lauric acid, myristic acid, pentadecyl acid, palmitic acid, margaric acid, stearic acid, nonadecanoic acid, arachidic acid, behenic acid, and the like.

The hydroxy group-containing aliphatic monocarboxylic acids preferably have a carbon number of 12 to 22. Specific examples thereof include 12-hydroxystearic acid and dihydroxystearic acid.

Each of the saturated aliphatic monocarboxylic acids and each of the hydroxy group-containing aliphatic monocarboxylic acids may be used alone, or a plurality of saturated aliphatic monocarboxylic acids and a plurality of hydroxy group-containing aliphatic monocarboxylic acids may be used in combination.

The polybasic acids are preferably a carboxylic acid that has a carbon number of 2 to 12 and two or more replaceable hydrogen atoms, and more preferably a dicarboxylic acid.

Examples of such a dicarboxylic acid include an aliphatic dicarboxylic acid such as oxalic acid, malonic acid, succinic acid, glutaric acid, adipic acid, pimelic acid, suberic acid, azelaic acid, sebacic acid, 1,10-decanedicarboxylic acid, or 1,12-dodecanedicarboxylic acid; an aromatic dicarboxylic acid such as phthalic acid, isophthalic acid, or terephthalic acid; and an alicyclic dicarboxylic acid such as 1,2-cyclohexanedicarboxylic acid, 1,3-cyclohexanedicarboxylic acid, 1,4-cyclohexanedicarboxylic acid, or cyclohexylsuccinic acid. Each of these polybasic acids may be used alone, or a plurality of these polybasic acids may be used in combination.

The diamines preferably have a carbon number of 2 to 14. Specifically, examples thereof include ethylenediamine, 1,3-propanediamine, 1,4-butanediamine, hexamethylenediamine, metaxylylenediamine, tolylenediamine, paraxylylenediamine, phenylenediamine, isophoronediamine, 1,10-decanediamine, 1,12-dodecanediamine, 4,4-diaminodicyclohexylmethane, and 4,4-diaminodiphenylmethane.

The tetramines preferably have a carbon number of 2 to 14. Specific examples thereof include butane-1,1,4,4-tetramine and pyrimidine-2,4,5,6-tetramine. Each of the diamines and each of the tetramines may be used alone, or a plurality of diamines and a plurality of tetramines may be used in combination.

The amount of diamines and tetramines is adjusted depending on the number of moles of the saturated aliphatic

monocarboxylic acids or the hydroxy group-containing aliphatic monocarboxylic acids and the number of moles of the polybasic acids, such that the total number of carboxy groups is equivalent to the total number of amino groups. For example, in a case where the number of moles of an aliphatic dicarboxylic acid, which is polybasic acids, is n (n = 0 to 5) with respect to 2 moles of the aliphatic monocarboxylic acid, by setting the number of moles of diamines to (n + 1), the amount of acids is equivalent to the amount of amines.

This amide wax may be obtained as a mixture of a plurality of compounds having different molecular weights. The amide wax is preferably a compound represented by Chemical Formula (I). The amide wax may be a single compound or a mixture.

$$A\text{-}C\text{-}(B\text{-}C)_m\text{-}A\cdots \qquad (I)$$

In formula (I), A is a dehydroxylated residue of a saturated aliphatic monocarboxylic acid and/or a hydroxy group-containing saturated aliphatic monocarboxylic acid, B is a dehydroxylated residue of a polybasic acid, C is a dehydrogenated residue of a diamine and/or a tetramine, and m satisfies $0 \leq m \leq 5$.

Examples of one of the suitable aspects of the anti-aggregation dispersant include a compound represented by the following Formula (II).

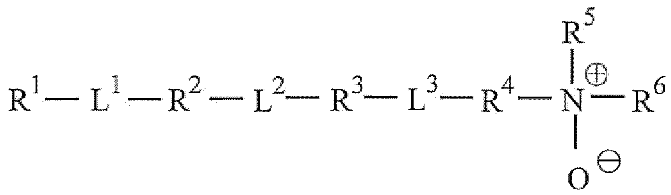

(II)

In Formula (II), $R^1$ represents a monovalent linear aliphatic hydrocarbon group with a carbon number of 10 to 25, $R^2$ and $R^3$ each independently represent a divalent aliphatic hydrocarbon group with a carbon number of 2, 4, 6, or 8, a divalent alicyclic hydrocarbon group with a carbon number of 6, or a divalent aromatic hydrocarbon group, $R^4$ represents a divalent aliphatic hydrocarbon group with a carbon number of 1 to 8, and $R^5$ and $R^6$ each independently represent a monovalent aliphatic hydrocarbon group with a carbon number of 1 to 3 or a hydroxyalkyl ether group.

In Formula (II), $L^1$ to $L^3$ each independently represent an amide bond. In a case where $L^1$ and $L^3$ each represent -CONH-, $L^2$ represents -NHCO-. In a case where $L^1$ and $L^3$ each represent -NHCO-, $L^2$ represents -CONH-.

$R^1$ is a monovalent linear aliphatic hydrocarbon group with a carbon number of 10 to 25. Examples thereof include a linear alkyl group such as a decyl group, a lauryl group, a myristyl group, a pentadecyl group, a stearyl group, a palmityl group, a nonadecyl group, an eicosyl group, or a behenyl group; a linear alkenyl group such as a decenyl group, a pentadecenyl group, an oleyl group, or an eicosenyl group; and a linear alkynyl group such as a pentadecynyl group, an octadecynyl group, or a nonadecinyl group.

Particularly, $R^1$ is preferably a monovalent linear aliphatic hydrocarbon group with a carbon number of 14 to 25, and more preferably a monovalent linear aliphatic hydrocarbon group with a carbon number of 18 to 21. The linear aliphatic hydrocarbon group is preferably an alkyl group.

Examples of the divalent aliphatic hydrocarbon group with a carbon number of 2, 4, 6, or 8 represented by $R^2$ and $R^3$ include an ethylene group, a n-butylene group, a n-hexylene group, and a n-octylene group.

Examples of the divalent alicyclic hydrocarbon group with a carbon number of 6 represented by $R^2$ and $R^3$ include a 1,4-cyclohexylene group, a 1,3-cyclohexylene group, and a 1,2-cyclohexylene group.

Examples of the divalent aromatic hydrocarbon group represented by $R^2$ and $R^3$ include an arylene group with a carbon number of 6 to 10, such as a 1,4-phenylene group, a 1,3-phenylene group, or a 1,2-phenylene group.

As $R^2$ and $R^3$, among the above, in view of an excellent thickening effect, a divalent aliphatic hydrocarbon group with a carbon number of 2, 4, 6, or 8 is preferable, a divalent aliphatic hydrocarbon group with a carbon number of 2, 4, or 6 is more preferable, a divalent aliphatic hydrocarbon group with a carbon number of 2 or 4 is even more preferable, and a divalent aliphatic hydrocarbon group with a carbon number of 2 is still more preferable. The divalent aliphatic hydrocarbon group is preferably a linear alkylene group.

$R^4$ represents a divalent aliphatic hydrocarbon group with a carbon number of 1 to 8. Among these, in view of an excellent thickening effect, a linear or branched alkylene group is preferable, and a linear alkylene group is more preferable.

The divalent aliphatic hydrocarbon group represented by $R^4$ has a carbon number of 1 to 8. In view of an excellent thickening effect, the carbon number is preferably 1 to 7, more preferably 3 to 7, even more preferably 3 to 6,

and particularly preferably 3 to 5.

Therefore, $R^4$ is preferably a linear or branched alkylene group with a carbon number of 1 to 8, more preferably a linear alkylene group with a carbon number of 1 to 7, even more preferably a linear alkylene group with a carbon number of 3 to 7, particularly preferably a linear alkylene group with a carbon number of 3 to 6, and most preferably a linear alkylene group with a carbon number of 3 to 5.

Examples of the monovalent aliphatic hydrocarbon group with a carbon number of 1 to 3 represented by $R^5$ and $R^6$ include a linear or branched alkyl group with a carbon number of 1 to 3 such as a methyl group, an ethyl group, a propyl group, or an isopropyl group; a linear or branched alkenyl group with a carbon number of 2 or 3 such as a vinyl group, a 1-methylvinyl group, or a 2-propenyl group; a linear or branched alkynyl group with a carbon number of 2 or 3 such as an ethynyl group or a propynyl group.

Examples of the hydroxyalkyl ether group represented by $R^5$ and $R^6$ include a mono or di(hydroxy) $C_{1-3}$ alkyl ether group such as a 2-hydroxyethoxy group, a 2-hydroxypropoxy group, or a 2,3-dihydroxypropoxy group.

Especially, $R^5$ and $R^6$ preferably each independently represent a monovalent aliphatic hydrocarbon group with a carbon number of 1 to 3, more preferably each independently represent a linear or branched alkyl group with a carbon number of 1 to 3, even more preferably each independently represent a linear alkyl group with a carbon number of 1 to 3, and particularly preferably each independently represent a methyl group.

As the compound represented by Formula (II), the compounds represented by the following Formulas (II-1) to (II-9) are preferable.

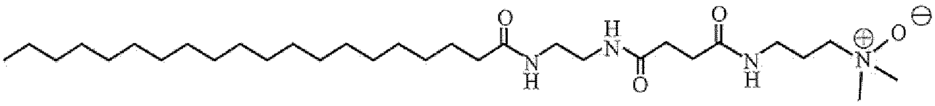
(II-1)

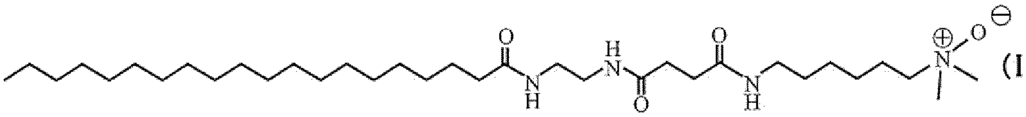
(II-2)

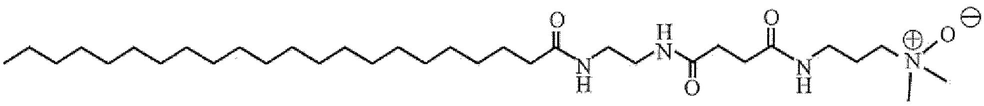
(II-3)

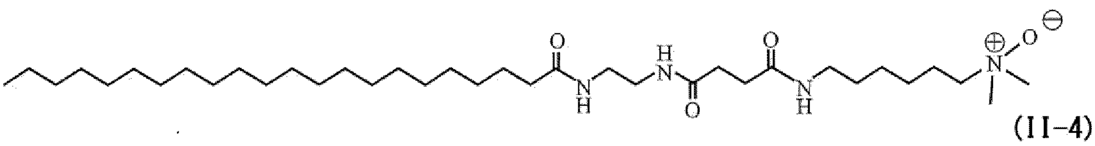
(II-4)

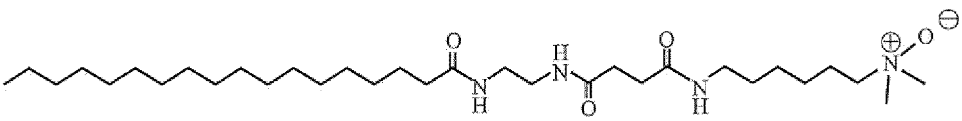
(II-5)

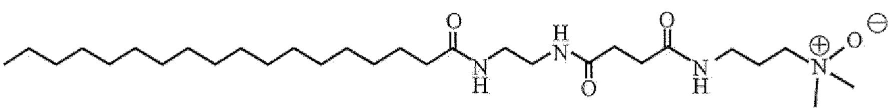
(II-6)

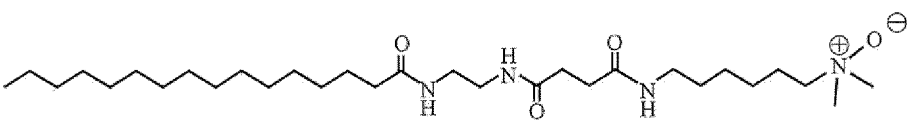
(II-7)

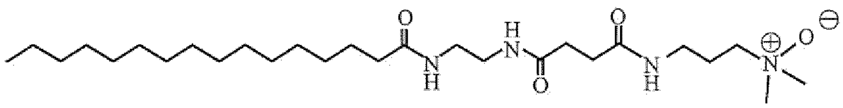

(II-8)

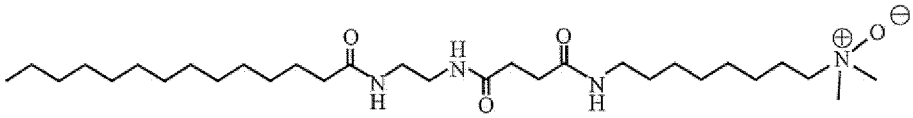

(II-9)

Examples of the anti-aggregation dispersant include ANTI-TERRA-203, ANTI-TERRA-204, ANTI-TERRA-206, and ANTI-TERRA-250 (all are trade names, manufactured by BYK-Chemie GmbH.): ANTI-TERRA-U (trade name, manufactured by BYK-Chemie GmbH.): DISPER BYK-102, DISPER BYK-180, and DISPER BYK-191 (all are trade names, manufactured by BYK-Chemie GmbH.): BYK-P105" (trade name, manufactured by BYK-Chemie GmbH.): TEGO Disper 630 and TEGO Disper 700 (all are trade names, manufactured by Evonik Degussa Japan Co., Ltd.): Taren VA-705B (trade name, manufactured by KYOEISHA CHEMICAL CO., LTD.): FLOWNON RCM-300TL and FLOWNON RCM-230 AF (trade name, manufactured by KYOEISHA CHEMICAL CO., LTD., amide wax), and the like.

In a case where the composition contains an anti-aggregation dispersant, the content of the anti-aggregation dispersant with respect to the total mass of the composition is preferably 1% to 24% by mass, more preferably 1% to 15% by mass, even more preferably 1% to 12% by mass, particularly preferably 1% to 10% by mass, and most preferably 1% to 7% by mass.

The content of the anti-aggregation dispersant with respect to the total solid content of the composition is preferably 0.8% to 24% by mass, more preferably 0.8% to 15% by mass, even more preferably 0.8% to 12% by mass, still more preferably 0.8% to 10% by mass, particularly preferably 0.8% to 8% by mass, and most preferably 0.8% to 7% by mass.

The content of the anti-aggregation dispersant is a content that does not include the content of the resin-type rheology control agent. The resin-type rheology control agent corresponds to the resin which is the aforementioned binder component.

<Inorganic rheology control agent>

Examples of the inorganic rheology control agent include bentonite, silica, calcium carbonate, and smectite.

[Curing agent]

The composition may contain a curing agent.

Particularly, in a case where the composition contains a compound having an epoxy group and/or an oxetanyl group as a binder component, it is preferable that the composition contain a curing agent.

Examples of the curing agent include a phenol-based curing agent, a naphthol-based curing agent, an acid anhydride-based curing agent, an active ester-based curing agent, a benzoxazine-based curing agent, a cyanate ester-based curing agent, a carbodiimide-based curing agent, and an amine adduct-based curing agent.

One curing agent may be used alone, or two or more curing agents may be used in combination.

Specific examples of the phenol-based curing agent and the naphthol-based curing agent include "MEH-7700", "MEH-7810", and "MEH-7851" manufactured by MEIWA PLASTIC INDUSTRIES, LTD., "NHN", "CBN", and "GPH" manufactured by Nippon Kayaku Co., Ltd., "SN-170", "SN-180", "SN-190", "SN-475", "SN-485", "SN-495", "SN-375", and "SN-395" manufactured by NIPPON STEEL Chemical & Material Co., Ltd., "LA-7052", "LA-7054", "LA-3018", "LA-3018-50P", "LA-1356", "TD2090", and "TD-2090-60M" manufactured by DIC Corporation, and the like.

Examples of the acid anhydride-based curing agent include a curing agent having one or more acid anhydride groups in one molecule.

Specific examples of the acid anhydride-based curing agent include phthalic anhydride, tetrahydrophthalic anhydride, hexahydrophthalic anhydride, methyl tetrahydrophthalic anhydride, methyl hexahydrophthalic anhydride, methyl nadic anhydride, hydrogenated methyl nadic anhydride, trialkyltetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyltetracarboxylic acid dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphtho[1,2-C]furan-1,3-dione, ethylene glycol bis(anhydrotrimellitate), a polymer-type acid anhydride such as styrene maleic acid resin formed by copolymerization of styrene and maleic acid, and the like.

Examples of commercially available products of acid anhydride-based curing agents include "HNA-100", "MH-700", "MTA-15", "DDSA", "HF-08", and "OSA" manufactured by New Japan Chemical Co., Ltd., "YH306" and "YH307" manufactured by Mitsubishi Chemical Corporation., "H-TMAn" manufactured by MITSUBISHI GAS CHEMICAL COMPANY, INC., "HN-2200", "HN-2000", "HN-5500" and "MHAC-P" manufactured by Hitachi Chemical Co., Ltd., and the like.

As the active ester-based curing agent, compounds having three or more ester groups with high reaction activity in one molecule, such as phenol esters, thiophenol esters, N-hydroxyamine esters, and esters of heterocyclic hydroxy compounds, are preferably used.

As the active ester-based curing agent, an active ester compound containing a dicyclopentadiene-type diphenol structure, an active ester compound containing a naphthalene structure, an active ester compound containing acetylated phenol novolac, and an active ester compound containing a benzoylated phenol novolac are preferable. "Dicyclopentadiene-type diphenol structure" represents a divalent structural unit consisting of phenylene-dicyclopentalene-phenylene.

Examples of commercially available products of active ester-based curing agents include an active ester compound containing a dicyclopentadiene-type diphenol structure, such as "EXB9451", "EXB9460","EXB9460S", "HPC-8000", "HPC-8000H", "HPC-8000-65T", "HPC-8000H-65TM", "EXB-8000L", and "EXB-8000L-65TM" (manufactured by DIC Corporation); an active ester compound containing a naphthalene structure, such as "EXB9416-70BK" and "EXB-8150-65T" (manufactured by DIC Corporation); an active ester compound containing acetylated phenol novolac, such as "DC808" (manufactured by Mitsubishi Chemical Corporation.); an active ester compound containing benzoylated phenol novolac, such as "YLH1026" (manufactured by Mitsubishi Chemical Corporation.); an active ester-based curing agent which is acetylated phenol novolac, such as "DC808" (manufactured by Mitsubishi Chemical Corporation.); an active ester-based curing agent which is benzoylated phenol novolac, such as "YLH1026" (manufactured by Mitsubishi Chemical Corporation.), "YLH1030" (manufactured by Mitsubishi Chemical Corporation.), and "YLH1048 "(manufactured by Mitsubishi Chemical Corporation.); and the like.

Specific examples of the benzoxazine-based curing agent include "JBZ-OP100D" and "ODA-BOZ" manufactured by JFE Chemical Corporation; "HFB2006M" manufactured by Showa High Polymer Co., Ltd., "P-d" and "F-a" manufactured by SHIKOKU CHEMICALS CORPORATION., and the like.

Specific examples of the cyanate ester-based curing agent include "PT30" and "PT60" (both of which are phenol novolac-type polyfunctional cyanate ester resins) manufactured by Lonza Japan Ltd., "BA230", and "BA230S75" (a prepolymer in which some or all of bisphenol A dicyanate molecules are triazinated and form a trimer), and the like.

Specific examples of the carbodiimide-based curing agent include "V-03" and "V-07" manufactured by Nisshinbo Chemical Inc., and the like.

Examples of commercially available products of amine adduct-type curing agents include AJICURE PN-23 and PN-50 (both of which are manufactured by Ajinomoto Fine-Techno Co., Inc.).

In a case where the composition contains a compound having an epoxy group (or a compound having an oxetanyl group) and a curing agent, the ratio of the content of the compound having an epoxy group (or the compound having an oxetanyl group) to the content of the curing agent is preferably set such that the equivalence ratio of the epoxy group in the compound having an epoxy group (or the oxetnayl group in the compound having an oxetanyl group) to a reactive group (an active hydrogen group such as a hydroxyl group in a curing agent) in the curing agent ("number of epoxy groups (or number of oxetanyl groups)/"number of reactive groups") is 30/70 to 70/30, more preferably set such that the equivalence ratio is 40/60 to 60/40, and even more preferably set such that the equivalence ratio is 45/55 to 55/45.

Furthermore, in a case where the composition contains a compound having an epoxy group, a compound having an oxetanyl group, and a curing agent, it is preferable that the equivalence ratio of the epoxy group in the compound having an epoxy group and the oxetanyl group in the compound having an oxetanyl group to the reactive group in the curing agent ("number of epoxy groups and number of oxetanyl groups"/"number of reactive groups") satisfy the aforementioned numerical range.

The content of the curing agent with respect to the total mass of the composition is preferably 0.001% to 3.5% by mass, and more preferably 0.01% to 3.5% by mass.

The content of the curing agent with respect to the total solid content of the composition is preferably 0.001% to 3.5% by mass, and more preferably 0.01% to 3.5% by mass.

[Curing accelerator]

The composition may contain a curing accelerator.

Particularly, in a case where the composition contains a compound having an epoxy group and/or an oxetanyl group as a binder component, it is preferable that the composition contain a curing accelerator.

Examples of the curing accelerator include triphenylphosphine, methyltributylphosphonium dimethylphosphate, trisorthotolylphosphine, and a boron trifluoride amine complex. Examples of a commercially available products of phosphate-based curing accelerators include HISHICOLIN PX-4MP (manufactured by Nippon Chemical Industrial CO., LTD.).

Examples of the curing accelerator also include imidazole-based curing accelerators such as 2-methylimidazole (trade name; 2MZ), 2-undecylimidazole (trade name; C11-Z), 2-heptadecylimidazole (trade name; C17Z), 1,2-dimethylimidazole (trade name; 1.2 DMZ), 2-ethyl-4-methylimidazole (trade name; 2E4MZ), 2-phenylimidazole (trade name; 2PZ), 2-phenyl-4-methylimidazole (trade name; 2P4MZ), 1-benzyl-2-methylimidazole (trade name; 1B2MZ), 1-benzyl-2-phenylimidazole (trade name; 1B2PZ), 1-cyanoethyl-2-methylimidazole (trade name; 2MZ-CN), 1-cyanoethyl-2-undecylimidazole (trade name; C11Z-CN), 1-cyanoethyl-2-phenylimidazolium trimellitate (trade name; 2PZCNS-PW), 2,4-diamino-6-[2'-methylimidazolyl-(1')]-ethyl-s-triazine (trade name; 2MZ-A), 2,4-diamino-6-[2'-undecylimidazolyl-(1')]-ethyl-s-triazine (trade name; C11Z-A), 2,4-diamino-6-[2'-ethyl-4'-methylimidazolyl-(1')]-ethyl-s-triazine (trade name; 2E4MZ-A), 2,4-diamino-6-[2'-methylimidazolyl-(1')]-ethyl-s-triazine isocyanuric acid adduct (trade name; 2MA-OK), 2-phenyl-4,5-dihydroxymethylimidazole (trade name; 2PHZ-PW), 2-phenyl-4-methyl-5-hydroxymethylimidazole (trade name; 2P4MHZ-PW), 1-cyanoethyl-2-phenylimidazole (trade name; 2PZ-CN), 2,4-diamino-6-[2'-methylimidazolyl-(1')]-ethyl-s-triazine (trade name; 2MZA-PW), and 2,4-diamino-6-[2'-methylimidazolyl-(1')]-ethyl-s-triazine isocyanuric acid adduct (trade name: 2MAOK-PW) (all manufactured by SHIKOKU CHEMICALS CORPORATION.). Examples of triarylphosphine-based curing accelerators also include the compounds described in paragraph "0052" of JP2004-043405A. Examples of the phosphorus-based curing accelerators in which triphenylborane is added to triarylphosphine include the compounds described in paragraph "0024" of JP2014-005382A.

The content of the curing accelerator with respect to the total mass of the composition is preferably 0.0002% to 3% by mass, more preferably 0.002% to 2% by mass, and even more preferably 0.01% to 1% by mass.

The content of the curing accelerator with respect to the total solid content of the composition is preferably 0.0002% to 3% by mass, more preferably 0.002% to 2% by mass, and even more preferably 0.02% to 1% by mass.

[Polymerization Initiator]

The composition may contain a polymerization initiator.

Particularly, in a case where the composition contains a compound containing an ethylenically unsaturated group as a binder component, it is preferable that the composition contain a polymerization initiator.

As the polymerization initiator, known polymerization initiators can be used without particular limitation. Examples of the polymerization initiator include a photopolymerization initiator, a thermal polymerization initiator, and the like.

In a case where the composition contains a polymerization initiator, the content of the polymerization initiator with respect to the total mass of the composition is preferably 0.5% to 10% by mass, more preferably 0.5% to 5% by mass, and even more preferably 0.5% to 3% by mass.

In a case where the composition contains a polymerization initiator, the content of the polymerization initiator with respect to the total solid content of the composition is preferably 0.8% to 5% by mass, more preferably 0.8% to 4% by mass, and even more preferably 1.5% to 3% by mass.

<Thermal polymerization initiator>

Examples of the thermal polymerization initiator include azo compounds such as 2,2'-azobisisobutyronitrile (AIBN), 3-carboxypropionitrile, azobismalenonitrile, and dimethyl-(2,2')-azobis(2-methylpropionate) [V-601] and organic peroxides such as benzoyl peroxide, lauroyl peroxide, and potassium persulfate.

Specific examples of the polymerization initiator include the polymerization initiators described on pages 65 to 148 of "Ultraviolet Curing System" by Kiyomi Kato (published by GL Sciences Inc.: 1989), and the like.

<Photopolymerization Initiator>

The photopolymerization initiator is not particularly limited as long as it can initiate the polymerization of the polymerizable compound. As the photopolymerization initiator, known photopolymerization initiators can be used. As the photopolymerization initiator, for example, a photopolymerization initiator sensitive to light ranging from an ultraviolet region to a visible light region is preferable. Furthermore, the photopolymerization initiator may be an activator that brings a certain action together with a photoexcited sensitizer and generates active radicals or an initiator that initiates cationic polymerization according to the type of polymerizable compound.

In addition, it is preferable that the photopolymerization initiator contain at least one compound having molar absorption coefficient of at least 50 in a range of 300 to 800 nm (more preferably 330 to 500 nm).

Examples of the photopolymerization initiator include halogenated hydrocarbon derivatives (for example, a compound containing a triazine skeleton, a compound containing an oxadiazole skeleton, and the like), acylphosphine compounds such as acylphosphine oxide, hexaarylbiimidazole, oxime compounds such as oxime derivatives, organic peroxides, thio compounds, ketone compounds, aromatic onium salts, aminoacetophenone compounds, hydroxyacetophenone, and the like.

For specific examples of the photopolymerization initiator, for example, paragraphs "0265" to "0268" of JP2013-029760A can be referred to, and what are described in the paragraphs are incorporated into the present specification.

More specifically, as the photopolymerization initiator, for example, the aminoacetophenone-based initiator described in JP1998-291969A (JP-H10-291969A) and the acylphosphine-based initiator described in JP4225898B can also be used.

As hydroxyacetophenone compounds, for example, Omnirad-184, Omnirad-1173, Omnirad-500, Omnirad-2959, and Omnirad-127 (trade names, all manufactured by IGM Resins B.V) can be used.

As aminoacetophenone compounds, for example, commercially available products, Omnirad-907, Omnirad-369, and Omnirad-379EG (trade names, all manufactured by IGM Resins B.V), can be used. As aminoacetophenone compounds, it is also possible to use the compound described in JP2009-191179A having an absorption wavelength matched with a long wavelength light source having a wavelength of 365 nm or a wavelength of 405 nm.

As acylphosphine compounds, for example, commercially available products, Omnirad-819 and Omnirad-TPO (trade names, all manufactured by IGM Resins B.V), can be used.

As the photopolymerization initiator, an oxime ester-based polymerization initiator (oxime compound) is more preferable. Particularly, an oxime compound is preferable because this compound has high sensitivity and high polymerization efficiency and makes it easy to design a high coloring material content in the composition.

Specifically, as the oxime compound, for example, the compound described in JP2001-233842A, the compound described in JP2000-080068A, or the compound described in JP2006-342166A can be used.

Examples of the oxime compound include 3-benzoyloxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-(4-toluenesulfonyloxy)iminobutan-2-one, 2-ethoxycarbonyloxyimino-1-phenylpropan-1-one, and the like.

Examples of the oxime compound also include the compounds described in J. C. S. Perkin II (1979) pp. 1653-1660, J. C. S. Perkin II (1979) pp. 156-162, Journal of Photopolymer Science and Technology (1995) pp. 202-232, and JP2000-066385A, the compounds described in JP2000-080068A, JP2004-534797A, and JP2006-342166A, and the like.

As commercially available products, IRGACURE-OXE01 (manufactured by BASF SE), IRGACURE-OXE02 (manufactured by BASF SE), IRGACURE-OXE03 (manufactured by BASF SE), or IRGACURE-OXE04 (manufactured by BASF SE) is also preferable. In addition, TR-PBG-304 (manufactured by Changzhou Tronly New Electronic Materials Co., Ltd.), ADEKA ARKLS NCI-831 and ADEKA ARKLS NCI-930 (manufactured by ADEKA CORPORATION), or N-1919 (carbazole oxime ester skeleton-containing photoinitiator (manufactured by ADEKA CORPORATION)) can also be used.

Furthermore, as oxime compounds other than the above, the compound described in JP2009-519904A in which oxime is linked to the N-position of carbazole; the compound described in US7626957B in which a hetero substituent is introduced into a benzophenone moiety; the compounds described in JP2010-015025A and US2009-292039A in which a nitro group is introduced into a dye moiety; the ketoxime compound described in WO2009-131189A; the compound described in US7556910B that contains a triazine skeleton and an oxime skeleton in the same molecule; the compound described in JP2009-221114A that has absorption maximum at 405 nm and has excellent sensitivity to a g-line light source; and the like may also be used.

For example, paragraphs "0274" and "0275" of JP2013-029760A can be referred to, and what are described in the paragraphs are incorporated into the present specification.

Specifically, as the oxime compound, a compound represented by the following Formula (OX-1) is preferable. The aforementioned oxime compound may be an oxime compound in which the N-O bond is an (E) isomer, an oxime compound in which the N-O bond is a (Z) isomer, or an oxime compound in which the N-O bond is a mixture of an (E) isomer and a (Z) isomer.

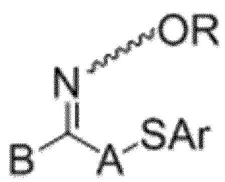
(OX-1)

In Formula (OX-1), R and B each independently represent a monovalent substituent, A represents a divalent organic group, and Ar represents an aryl group.

In Formula (OX-1), as the monovalent substituent represented by R, a monovalent non-metal atomic group is preferable.

Examples of the monovalent non-metal atomic group include an alkyl group, an aryl group, an acyl group, an alkoxycarbonyl group, an aryloxycarbonyl group, a heterocyclic group, an alkylthiocarbonyl group, an arylthiocarbonyl group, and the like. Furthermore, these groups may have one or more substituents. In addition, the aforementioned substituents may be further substituted with another substituent.

Examples of the substituent include a halogen atom, an aryloxy group, an alkoxycarbonyl or aryloxycarbonyl group, an acyloxy group, an acyl group, an alkyl group, an aryl group, and the like.

As the monovalent substituent represented by B in Formula (OX-1), an aryl group, a heterocyclic group, an arylcarbonyl group, or a heterocyclic carbonyl group is preferable, and an aryl group or a heterocyclic group is more preferable. These groups may have one or more substituents. Examples of the substituents include the aforementioned substituents.

As the divalent organic group represented by A in Formula (OX-1), an alkylene group with a carbon number of 1 to 12, a cycloalkylene group, or an alkynylene group is preferable. These groups may have one or more substituents. Examples of the substituents include the aforementioned substituents.

As the photopolymerization initiator, an oxime compound containing a fluorine atom can also be used. Specific examples of the oxime compound containing a fluorine atom include the compounds described in JP2010-262028A; compounds 24 and 36 to 40 described in JP2014-500852A; the compound (C-3) described in JP2013-164471A; and the like. What are described in these documents are incorporated into the present specification.

As the photopolymerization initiator, compounds represented by the following General Formulas (1) to (4) can also be used.

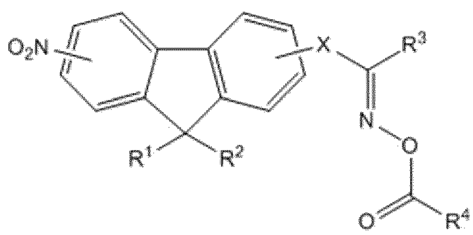

(1)

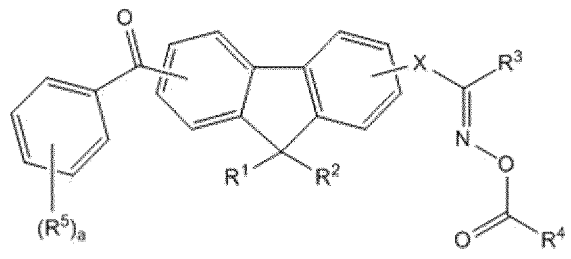

(2)

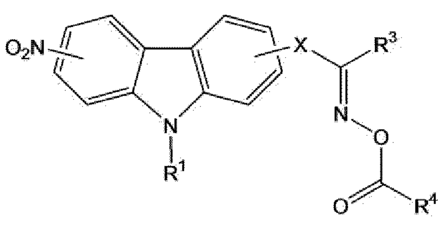

(3)

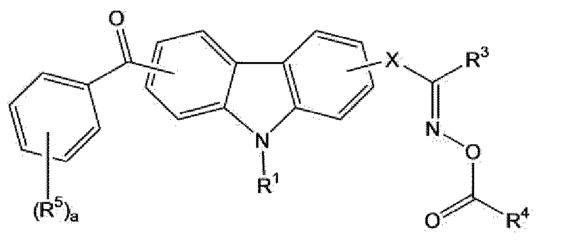

(4)

In Formula (1), $R^1$ and $R^2$ each independently represent an alkyl group with a carbon number of 1 to 20, an alicyclic hydrocarbon group with a carbon number of 4 to 20, an aryl group with a carbon number of 6 to 30, or an arylalkyl group with a carbon number of 7 to 30; in a case where $R^1$ and $R^2$ represent phenyl groups, the phenyl groups may be bonded together to form a fluorene group; $R^3$ and $R^4$ each independently represent a hydrogen atom, an alkyl group with a carbon number of 1 to 20, an aryl group with a carbon number of 6 to 30, an arylalkyl group with a carbon number of 7 to 30, or a heterocyclic group with a carbon number of 4 to 20; and X represents a direct bond or a carbonyl group.

In Formula (2), $R^1$, $R^2$, $R^3$, and $R^4$ have the same definitions as $R^1$, $R^2$, $R^3$, and $R^4$ in Formula (1), $R^5$ represents $-R^6$, $-OR^6$, $-SR^6$, $-COR^6$, $-CONR^6R^6$, $-NR^6COR^6$, $-OCOR^6$, $-COOR^6$, $-SCOR^6$, $-OCSR^6$, $-COSR^6$, $-CSOR^6$, -CN, a halogen atom, or a hydroxyl group, $R^6$ represents an alkyl group with a carbon number of 1 to 20, an aryl group with a carbon number of 6 to 30, an arylalkyl group with a carbon number of 7 to 30, or a heterocyclic group with a carbon number of 4 to 20, X represents a direct bond or a carbonyl group, and a represents an integer of 0 to 4.

In Formula (3), $R^1$ represents an alkyl group with a carbon number of 1 to 20, an alicyclic hydrocarbon group with a carbon number of 4 to 20, an aryl group with a carbon number of 6 to 30, or an arylalkyl group with a carbon number of 7 to 30; $R^3$ and $R^4$ each independently represent a hydrogen atom, an alkyl group with a carbon number of 1 to 20, an aryl group with a carbon number of 6 to 30, an arylalkyl group with a carbon number of 7 to 30, or a heterocyclic

group with a carbon number of 4 to 20; and X represents a direct bond or a carbonyl group.

In Formula (4), $R^1$, $R^3$, and $R^4$ have the same definitions as $R^1$, $R^3$, and $R^4$ in Formula (3), $R^5$ represents $-R^6$, $-OR^6$, $-SR^6$, $-COR^6$, $-CONR^6R^6$, $-NR^6COR^6$, $-OCOR^6$, $-COOR^6$, $-SCOR^6$, $-OCSR^6$, $-COSR^6$, $-CSOR^6$, -CN, a halogen atom, or a hydroxyl group, $R^6$ represents an alkyl group with a carbon number of 1 to 20, an aryl group with a carbon number of 6 to 30, an arylalkyl group with a carbon number of 7 to 30, or a heterocyclic group with a carbon number of 4 to 20, X represents a direct bond or a carbonyl group, and a represents an integer of 0 to 4.

In the Formulas (1) and (2), each of $R^1$ and $R^2$ is preferably a methyl group, an ethyl group, an n-propyl group, an i-propyl group, a cyclohexyl group, or a phenyl group. $R^3$ is preferably a methyl group, an ethyl group, a phenyl group, a tolyl group, or a xylyl group. $R^4$ is preferably an alkyl group or a phenyl group with a carbon number of 1 to 6. $R^5$ is preferably a methyl group, an ethyl group, a phenyl group, a tolyl group, or a naphthyl group. X is preferably a direct bond.

In the Formulas (3) and (4), $R^1$ is preferably a methyl group, an ethyl group, an n-propyl group, an i-propyl group, a cyclohexyl group, or a phenyl group. $R^3$ is preferably a methyl group, an ethyl group, a phenyl group, a tolyl group, or a xylyl group. $R^4$ is preferably an alkyl group with a carbon number of 1 to 6, or a phenyl group. $R^5$ is preferably a methyl group, an ethyl group, a phenyl group, a tolyl group, or a naphthyl group. X is preferably a direct bond.

Specific examples of the compounds represented by Formulas (1) and (2) include the compounds described in paragraphs "0076" to "0079" of JP2014-137466A. What are described in these documents are incorporated into the present specification.

Specific examples of the oxime compound preferably used in the aforementioned composition will be shown below. Among the following oxime compounds, the oxime compound represented by General Formula (C-13) is more preferable.

Furthermore, as the oxime compound, the compounds described in Table 1 of WO2015/036910A can also be used, and what are described in the document are incorporated into the present specification.

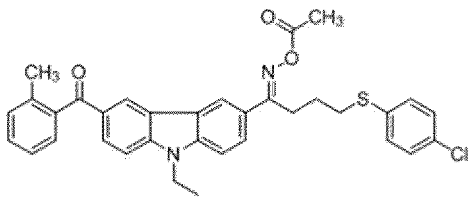

(C-1)

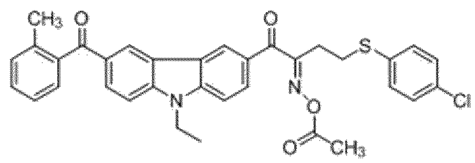

(C-2)

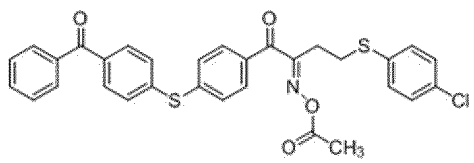

(C-3)

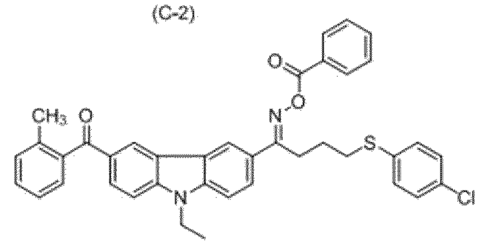

(C-4)

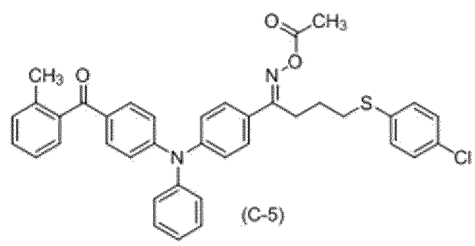

(C-5)

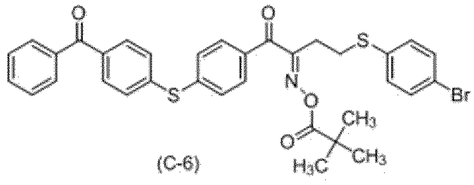

(C-6)

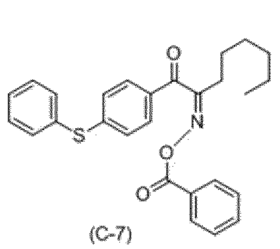

(C-7)

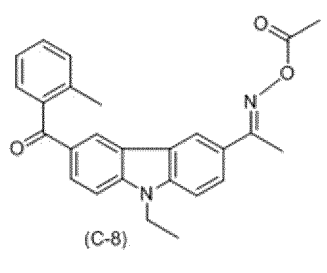

(C-8)

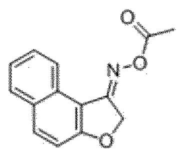

(C-9)

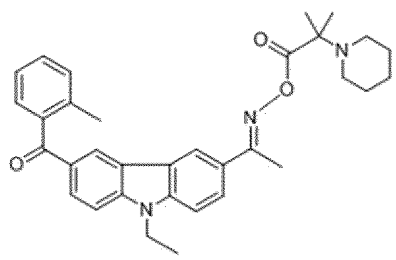

(C-10)

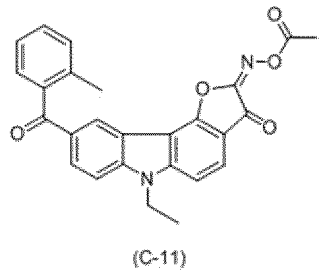

(C-11)

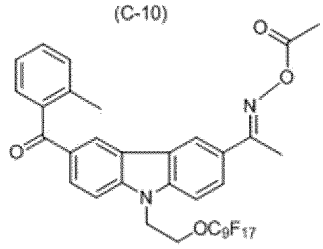

(C-12)

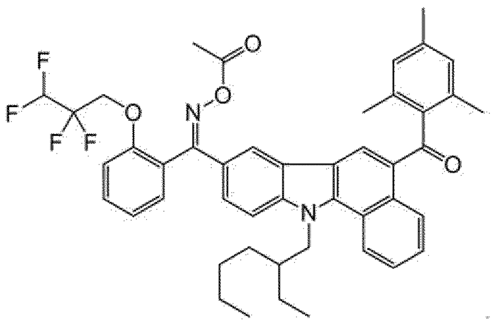

(C-13).

The oxime compound preferably has a maximal absorption wavelength in a wavelength range of 350 to 500 nm, more preferably has a maximal absorption wavelength in a wavelength range of 360 to 480 nm, and even more preferably has a high absorbance at wavelengths of 365 nm and 405 nm.

In view of sensitivity, the molar absorption coefficient of the oxime compound at 365 nm or 405 nm is preferably 1,000 to 300,000, more preferably 2,000 to 300,000, and even more preferably 5,000 to 200,000.

The molar absorption coefficient of a compound can be measured using known methods. For example, it is preferable to measure the molar absorption coefficient by using an ultraviolet-visible spectrophotometer (Cary-5 spectrophotometer manufactured by Varian) and ethyl acetate at a concentration of 0.01 g/L.

As necessary, two or more photopolymerization initiators may be used in combination.

As the photopolymerization initiator, it is also possible to use the compounds described in paragraph "0052" of JP2008-260927A, paragraphs "0033" to "0037" of JP2010-097210A, and paragraph "0044" of JP2015-068893A, and what are described in the paragraphs are incorporated into the present specification. In addition, the oxime initiator described in KR10-2016-0109444A can also be used.

[Polymerization Inhibitor]

The composition may contain a polymerization inhibitor.

As the polymerization inhibitor, known polymerization inhibitors can be used without particular limitation. Examples of the polymerization inhibitor include a phenol-based polymerization inhibitor (for example, p-methoxyphenol, 2,5-di-tert-butyl-4-methylphenol, 2,6-di-tert-butyl-4-methylphenol, 4,4'-thiobis(3-methyl-6-t-butylphenol), 2,2'-methylenebis(4-methyl-6-t-butylphenol), 4-methoxynaphthol, or the like); a hydroquinone-based polymerization inhibitor (for example, hydroquinone, 2,6-di-tert-butyl hydroquinone, or the like); a quinone-based polymerization inhibitor (for example, benzoquinone or the like); a free radical-based polymerization inhibitor (for example, a 2,2,6,6-tetramethylpiperidine 1-oxyl free radical, a 4-hydroxy-2,2,6,6-tetramethylpiperidine 1-oxyl free radical, or the like); a nitrobenzene-based polymerization inhibitor (for example, nitrobenzene, 4-nitrotoluene, or the like); a phenothiazine-based polymerization

inhibitor (for example, phenothiazine, 2-methoxyphenothiazine, or the like); and the like.

Among these, a phenol-based polymerization inhibitor or a free radical-based polymerization inhibitor is preferable.

The effect of the polymerization inhibitor is marked in a case where the polymerization inhibitor is used together with a resin containing a curable group.

The content of the polymerization inhibitor in the composition is not particularly limited. The content of the polymerization inhibitor with respect to the total mass of the composition is preferably 0.0001% to 0.5% by mass, more preferably 0.0001% to 0.2% by mass, and even more preferably 0.0001% to 0.05% by mass.

The content of the polymerization inhibitor with respect to the total solid content of the composition is preferably 0.0001% to 0.5% by mass, more preferably 0.0001% to 0.2% by mass, and even more preferably 0.0001% to 0.05% by mass.

[Surfactant]

The composition may contain a surfactant. The surfactant contributes to the improvement of the coating properties of the composition.

In a case where the composition contains a surfactant, the content of the surfactant with respect to the total mass of the composition is preferably 0.001% to 2.0% by mass, more preferably 0.005% to 0.5% by mass, and even more preferably 0.005% to 0.1% by mass.

The content of the surfactant with respect to the total solid content of the composition is preferably 0.001% to 2.0% by mass, more preferably 0.005% to 0.5% by mass, and even more preferably 0.01% to 0.1% by mass.

Examples of the surfactant include a fluorine-based surfactant, a nonionic surfactant, a cationic surfactant, an anionic surfactant, a silicone-based surfactant, and the like.

For example, in a case where the composition contains a fluorine-based surfactant, the liquid properties (particularly, fluidity) of the composition are further improved. That is, in a case where a film is formed using the composition containing a fluorine-based surfactant, the interfacial tension between the surface to be coated and the coating liquid is reduced, and the wettability with respect to the surface to be coated is improved, which improves the coating properties with respect to the surface to be coated. Therefore, it is effective to use the composition containing a fluorine-based surfactant, because then a film having a uniform thickness with small thickness unevenness is more suitably formed even in a case where a thin film of about several μm is formed using a small amount of liquid.

The fluorine content in the fluorine-based surfactant is preferably 3% to 40% by mass, more preferably 5% to 30% by mass, and even more preferably 7% to 25% by mass. The fluorine-based surfactant with a fluorine content in this range is effective for achieving thickness uniformity of a coating film and/or saving liquid, and has excellent solubility in the composition.

Examples of the fluorine-based surfactant include the surfactants described in paragraphs "0060" to "0064" of JP2014-041318A (paragraphs "0060" to "0064" of WO2014/017669A corresponding to JP2014-041318A) and the like, the surfactants described in paragraphs "0117" to "0132" of JP2011-132503A, and the surfactant described JP2020-008634A. What are described in these documents are incorporated into the present specification. Examples of commercially available products of fluorine-based surfactants include MEGAFACE F-171, F-172, F-173, F-176, F-177, F-141, F-142, F-143, F-144, F-437, F-475, F-477, F-479, F-482, F-554, F-555-A, F-556, F-557, F-558, F-559, F-560, F-561, F-565, F-563, F-568, F-575, F-780, EXP, MFS-330, R-41, R-41-LM, R-01, R-40, R-40-LM, R-43, RS-43, TF-1956, RS-90, R-94, RS-72-K, and DS-21 (all of these are manufactured by DIC Corporation), FLUORAD FC430, FC431, and FC171 (all of these are manufactured by Sumitomo 3M Ltd.); SURFLON S-382, SC-101, SC-103, SC-104, SC-105, SC-1068, SC-381, SC-383, S-393, and KH-40 (all of these are manufactured by AGC Inc.), PolyFox PF636, PF656, PF6320, PF6520, and PF7002 (all of these are manufactured by OMNOVA Solutions), FTERGENT 710FM, 610FM, 601AD, 601ADH2, 602A, 215M, and 245F (all of these are manufactured by NEOS COMPANY LIMITED), and the like.

A block polymer can also be used as the fluorine-based surfactant, and specific examples thereof include the compounds described in JP2011-089090A.

Examples of the silicone-based surfactant include KF-6001 and KF-6007 (manufactured by Shin-Etsu Chemical Co., Ltd.)

From the viewpoint of environmental regulation, sometimes the use of perfluoroalkyl sulfonic acid and a salt thereof, and perfluoroalkyl carboxylic acid and a salt thereof is restricted.

In a case where the content of the above compounds in the composition is to be reduced, the content of the perfluoroalkyl sulfonic acid (particularly, perfluoroalkyl sulfonic acid having a perfluoroalkyl group with a carbon number of 6 to 8) and a salt thereof, and the perfluoroalkyl carboxylic acid (particularly, perfluoroalkyl carboxylic acid having a perfluoroalkyl group with a carbon number of 6 to 8) and a salt thereof with respect to the total solid content of the composition is preferably 0.01 to 1,000 ppb, more preferably 0.05 to 500 ppb, and even more preferably 0.1 to 300 ppb.

The composition may substantially not contain the perfluoroalkyl sulfonic acid and a salt thereof and the perfluoroalkyl carboxylic acid and a salt thereof. For example, a compound that can substitute for perfluoroalkyl sulfonic acid and a salt thereof and a compound that can substitute for perfluoroalkyl carboxylic acid and a salt thereof may be used such that the composition substantially does not contain perfluoroalkyl sulfonic acid and a salt thereof and perfluoroalkyl carboxylic acid and a salt thereof. Examples of the compound that can substitute for the regulated compound include compounds excluded from the regulation target due to the difference in the carbon number of the perfluoroalkyl group. Here, what are described above do not prevent the use of the perfluoroalkyl sulfonic acid and a salt thereof and the perfluoroalkyl carboxylic acid and a salt thereof. The composition may contain the perfluoroalkyl sulfonic acid and a salt thereof and the perfluoroalkyl carboxylic acid and a salt thereof, within the maximum allowable range.

[Adhesion aid]

It is also preferable that the composition contain a silane coupling agent as an adhesion aid.

Specific examples of the silane coupling agent include N-phenyl-3-aminopropyltrimethoxysilane, phenyltrimethoxysilane, N-(2-aminoethyl)3-aminopropylmethyldimethoxysilane,

N-(2-aminoethyl)3-aminopropylmethyltrimethoxysilane, 3-aminopropyltriethoxysilane, 3-mercaptopropyltrimethoxysilane, vinyltrimethoxysilane, N-(2-(vinylbenzylamino)ethyl)3-aminopropyltrimethoxysilane hydrochloride, 3-methacryloxypropyltrimethoxysilane, 3-chloropropylmethyldimethoxysilane, 3-chloropropyltrimethoxysilane, and the like.

Examples of commercially available products of silane coupling agents include a KBM series, a KBE series, and the like (for example, KBM-573 and KBM-103) manufactured by Shin-Etsu Chemical Co., Ltd.

In a case where the composition contains an adhesion aid, the content of the adhesion aid with respect to the total mass of the composition is preferably 0.05% to 2% by mass, more preferably 0.05% to 1% by mass, and even more preferably 0.05% to 0.8% by mass.

The content of the adhesion aid with respect to the total solid content of the composition is preferably 0.05% to 2% by mass, more preferably 0.05% to 1% by mass, and even more preferably 0.05% to 0.8% by mass.

[Other optional components]

The composition may further contain other optional components in addition to the aforementioned components. Examples of the optional components include a sensitizer, a co-sensitizer, a plasticizer, a diluent, an oil sensitizing agent, a filler, a rubber component, and the like. As necessary, known additives, such as aids (for example, an antifoaming agent, a flame retardant, a leveling agent, a peeling accelerator, an antioxidant, a fragrance, a surface tension adjuster, a chain transfer agent, and the like) may be further added to the composition.

[Physical properties of composition]

In view of further improving sedimentation stability of the magnetic particles, the viscosity of the composition at 23°C and a shear rate of 0.1 (1/s) is preferably 1 to 1,000,000 Pa·s, more preferably 10 to 50,000 Pa·s, and even more preferably 50 to 10,000 Pa·s.

In view of further improving sedimentation stability of the magnetic particles, the viscosity of the composition at 23°C and a shear rate of 1,000 (1/s) is preferably 100 Pa·s or less, more preferably 50 Pa·s or less, and even more preferably 10 Pa·s or less. The lower limit of the viscosity at a shear rate of 1,000 (1/s) is preferably 0.001 Pa·s or more.

The viscosity of the composition at 23°C is obtained by measuring viscosity at 23°C by using MCR-102 (manufactured by Anton Paar GmbH) while increasing the shear rate from 0.1/s to 1,000/s.

[Manufacturing method of composition]

The composition can be prepared by mixing together the components described above by a known mixing method (for example, a mixing method using a stirrer, a homogenizer, a high-pressure emulsifier, a wet pulverizer, a wet disperser, or the like).

In preparing the composition, the components may be mixed together at once, or the components may be dissolved or dispersed one by one in a solvent and then sequentially mixed together. Furthermore, the order of adding components and working conditions at the time of mixing are not particularly limited. For example, in a case where two or more other resins are used, the resins may be mixed together at once, or each kind of resin may be mixed in batches.

[Use]

The composition can be suitably used as a composition for filling holes of hole portions, such as via holes and through-holes, provided on a substrate.
In a case where the composition is used as a composition for filling holes, the composition preferably contains a resin precursor as a binder component. In view of further improving the effects of the present invention, the compound more preferably contains an epoxy compound and/or an oxetanyl compound.
In a case where the composition contains an epoxy compound and/or an oxetanyl compound as a binder component, one of the examples of a specific hole filling procedure is a method including the following steps 1 to 3.
Step 1: a step of coating a substrate provided with hole portions such as via holes or through-holes with the composition by a known coating method such as a slit coating method, an ink jet method, a spin coating method, a cast coating method, a roll coating method or a screen printing method such that the hole portions are filled with the composition
Step 2: a step of heating the substrate having undergone the step 1 at about 120°C to 180°C for about 30 to 90 minutes such that either or both of the epoxy compound and the oxetanyl compound in the composition are cured
Step 3: a step of removing unnecessary portions of the cured substance sticking out of the substrate surface by physical polishing such that the substrate has a flat surface
In a case where the composition contains a photocurable resin precursor as a binder component, in the procedure of the steps 1 to 3, it is preferable that a step including an exposure treatment of irradiating the substrate with an actinic ray or radiation be performed instead of the step 2.
It is also preferable that the composition be formed into a film.
In a case where the composition is cured, it is preferable that the composition contain a resin precursor as a binder component. In view of further improving the effects of the present invention, it is more preferable that the composition contain an epoxy compound and/or an oxetanyl compound.
The film formed of the composition is suitably used as electronic components such as an antenna and an inductor installed in an electronic communication device and the like.
In view of further improving magnetic permeability, the film thickness of the film formed of the composition is preferably 1 to 10,000 μm, more preferably 10 to 1,000 μm, and particularly preferably 15 to 800 μm.

[Cured substance (magnetic particle-containing cured substance)]

The cured substance (magnetic particle-containing cured substance) according to an embodiment of the present invention is formed of the composition according to the embodiment of the present invention described above. The shape of the cured substance of according to the embodiment of the present invention is not particularly limited. For example, as described above, the cured substance may have a shape compatible with the shape of the hole portions provided in the substrate or may have a film shape.

[Manufacturing method of cured substance]

The cured substance according to the embodiment of the present invention is obtained, for example, by curing the aforementioned composition.
In a case where the composition is cured, it is preferable that the composition contain a resin precursor as a binder component. In view of further improving the effects of the present invention, it is more preferable that the composition contain an epoxy compound and/or an oxetanyl compound.
The manufacturing method of the cured substance is not particularly limited, but preferably includes the following steps.

· Composition layer forming step
· Curing step

Hereinafter, by taking a manufacturing method of a cured substance having a film shape as an example, the manufacturing method of the cured substance according to the embodiment of present invention will be described. Hereinafter, the film-shaped cured substance will be called a magnetic particle-containing cured film.

<Composition layer forming step>

In the composition layer forming step, the composition is applied to a substrate (support) or the like such that a layer of the composition (composition layer) is formed. The substrate may be, for example, a wiring board having an antenna portion or an inductor portion.

As a method for applying the composition to the substrate, various coating methods such as a slit coating method, an ink jet method, a spin coating method, a cast coating method, a roll coating method, and a screen printing method can be used. The film thickness of the composition layer is preferably 1 to 10,000 μm, more preferably 10 to 1,000 μm, and even more preferably 15 to 800 μm. The composition layer applied to the substrate may be heated (pre-baked). The pre-baking is performed, for example, using a hot plate, an oven, or the like at a temperature of 50°C to 140°C for 10 to 1,800 seconds. Particularly, it is preferable to perform pre-baking in a case where the composition contains a solvent.

<Curing step>

The curing step is not particularly limited as long as the composition layer can be cured, and examples thereof include a heating treatment of heating the composition layer, an exposure treatment of irradiating the composition layer with an actinic ray or radiation, and the like.
In a case where the heating treatment is performed, for example, the heating treatment can be performed continuously or in batch by using heating means such as a hot plate, a convection oven (hot air circulation-type dryer), or a high-frequency heater.
The heating temperature during the heating treatment is preferably 120°C to 260°C, and more preferably 150°C to 240°C. The heating time is not particularly limited, but is preferably 10 to 1,800 seconds.
Note that pre-baking in the composition layer forming step may serve as the heating treatment in the curing step.
In a case where the exposure treatment is performed, the method of irradiating the composition layer with an actinic ray or radiation is not particularly limited. It is preferable to irradiate the composition layer through a photomask having a patterned opening portion.
The exposure is preferably performed by irradiation with radiation. As the radiation that can be used for exposure, an ultraviolet ray such as g-line, h-line, or i-line is preferable, and a high-pressure mercury lamp is preferable as a light source. The irradiation intensity is preferably 5 to 1,500 $mJ/cm^2$, and more preferably 10 to 1,000 $mJ/cm^2$.
In a case where the composition contains a thermal polymerization initiator, the composition layer may be heated in the above exposure treatment. The heating temperature is not particularly limited, but is preferably 80°C to 250°C. The heating time is not particularly limited, but is preferably 30 to 300 seconds.
In a case where the composition layer is heated in the exposure treatment, the heating may serve as a post-heating step which will be described later. In other words, in a case where the composition layer is heated in the exposure treatment, the manufacturing method of the magnetic particle-containing cured film may not include a post-heating step.

<Development step>

In a case where the exposure treatment is performed in the curing step, the manufacturing method may further include a development step.
The development step is a step of developing the exposed composition layer to form a magnetic particle-containing cured film. By this step, the composition layer in a portion not being irradiated with light in the exposure treatment is eluted, and only the photo-cured portion remains. In this way, a patterned magnetic particle-containing cured film is obtained.
Although the type of developer used in the development step is not particularly limited, it is desirable to use an alkali developer that does not damage the circuit or the like.
The development temperature is, for example, 20°C to 30°C.
The development time is, for example, 20 to 90 seconds. In recent years, in order to more thoroughly remove residues, sometimes the development has been performed for 120 to 180 seconds. Furthermore, in order to further improve the residue removability, sometimes a step of shaking off the developer every 60 seconds and supplying a new developer is repeated several times.
As the alkali developer, an alkaline aqueous solution is preferable which is prepared by dissolving an alkaline compound in water at a concentration of 0.001% to 10% by mass (preferably 0.01% to 5% by mass).
Examples of the alkaline compound include sodium hydroxide, potassium hydroxide, sodium carbonate, sodium silicate, sodium metasilicate, aqueous ammonia, ethylamine, diethylamine, dimethylethanolamine, tetramethylammonium hydroxide, tetraethylammonium hydroxide, tetrapropylammonium hydroxide, tetrabutylammonium hydroxide, benzyltrimethylammonium hydroxide, choline, pyrrole, piperidine, 1,8-diazabicyclo[5.4.0]-7-undecene, and the like (among these, an organic alkali is preferable).
In a case where an alkali developer is used, generally, a rinsing treatment using water is performed after development.

<Post-baking>

In a case where the exposure treatment is performed in the curing step, it is preferable to perform the heating treatment (post-baking) after the curing step. The post-baking is a heating treatment for completion of curing. In a case where the development step is performed, it is preferable to perform the post-baking after the development step. The heating temperature is preferably 240°C or lower, and more preferably 220°C or lower. The lower limit of the heating temperature is not particularly limited. However, considering an efficient and effective treatment, the heating temperature is preferably 50°C or higher, and more preferably 100°C or higher. The heating time is not particularly limited, but is preferably 10 to 1,800 seconds.

The post-baking can be performed continuously or in batch by using heating means such as a hot plate, a convection oven (hot air circulation-type dryer), or a high-frequency heater.

It is preferable that the aforementioned post-baking be performed in an atmosphere with a low oxygen concentration. The oxygen concentration is preferably 19% by volume or less, more preferably 15% by volume or less, even more preferably 10% by volume or less, particularly preferably 7% by volume or less, and most preferably 3% by volume or less. The lower limit of the oxygen concentration is not particularly limited, but is practically 10 ppm by volume or more.

Instead of post-baking by heating described above, ultraviolet (UV) irradiation may be performed to complete curing.

In this case, it is preferable that the composition further contain a UV curing agent. The UV curing agent is preferably a UV curing agent that can be cured at a wavelength shorter than 365 nm, which is the exposure wavelength of the polymerization initiator added for the lithography process by ordinary i-line exposure. Examples of the UV curing agent include Ciba IRGACURE 2959 (trade name). In a case where UV irradiation is performed, it is preferable that the composition layer be a material that is cured at a wavelength of 340 nm or less. The lower limit of the wavelength is not particularly limited, but is 220 nm or more in general. The exposure amount of UV irradiation is preferably 100 to 5,000 mJ, more preferably 300 to 4,000 mJ, and even more preferably 800 to 3,500 mJ. In order to more effectively cure the composition layer at a low temperature, it is preferable that this UV curing step be performed after the exposure treatment. As the exposure light source, it is preferable to use an ozoneless mercury lamp.

[Magnetic particle-introduced substrate and electronic material]

The magnetic particle-introduced substrate according to an embodiment of the present invention comprises a substrate in which hole portions are formed and a cured substance (magnetic particle-containing cured substance) according to an embodiment of the present invention disposed in the hole portions.

The hole portions may be through-holes or recessed portions. Examples of the substrate in which hole portions are formed include a wiring board in which via holes, through-holes, or the like are formed. The method of forming the cured substance according to the embodiment of the present invention is as described above.

The magnetic particle-introduced substrate can be applied to, for example, an electronic material such as an inductor.

## Examples

Hereinafter, the present invention will be more specifically described based on examples. The materials, amounts and proportions of the materials used, details and procedures of treatments, and the like described in the following examples can be appropriately changed as long as the gist of the present invention is maintained. Therefore, the scope of the present invention is not limited to the following specific examples.

In the following description, unless otherwise specified, "%" means "% by mass", and "parts" means "parts by mass".

[Various components used for preparing composition]

To make the composition, the components described in Table 1 were prepared. The components described in Table 1 are summarized below.

[Magnetic particles]

·P-1: 80% Ni-4Mo PF-5F (manufactured by Epson Atmix Corporation, concentration of solid contents: 100% by mass, average primary particle diameter: 4 μm)

·P-2: 80% Ni-4Mo PF-15F (manufactured by Epson Atmix Corporation, concentration of solid contents: 100% by mass, average primary particle diameter: 8 μm)
·P-3: 80% Ni-4Mo WA13 (manufactured by Epson Atmix Corporation, concentration of solid contents: 100% by mass, average primary particle diameter: 12.5 μm)
·P-4: KUAMET-CT5-25 μm (manufactured by Epson Atmix Corporation, concentration of solid contents: 100% by mass, average primary particle diameter: 15 μm)
·P-5: AW2-08 PF-3F (manufactured by Epson Atmix Corporation, concentration of solid contents: 100% by mass, average primary particle diameter: 3 μm)
·P-6: AW2-08 PF-8F (manufactured by Epson Atmix Corporation, concentration of solid contents: 100% by mass, average primary particle diameter: 5 μm)
·P-7: AW2-08 PF-20F (manufactured by Epson Atmix Corporation, concentration of solid contents: 100% by mass, average primary particle diameter: 10 μm)
·P-8: KUAMET6B2 (manufactured by Epson Atmix Corporation, concentration of solid contents: 100% by mass, average primary particle diameter: 24 μm)
·P-9: EA-SMP-10 PF-5F (manufactured by Epson Atmix Corporation, concentration of solid contents: 100% by mass, average primary particle diameter: 10 μm)
·P-10: KUAMETNC (manufactured by Epson Atmix Corporation, concentration of solid contents: 100% by mass, average primary particle diameter: 25 μm)
·P-11: BSN-125 (manufactured by TODA KOGYO CORP., concentration of solid contents: 100% by mass, average primary particle diameter: 8 μm)
·P-12: BSN-714 (manufactured by TODA KOGYO CORP., concentration of solid contents: 100% by mass, average primary particle diameter: 30 μm)
·P-13: BSN-828 (manufactured by TODA KOGYO CORP., concentration of solid contents: 100% by mass, average primary particle diameter: 66 μm)
·P-14: BSF-547 (manufactured by TODA KOGYO CORP., concentration of solid contents: 100% by mass, average primary particle diameter: 11 μm)
·P-15: KNS-415 (manufactured by TODA KOGYO CORP., concentration of solid contents: 100% by mass, average primary particle diameter: 4 μm)
·P-16: particles prepared with reference to [Manufacturing Example 1] of JP2019-067960A, (concentration of solid contents: 100% by mass, average primary particle diameter: 10 μm)
·P-17: MOSS (manufactured by Powdertech., concentration of solid contents: 100% by mass, average primary particle diameter: 10 μm)

[Binder component]

·B-1: trade name "BYK-P105" (polymer of low-molecular-weight unsaturated carboxylic acid, manufactured by BYK-Chemie GmbH., concentration of solid contents: 100% by mass)
·B-2; trade name "Talen VA-705B" (higher fatty acid amide, manufactured by Kyoeisha Chemical Co., Ltd., concentration of solid contents 100% by mass)
·B-3: trade name "FLOWNON RCM-230AF" (higher fatty acid amide, manufactured by Kyoeisha Chemical Co., Ltd., concentration of solid contents: 10% by mass, diluting solvent: butyl acetate (boiling point 126°C)/3-methoxy-3-methyl-1-butanol (boiling point 174° C) (mixing ratio (mass ratio): 2/1))
·B-4: solution containing the following compound (weight-average molecular weight 10,000) (concentration of solid contents: 30% by mass, diluting solvent: PGMEA (boiling point 146°C). The numerical value attached to each repeating unit constituting the main chain represents a mass ratio, and the numerical value attached to each repeating unit included in the side chain represents the number of repeating units.

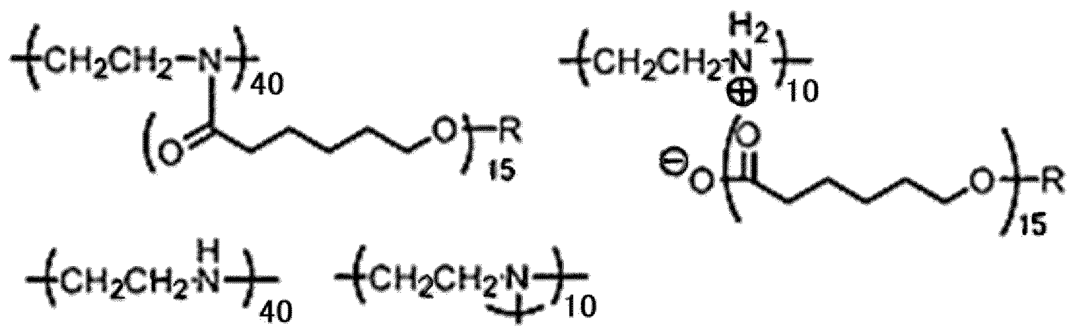

R= -CO$^n$C$_7$H$_{15}$, H

·B-5: solution containing the following compound (weight-average molecular weight 25,000) (concentration of solid contents: 30% by mass, diluting solvent: PGMEA (boiling point 146°C). The numerical value attached to each repeating unit constituting the main chain represents a mass ratio, and the numerical value attached to each repeating unit included in the side chain represents the number of repeating units.

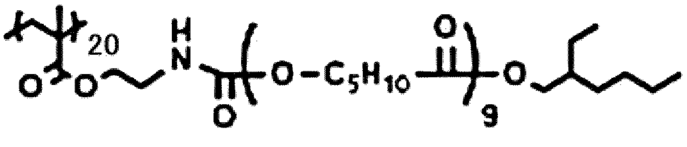
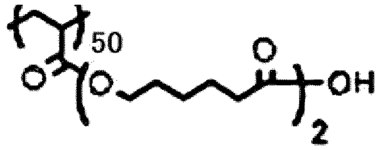

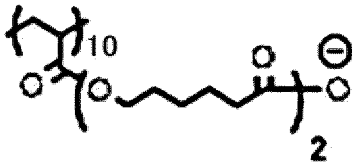
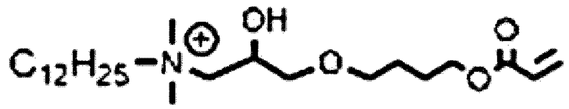

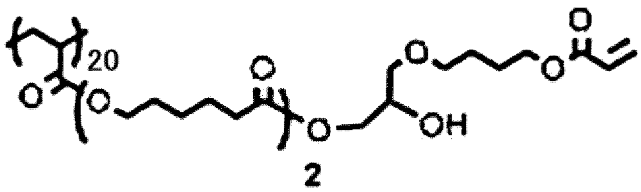

·B-6: solution containing the following compound (weight-average molecular weight 10,000) (concentration of solid contents: 30% by mass, diluting solvent: PGMEA (boiling point 146°C). The numerical value attached to each repeating unit constituting the main chain represents a mass ratio, and the numerical value attached to each repeating unit included in the side chain represents the number of repeating units.

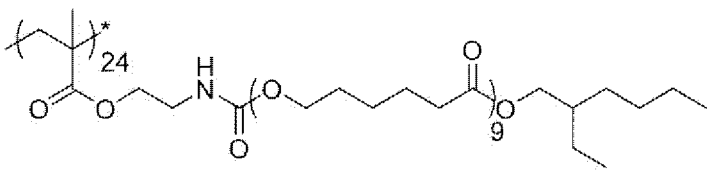
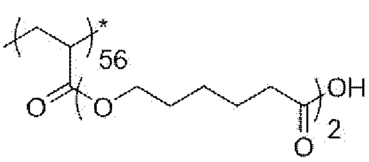

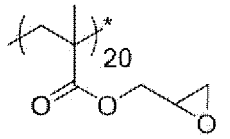

·B-7: trade name "C-2093I" (wet dispersant, manufactured by NOF CORPORATION., concentration of solid contents: 100% by mass)

·B-8: trade name "EHPE 3150" (1,2-epoxy-4-(2-oxiranyl)cyclohexane adduct of 2,2-bis(hydroxymethyl)-1-butanol, manufactured by Daicel Corporation, concentration of solid contents: 100% by mass)

·B-9: trade name "ACRYCURE RD-F8" (alkali-soluble resin containing curable group, manufactured by NIPPON SHOKUBAI CO., LTD., concentration of solid contents: 40% by mass, diluting solvent: PGMEA (boiling point 146°C))

·B-10: trade name "CELLOXIDE 2021P" (3',4'-epoxycyclohexylmethyl-3,4-epoxycyclohexane carboxylate, manufactured by Daicel Corporation, concentration of solid contents 100% by mass)

·B-11: trade name "DENACOL EX-411" (pentaerythritol polyglycidyl ether, manufactured by Nagase ChemteX Corporation., concentration of solid contents: 100% by mass)

·B-12: trade name "KAYARAD RP-1040" (the following compound, manufactured by Nippon Kayaku Co., Ltd., concentration of solid contents 100% by mass)

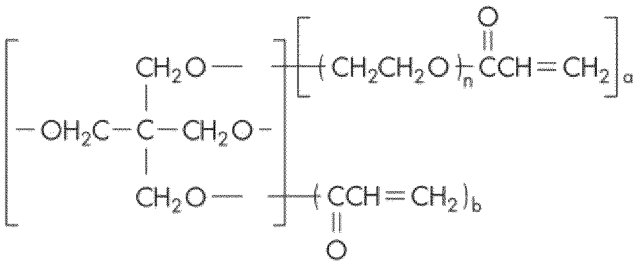

$a+b=4,\ \bar{n}=4$

·B-13: trade name "A-TMMT", (polyfunctional acrylic monomer, manufactured by TOAGOSEI CO., LTD., concentration of solid contents: 100% by mass)

·B-14: trade name "ZX1059" (mixture of bisphenol A-type epoxy resin and bisphenol F-type epoxy resin, manufactured by NIPPON STEEL Chemical & Material Co., Ltd., concentration of solid contents: 100% by mass)

·B-15: trade name "ZX1658GS" (liquid 1,4-glycidylcyclohexane-type epoxy resin, manufactured by NIPPON STEEL Chemical & Material Co., Ltd., concentration of solid contents: 100% by mass)

·B-16: trade name "HP-4700" (naphthalene-type tetrafunctional epoxy resin, manufactured by DIC Corporation, concentration of solid contents: 100% by mass)

·B-17: trade name "YX7553BH30" (phenoxy resin, manufactured by Mitsubishi Chemical Corporation., concentration of solid contents: 30% by mass, diluting solvent: MEK (boiling point 80°C)/cyclohexanone (boiling point 155.6°C))

·B-18: trade name "KS-1" (polyvinyl acetal resin, manufactured by SEKISUI CHEMICAL CO., LTD., concentration of solid contents: 100% by mass)

·B-19: trade name "828US" (bisphenol A-type epoxy resin, manufactured by Mitsubishi Chemical Corporation., concentration of solid contents: 100% by mass)

·B-20: trade name "NC3000L" (biphenyl-type epoxy resin, manufactured by Nippon Kayaku Co., Ltd., concentration of solid contents: 100% by mass)

·B-21: trade name "HPC-4032" (naphthalene-type difunctional epoxy resin, manufactured by DIC Corporation, concentration of solid contents: 100% by mass)

[Additive]

<Curing agent/Curing accelerator>

·A-1: trade name "HISHICOLIN PX-4MP" (phosphate-based epoxy curing accelerator, manufactured by Nippon Chemical Industrial CO., LTD., concentration of solid contents: 100% by mass)

·A-2: trade name "2MZA-PW" (imidazole-based curing accelerator, manufactured by SHIKOKU CHEMICALS CORPORATION., concentration of solid contents: 100% by mass)

·A-3: trade name "LA-7054" (novolac-type phenol resin curing agent, manufactured by DIC Corporation, concentration of solid contents: 60% by mass, diluting solvent: MEK (boiling point 80°C))

·A-4: trade name "2E4MZ" (2-ethyl-4-methylimidazole (curing accelerator), manufactured by SHIKOKU CHEMICALS

CORPORATION., concentration of solid contents: 100% by mass)

·A-5: trade name "2PHZ-PW" (imidazole-based epoxy curing accelerator, manufactured by SHIKOKU CHEMICALS CORPORATION., concentration of solid contents: 100% by mass)

·A-6: trade name "LA-3018-50P" (novolac-type phenol resin curing agent, manufactured by DIC Corporation, concentration of solid contents: 50% by mass, diluting solvent: 2-methoxypropanol (boiling point 120°C))

·A-7: trade name "HPC-8000-65T" (ester resin-type epoxy curing agent, manufactured by DIC Corporation, concentration of solid contents: 65% by mass, diluting solvent: toluene (boiling point 111°C))

·A-8: trade name "V-03" (epoxy curing agent, manufactured by Nisshinbo Chemical Inc., concentration of solid contents: 50% by mass, diluting solvent: toluene (boiling point 111°C))

·A-9: trade name "DMAP" (4-dimethylaminopyridine, manufactured by FUJIFILM Wako Pure Chemical Corporation, concentration of solid contents: 100% by mass)

·A-10: trade name "PN-50" (amine adduct-based curing agent, manufactured by Ajinomoto Fine-Techno Co., Inc., concentration of solid contents: 100% by mass)

·A-16: trade name "HNA-100" (acid anhydride-based curing agent, manufactured by New Japan Chemical Co., Ltd., concentration of solid contents: 100% by mass)

<Filler>

·A-11: trade name "SO-C2" (silica particles, manufactured by Admatechs., concentration of solid contents: 100% by mass)

<Silane coupling agent>

·A-12: trade name "KBM-573" (N-phenyl-3-aminopropyltrimethoxysilane, manufactured by Shin-Etsu Chemical Co., Ltd., concentration of solid contents: 100% by mass)

·A-13: trade name "KBM-103" (phenyltrimethoxysilane, manufactured by Shin-Etsu Chemical Co., Ltd., concentration of solid contents: 100% by mass)

<Photopolymerization Initiator>

·A-14: trade name "OXE-03" (oxime ester-based photopolymerization initiator, manufactured by BASF SE, concentration of solid contents: 100% by mass)

·A-15: trade name "Omnirad 369" (alkylphenone-based photopolymerization initiator, manufactured by BASF SE, concentration of solid contents: 100% by mass)

[Surfactant]

·Sur-1: trade name "MEGAFACE F-781F" (fluorine-based surfactant, manufactured by DIC Corporation, concentration of solid contents: 100% by mass)

·Sur-2: trade name "KF-6001" (silicone-based surfactant, manufactured by Shin-Etsu Chemical Co., Ltd., concentration of solid contents: 100% by mass)

[Solvent]

·S-1: PGMEA (propylene glycol monomethyl ether acetate (boiling point 146°C), manufactured by Tokyo Chemical Industry Co., Ltd.)

·S-2: 1,6-HDDA (1,6-hexanediol diacetate (boiling point 260°C), manufactured by Daicel Corporation)

·S-3: glycerol triacetate (boiling point 260°C, manufactured by FUJIFILM Wako Pure Chemical Corporation)

·S-4: 1,3-BGDA (1,3-butylene glycol diacetate (boiling point 232°C), manufactured by Daicel Corporation)

·S-5: 1,4-BDDA (1,4-butanediol diacetate (boiling point 232°C), manufactured by Daicel Corporation)

·S-6: PGDA (propylene glycol diacetate (boiling point 190°C), manufactured by Daicel Corporation)
·S-7: cyclohexanone (boiling point 155.6°C, manufactured by FUJIFILM Wako Pure Chemical Corporation)
·S-8: toluene (boiling point 110°C, manufactured by FUJIFILM Wako Pure Chemical Corporation)
·S-9: 3-methoxy-1-butanol (boiling point 161°C, manufactured by FUJIFILM Wako Pure Chemical Corporation)
·S-10: isopropyl acetate (boiling point 89°C, manufactured by FUJIFILM Wako Pure Chemical Corporation)
·S-11: methyl ethyl ketone (MEK (boiling point 80°C), manufactured by FUJIFILM Wako Pure Chemical Corporation)
·S-12: ethanol (boiling point 78°C, manufactured by FUJIFILM Wako Pure Chemical Corporation)

[Preparation of compositions of examples and comparative examples]

The components shown in Table 1 except for solvents were mixed together such that the compositional ratio (based on mass) shown in Table 1 was achieved, and the mixture was put in an airtight container made of polytetrafluoroethylene (PTFE). Thereafter, solvents were added thereto such that the compositional ratio (based on mass) shown in Table 1 was achieved, and the container was then sealed, followed by dispersion for 2 hours at 50 G by using RAM (low-frequency resonance acoustic mixer) manufactured by Resodyn Acoustic Mixers, Inc., thereby preparing compositions of examples and comparative examples.

[Evaluation]

[Magnetic properties]

<Preparation of sample substrate for measurement>

A Si wafer having a thickness of 100 μm was coated with CT4000 (manufactured by FUJIFILM Electronic Materials Co., Ltd.), thereby preparing a substrate.
The obtained substrate was coated with each of the compositions of examples and comparative examples by using an applicator having a gap of 100 μm, thereby forming a coating film. Then, in a case where the composition with which the wafer was coated did not contain a photopolymerization initiator, the obtained coating film was dried by heating under drying conditions of 100°C for 120 seconds, and then heated at 230°C for 15 minutes, thereby preparing a substrate with a cured film. In a case where the composition with which the wafer was coated contained a photopolymerization initiator, the coating film was subjected to an exposure treatment with a proximity exposure machine under the conditions of 1,000 mJ/cm$^2$ and heated at 230°C for 10 minutes, thereby obtaining a substrate with a cured film.
Thereafter, each of the obtained substrates with a cured film was cut into pieces having a size of 1 cm × 2.8 cm, thereby preparing a sample substrate for measurement.

<Preparation of reference substrate for measurement>

A reference substrate for measurement was prepared by the same method as the aforementioned production method of the sample substrate for measurement, except that the following composition (composition for preparing a reference substrate for measurement) was used.
In the composition for preparing a reference substrate for measurement, as magnetic particles, magnetic particles of the same type as the magnetic particles used in each of the compositions of examples and comparative examples were used. Furthermore, in a case where two or more kinds of magnetic particles were used in combination, the magnetic particles were mixed at the same ratio. That is, for example, as in Example 17, in preparing the reference substrate for measurement for the sample substrate for measurement prepared using the composition of Example 17, the composition for preparing a reference substrate for measurement contains magnetic particles P-3 and P-1 at a mass ratio of 1:1 as shown in Example 17.
In the composition for preparing a reference substrate for measurement, the binder component B-4 and the solvent S-1 are as described above, respectively.

(Composition for preparing reference substrate for measurement)

Magnetic particles (same type and same mixing ratio as the magnetic particles in each of compositions of examples and comparative examples): 85.8% by mass
Binder component (B-4 was used): 5.2% by mass
Solvent (S-1 was used): 9.0% by mass

Subsequently, by using PER-01 (manufactured by KEYCOM Corp., high-frequency magnetic permeability measuring device), magnetic properties (specific magnetic permeability μ' at 100 MHz) of the film in each of the obtained sample substrates for measurement and reference substrates for measurement were measured.
Based on the obtained value of specific magnetic permeability μ', a magnetic permeability ratio (Δμ') was calculated by the following Equation (1), and magnetic properties were evaluated based on the evaluation standard that will be described later. The larger the value of magnetic permeability ratio (Δμ'), the better the magnetic properties unique to the magnetic particles can be maintained by the formulation. For practical use, a sample graded "3" or higher by evaluation is preferable, a sample graded "4" or higher by evaluation is more preferable, and a sample graded "5" by evaluation is most preferable.

$$\text{Equation (1) } \Delta\mu' = \mu'A/\mu'B$$

Δμ': magnetic permeability ratio
μ'A: specific magnetic permeability μ' of sample substrate for measurement at 100 MHz
μ'B: specific magnetic permeability μ' of reference substrate for measurement at 100 MHz

<Evaluation Standard>

"5": 0.9 < Δμ' and μ'B > 15
"4": 0.75 < Δμ' ≤ 0.9 and μ'B > 15
"3": 0.6 < Δμ' ≤ 0.75 and μ'B > 15
"2": 0.4 < Δμ' ≤ 0.6 and μ'B > 15
"1": Δμ' ≤ 0.4 or μ'B ≤ 15

[Fluidity]

Fluidity was evaluated based on whether or not the composition can be applied by using the applicator used in the evaluation of magnetic properties. Specifically, the fluidity was evaluated based on the following evaluation standard.

<Evaluation Standard>

"A": Applicable.
"B": The composition slides on the substrate and is not applicable.

[Filling suitability]

An FR-4 substrate having a thickness of 0.8 mm was prepared, and through-holes having a diameter of 0.4 mm were formed.
Then, by using DP-320 (NEWLONG SEIMITSU KOGYO Co., LTD.), the substrate was treated such that each of the compositions of examples and comparative examples was embedded in the through-holes. Thereafter, in a case where the composition did not contain a photopolymerization initiator, the obtained substrate in which the composition was embedded was heated at 160°C for 1 hour such that the composition was cured. In a case where the applied composition contained a photopolymerization initiator, the substrate was subjected to an exposure treatment with a proximity exposure machine under the conditions of 1,000 mJ/$cm^2$ and heated at 230°C for 10 minutes such that the composition was cured.
The obtained substrate was subjected to a polishing treatment such that the cross section of the embedded portion was exposed, and the state of the interior of the substrate was observed with a scanning electron microscope (SEM).
An image was obtained at n = 30, and the proportion of openings calculated by Image J was averaged and adopted as an index of filling suitability. In addition, based on the value (Va) obtained by averaging and the following evaluation standard, filling suitability was evaluated. The smaller the value of Va, the fewer the openings caused by voids, cracks, and the like in the cured substance, which is preferable. For practical use, a sample graded "3" or higher by evaluation is preferable, a sample graded "4" or higher by evaluation is more preferable, and a sample graded "5"

by evaluation is most preferable.

<Evaluation Standard>

"5": 3% > Va
"4": 5% > Va ≥ 3%
"3": 8% > Va ≥ 5%
"2": 15% > Va ≥ 8%
"1": Va ≥ 15%

Table 1 shows the formulation of each composition and the results of evaluation tests performed on each composition.

In Table 1, the unit of the value described in the columns of "Amount" and "Total amount" is "parts by mass".

In addition, in Table 1, "N" in the column of "Content (% by mass) of solvent having boiling point of 160°C or higher with respect to total mass of composition" means that the content of a solvent having a boiling point of 160°C or higher is less than 3% by mass with respect to the total mass of the composition, and "P in the same column means that the content of a solvent having a boiling point of 160°C or higher is 3% by mass or more with respect to the total mass of the composition.

Furthermore, in Table 1, "Content (% by mass) of the magnetic particles having primary particle diameter of 4 μm or more" means the content (% by mass) of the magnetic particles having a primary particle diameter of 4 μm or more with respect to the total mass of the magnetic particles.

[Table 1]

| | Formulation of composition | | | | | | | | | | | Content of magnetic particles having primary particle diameter of 4μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% by mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 1 | P-1 | 83.7 | B-1 | 3.15 | | | | | S-1 | 10 | 100 | 67 | 93 | 10 | N | 4 | A | 5 |
| | | | B-10 | 3.15 | | | | | | | | | | | | | | |
| Example 2 | P-2 | 83.7 | B-1 | 3.15 | | | | | S-1 | 10 | 100 | > 90 | 93 | 10 | N | 4 | A | 4 |
| | | | B-10 | 3.15 | | | | | | | | | | | | | | |
| Example 3 | P-3 | 83.7 | B-1 | 3.15 | | | | | S-1 | 10 | 100 | > 90 | 93 | 10 | N | 4 | A | 4 |
| | | | B-10 | 3.15 | | | | | | | | | | | | | | |
| Example 4 | P-4 | 83.7 | B-1 | 3.15 | | | | | S-1 | 10 | 100 | > 90 | 93 | 10 | N | 4 | A | 4 |
| | | | B-10 | 3.15 | | | | | | | | | | | | | | |
| Example 5 | P-6 | 83.7 | B-1 | 3.15 | | | | | S-1 | 10 | 100 | 80 | 93 | 10 | N | 4 | A | 5 |
| | | | B-10 | 3.15 | | | | | | | | | | | | | | |
| Example 6 | P-7 | 83.7 | B-1 | 3.15 | | | | | S-1 | 10 | 100 | > 90 | 93 | 10 | N | 4 | A | 4 |
| | | | B-10 | 3.15 | | | | | | | | | | | | | | |
| Example 7 | P-8 | 83.7 | B-1 | 3.15 | | | | | S-1 | 10 | 100 | > 90 | 93 | 10 | N | 4 | A | 3 |
| | | | B-10 | 3.15 | | | | | | | | | | | | | | |
| Example 8 | P-9 | 83.7 | B-1 | 3.15 | | | | | S-1 | 10 | 100 | > 90 | 93 | 10 | N | 4 | A | 4 |
| | | | B-10 | 3.15 | | | | | | | | | | | | | | |
| Example 9 | P-10 | 83.7 | B-1 | 3.15 | | | | | S-1 | 10 | 100 | > 90 | 93 | 10 | N | 4 | A | 3 |
| | | | B-10 | 3.15 | | | | | | | | | | | | | | |

(continued)

| | Formulation of composition | | | | | | | | | | | Content of magnetic particles having primary particle diameter of 4 μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% by mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 10 | P-11 | 83.7 | B-1 | 3.15 | | | | | S-1 | 10 | 100 | 65 | 93 | 10 | N | 4 | A | 4 |
| | | | B-10 | 3.15 | | | | | | | | | | | | | | |
| Example 11 | P-12 | 83.7 | B-1 | 3.15 | | | | | S-1 | 10 | 100 | > 90 | 93 | 10 | N | 4 | A | 3 |
| | | | B-10 | 3.15 | | | | | | | | | | | | | | |
| Example 12 | P-13 | 83.7 | B-1 | 3.15 | | | | | S-1 | 10 | 100 | > 90 | 93 | 10 | N | 4 | A | 3 |
| | | | B-10 | 3.15 | | | | | | | | | | | | | | |
| Example 13 | P-14 | 83.7 | B-1 | 3.15 | | | | | S-1 | 10 | 100 | 70 | 93 | 10 | N | 4 | A | 4 |
| | | | B-10 | 3.15 | | | | | | | | | | | | | | |
| Example 14 | P-15 | 83.7 | B-1 | 3.15 | | | | | S-1 | 10 | 100 | 50 | 93 | 10 | N | 4 | A | 5 |
| | | | B-10 | 3.15 | | | | | | | | | | | | | | |
| Example 15 | P-16 | 83.7 | B-1 | 3.15 | | | | | S-1 | 10 | 100 | > 90 | 93 | 10 | N | 4 | A | 5 |
| | | | B-10 | 3.15 | | | | | | | | | | | | | | |
| Example 16 | P-17 | 83.7 | B-1 | 3.15 | | | | | S-1 | 10 | 100 | > 90 | 93 | 10 | N | 4 | A | 4 |
| | | | B-10 | 3.15 | | | | | | | | | | | | | | |
| Example 17 | P-3 | 41.85 | B-1 | 3.15 | | | | | S-1 | 10 | 100 | 80 | 93 | 10 | N | 4 | A | 4 |
| | P-1 | 41.85 | B-10 | 3.15 | | | | | | | | | | | | | | |
| Example 18 | P-3 | 62.8 | B-1 | 3.15 | | | | | S-1 | 10 | 100 | > 90 | 93 | 10 | N | 4 | A | 4 |
| | P-1 | 20.9 | B-10 | 3.15 | | | | | | | | | | | | | | |

(continued)

| | Formulation of composition | | | | | | | | | | | Content of magnetic particles having primary particle diameter of 4 μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% by mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 19 | P-3 | 20.9 | B-1 | 3.15 | | | | | S-1 | 10 | 100 | 80 | 93 | 10 | N | 4 | A | 5 |
| | P-1 | 62.8 | B-10 | 3.15 | | | | | | | | | | | | | | |
| Example 20 | P-3 | 41.85 | B-1 | 3.15 | | | | | S-1 | 10 | 100 | 55 | 93 | 10 | N | 4 | A | 4 |
| | P-5 | 41.85 | B-10 | 3.15 | | | | | | | | | | | | | | |
| Example 21 | P-3 | 74.493 | B-1 | 3.15 | | | | | S-1 | 10 | 100 | 29 | 93 | 11 | N | 4 | A | 4 |
| | P-5 | 9.207 | B-10 | 3.15 | | | | | | | | | | | | | | |
| Example 22 | P-3 | 41.85 | B-1 | 3.15 | | | | | S-1 | 10 | 100 | > 90 | 93 | 10 | N | 4 | A | 4 |
| | P-9 | 41.85 | B-10 | 3.15 | | | | | | | | | | | | | | |
| Example 23 | P-1 | 27.9 | B-1 | 3.15 | | | | | S-1 | 10 | 100 | 60 | 93 | 10 | N | 4 | A | 4 |
| | P-5 | 27.9 | B-10 | 3.15 | | | | | | | | | | | | | | |
| | P-9 | 27.9 | | | | | | | | | | | | | | | | |
| Example 24 | P-3 | 81.9 | B-1 | 4.05 | | | | | S-1 | 10 | 100 | > 90 | 91 | 10 | N | 3 | A | 4 |
| | | | B-10 | 405 | | | | | | | | | | | | | | |
| Example 25 | P-3 | 85.5 | B-1 | 2.25 | | | | | S-1 | 10 | 100 | > 90 | 95 | 10 | N | 5 | A | 4 |
| | | | B-10 | 2.25 | | | | | | | | | | | | | | |
| Example 26 | P-3 | 87.3 | B-1 | 1.35 | | | | | S-1 | 10 | 100 | > 90 | 97 | 10 | N | 5 | A | 4 |
| | | | B-10 | 1.35 | | | | | | | | | | | | | | |

(continued)

| | Formulation of composition | | | | | | | | | | | Content of magnetic particles having primary particle diameter of 4μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% by mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 27 | P-3 | 89.1 | B-1 | 0.45 | | | | | S-1 | 10 | 100 | > 90 | 99 | 10 | N | 5 | A | 4 |
| | | | B-10 | 0.45 | | | | | | | | | | | | | | |
| Example 28 | P-3 | 87.42 | B-1 | 3.29 | | | | | S-1 | 6 | 100 | > 90 | 93 | 6 | N | 4 | A | 5 |
| | | | B-10 | 3.29 | | | | | | | | | | | | | | |
| Example 29 | P-3 | 90.2 | B-1 | 3.4 | | | | | S-1 | 3 | 100 | > 90 | 93 | 3 | N | 4 | A | 5 |
| | | | B-10 | 3.4 | | | | | | | | | | | | | | |
| Example 30 | P-3 | 80 | B-1 | 3 | | | | | S-1 | 14 | 100 | > 90 | 93 | 14 | N | 4 | A | 4 |
| | | | B-10 | 3 | | | | | | | | | | | | | | |
| Example 31 | P-3 | 76.3 | B-1 | 2.85 | | | | | S-1 | 18 | 100 | > 90 | 93 | 18 | N | 4 | A | 3 |
| | | | B-10 | 2.85 | | | | | | | | | | | | | | |
| Example 32 | P-3 | 73.5 | B-1 | 2.75 | | | | | S-1 | 21 | 100 | > 90 | 93 | 21 | N | 4 | A | 3 |
| | | | B-10 | 2.75 | | | | | | | | | | | | | | |
| Example 33 | P-3 | 70.7 | B-1 | 2.65 | | | | | S-1 | 24 | 100 | > 90 | 93 | 24 | N | 4 | A | 3 |
| | | | B-10 | 2.65 | | | | | | | | | | | | | | |
| Example 34 | P-3 | 83.7 | B-2 | 3.15 | | | | | S-1 | 10 | 100 | > 90 | 93 | 10 | N | 4 | A | 4 |
| | | | B-10 | 3.15 | | | | | | | | | | | | | | |
| Example 35 | P-3 | 73.5 | B-3 | 18.41 | | | | | S-1 | 4.4 | 100 | > 90 | 93 | 21 | P | 4 | A | 4 |
| | | | B-10 | 3.69 | | | | | | | | | | | | | | |

[Table 2]

| Table 1 (continued) | Formulation of composition | | | | | | | | | | | Content of magnetic particles having primary particle diameter of 4μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% by mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 36 | P-3 | 83.7 | B-4 | 7 | | | | | S-1 | 5.1 | 100 | > 90 | 93 | 10 | N | 4 | A | 4 |
| | | | B-10 | 4.2 | | | | | | | | | | | | | | |
| Example 37 | P-3 | 83.7 | B-5 | 5 | A-14 | 1.8 | | | S-1 | 6.5 | 100 | > 90 | 93 | 10 | N | 4 | A | 4 |
| | | | B-10 | 3 | | | | | | | | | | | | | | |
| Example 38 | P-3 | 83.7 | B-6 | 10.5 | | | | | S-1 | 5.8 | 100 | > 90 | 96 | 13 | N | 5 | A | 4 |
| Example 39 | P-3 | 83.7 | B-7 | 3.15 | | | | | S-1 | 10 | 100 | > 90 | 93 | 10 | N | 4 | A | 4 |
| | | | B-10 | 3.15 | | | | | | | | | | | | | | |
| Example 40 | P-3 | 83.7 | B-1 | 3.15 | | | | | S-1 | 10 | 100 | > 90 | 93 >3 | 10 | N | 4 | A | 4 |
| | | | B-8 | 3.15 | | | | | | | | | | | | | | |
| Example 41 | P-3 | 83.72 | B-1 | 2.25 | A-14 | 1.8 | | | S-1 | 6.6 | 100 | > 90 | 93 | 10 | N | 4 | A | 4 |
| | | | B-9 | 5.63 | | | | | | | | | | | | | | |
| Example 42 | P-3 | 83.7 | B-1 | 3.15 | | | | | S-7 | 10 | 100 | > 90 | 93 | 10 | N | 4 | A | 4 |
| | | | B-14 | 3.15 | | | | | | | | | | | | | | |
| Example 43 | P-3 | 83.7 | B-1 | 3.15 | | | | | S-7 | 10 | 100 | > 90 | 93 | 10 | N | 4 | A | 4 |
| | | | B-15 | 3.15 | | | | | | | | | | | | | | |
| Example 44 | P-3 | 83.75 | B-1 | 3.15 | | | | | S-7 | 2.6 | 100 | > 90 | 93 >3 | 10 | N | 4 | A | 4 |
| | | | B-17 | 10.5 | | | | | | | | | | | | | | |

(continued)

| Table 1 (continued) | Formulation of composition | | | | | | | | | | | Content of magnetic particles having primary particle diameter of 4μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% by mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 45 | P-3 | 83.7 | B-1 | 3.15 | | | | | S-7 | 10 | 100 | > 90 | 93 >3 | 10 | N | 4 | A | 4 |
| | | | B-18 | 3.15 | | | | | | | | | | | | | | |
| 11 | P-3 | 83.7 | B-1 | 3.15 | | | | | S-1 | 10 | 100 | > 90 | 93 | 10 | N | 4 | A | 4 |
| | | | B-11 | 3.15 | | | | | | | | | | | | | | |
| Example 47 | P-3 | 83.7 | B-1 | 0.9 | A-14 | 2.7 | | | S-1 | 10 | 100 | > 90 | 93 | 10 | N | 4 | A | 4 |
| | | | B-12 | 2.7 | | | | | | | | | | | | | | |
| Example 48 | P-3 | 83.7 | B-1 | 1.12 | A-14 | 1.8 | | | S-1 | 10 | 100 | > 90 | 93 | 10 | N | 4 | A | 4 |
| | | | B-13 | 3.38 | | | | | | | | | | | | | | |
| Example 49 | P-3 | 83.7 | B-1 | 1.12 | A-15 | 1.8 | | | S-1 | 10 | 100 | > 90 | 93 | 10 | N | 4 | A | 4 |
| | | | B-13 | 3.38 | | | | | | | | | | | | | | |
| Example 50 | P-3 | 83.7 | B-1 | 1.12 | A-14 | 0.9 | | | S-1 | 10 | 100 | > 90 | 93 | 10 | N | 4 | A | 4 |
| | | | B-13 | 3.38 | A-15 | 0.9 | | | | | | | | | | | | |
| Example 51 | P-3 | 83.7 | B-1 | 3.15 | | | | | S-1 | 10 | 100 | > 90 | 93 | 10 | N | 4 | A | 4 |
| | | | B-16 | 3.15 | | | | | | | | | | | | | | |
| Example 52 | P-3 | 83.7 | B-1 | 3.15 | | | | | S-1 | 10 | 100 | > 90 | 93 | 10 | N | 4 | A | 4 |
| | | | B-19 | 3.15 | | | | | | | | | | | | | | |
| Example 53 | P-3 | 83.7 | B-1 | 3.15 | | | | | S-1 | 10 | 100 | > 90 | 93 | 10 | N | 4 | A | 4 |
| | | | B-20 | 3.15 | | | | | | | | | | | | | | |

(continued)

| Table 1 (continued) | Formulation of composition | | | | | | | | | | | Content of magnetic particles having primary particle diameter of 4μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% by mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 54 | P-3 | 83.7 | B-1 | 4.72 | | | | | S-1 | 10 | 100 | > 90 | 93 | 10 | N | 4 | A | 4 |
| | | | B-10 | 1.58 | | | | | | | | | | | | | | |
| Example 55 | P-3 | 83.7 | B-1 | 1.57 | | | | | S-1 | 10 | 100 | > 90 | 93 | 10 | N | 4 | A | 4 |
| | | | B-10 | 4.73 | | | | | | | | | | | | | | |
| Example 56 | P-3 | 83.7 | B-1 | 2.7 | A-1 | 0.9 | | | S-1 | 10 | 100 | > 90 | 93 | 10 | N | 4 | A | 4 |
| | | | B-10 | 2.7 | | | | | | | | | | | | | | |
| Example 57 | P-3 | 83.7 | B-1 | 2.7 | A-2 | 0.9 | | | S-1 | 10 | 100 | > 90 | 93 | 10 | N | 4 | A | 4 |
| | | | B-10 | 2.7 | | | | | | | | | | | | | | |
| Example 58 | P-6 | 81.93 | B-14 | 0.58 | A-3 | 1.16 | | | S-7 | 0.75 | 100 | 80 | 91 | 10 | N | 3 | A | 5 |
| | | | B-16 | 0.58 | A-4 | 0.01 | | | S-8 | 3 | | | | | | | | |
| | | | B-17 | 2.88 | A-11 | 2.6 | | | S-11 | 0.75 | | | | | | | | |
| | | | B-18 | 2.47 | A-12 | 0.29 | | | S-12 | 3 | | | | | | | | |
| Example 59 | P-6 | 81.93 | B-14 | 0.58 | A-3 | 1.16 | | | S-7 | 0.75 | 100 | 80 | 91 | 10 | N | 3 | A | 4 |
| | | | B-16 | 0.58 | A-4 | 0.01 | | | S-8 | 3 | | | | | | | | |
| | | | B-17 | 2.88 | A-11 | 2.89 | | | S-11 | 0.75 | | | | | | | | |
| | | | B-18 | 2.47 | | | | | S-12 | 3 | | | | | | | | |

(continued)

| Table 1 (continued) | Formulation of composition | | | | | | | | | | | Content of magnetic particles having primary particle diameter of 4μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% by mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 60 | P-6 | 86.5 | B-14 | 0.47 | A-3 | 0.93 | | | S-7 | 0.5 | 100 | 80 | 93 | 7 | N | 4 | A | 5 |
| | | | B-16 | 0.47 | A-4 | 0.01 | | | S-8 | 2 | | | | | | | | |
| | | | B-17 | 2.32 | A-11 | 2.08 | | | S-11 | 0.5 | | | | | | | | |
| | | | B-18 | 1.99 | A-2 | 0.23 | | | S-12 | 2 | | | | | | | | |
| Example 61 | P-16 | 86.5 | B-14 | 0.47 | A-3 | 0.93 | | | S-7 | 0.48 | 100 | > 90 | 93 | 7 | N | 4 | A | 5 |
| | | | B-18 | 0.47 | A-4 | 0.23 | | | S-8 | 1.92 | | | | | | | | |
| | | | B-17 | 2.31 | A-11 | 2.08 | | | S-11 | 0.48 | | | | | | | | |
| | | | B-18 | 1.98 | A-12 | 0.23 | | | S-12 | 1.92 | | | | | | | | |

[Table 3]

| Table 1 (continued) | Formulation of composition | | | | | | | | | | | Content of magnetic particles having primary particle diameter of 4μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% by mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 62 | P-17 | 86.5 | B-14 | 0.47 | A-3 | 0.93 | | | S-7 | 0.5 | 100 | > 90 | 93 | 7 | N | 4 | A | 5 |
| | | | B-16 | 0.47 | A-4 | 0.23 | | | S-8 | 2 | | | | | | | | |
| | | | B-17 | 2.21 | A-11 | 1.98 | | | S-11 | 0.5 | | | | | | | | |
| | | | B-18 | 1.98 | A-12 | 0.23 | | | S-12 | 2 | | | | | | | | |
| Example 63 | P-6 | 83.67 | B-19 | 0.9 | A-6 | 0.63 | | | S-7 | 0.81 | 100 | 80 | 93 | 10 | N | 4 | A | 4 |
| | | | B-20 | 3 | A-7 | 1.08 | | | S-8 | 3.24 | | | | | | | | |
| | | | B-21 | 0.6 | A-8 | 0.63 | | | S-11 | 0.81 | | | | | | | | |
| | | | B-17 | 1.32 | A-9 | 0.07 | | | S-12 | 3.24 | | | | | | | | |
| Example 64 | P-16 | 83.67 | B-19 | 0.9 | A-6 | 0.63 | | | S-7 | 0.81 | 100 | > 90 | 93 | 10 | N | 4 | A | 5 |
| | | | B-20 | 3 | A-7 | 1.08 | | | S-8 | 3.24 | | | | | | | | |
| | | | B-21 | 0.6 | A-8 | 0.63 | | | S-11 | 0.81 | | | | | | | | |
| | | | B-17 | 1.32 | A-9 | 0.07 | | | S-12 | 3.24 | | | | | | | | |
| Example 65 | P-17 | 83.66 | B-19 | 0.83 | A-6 | 0.81 | | | S-7 | 0.79 | 100 | > 90 | 93 | 10 | N | 4 | A | 4 |
| | | | B-20 | 2.76 | A-7 | 1.38 | | | S-8 | 3.16 | | | | | | | | |
| | | | B-21 | 0.55 | A-8 | 0.81 | | | S-11 | 0.79 | | | | | | | | |
| | | | B-17 | 1.21 | A-9 | 0.09 | | | S-12 | 3.16 | | | | | | | | |

(continued)

| Table 1 (continued) | Formulation of composition | | | | | | | | | | | Content of magnetic particles having primary particle diameter of 4μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% by mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 66 | P-17 | 86.48 | B-19 | 0.85 | A-6 | 0.84 | | | S-7 | 0.48 | 100 | > 90 | 93 | 7 | N | 4 | A | 5 |
| | | | B-20 | 2.85 | A-7 | 1.43 | | | S-8 | 1.92 | | | | | | | | |
| | | | B-21 | 0.57 | A-8 | 0.84 | | | S-11 | 0.48 | | | | | | | | |
| | | | B-17 | 1.25 | A-9 | 0.09 | | | S-12 | 1.92 | | | | | | | | |
| Example 67 | P-17 | 88.4 | B-19 | 0.68 | A-6 | 0.37 | | | S-7 | 0.57 | 100 | > 90 | 95 | 7 | N | 5 | A | 5 |
| | | | B-20 | 2.28 | A-7 | 0.72 | | | S-8 | 2.24 | | | | | | | | |
| | | | B-21 | 0.46 | A-8 | 0.37 | | | S-11 | 0.57 | | | | | | | | |
| | | | B-17 | 1 | A-9 | 0.09 | | | S-12 | 2.25 | | | | | | | | |
| Example 68 | P-6 | 83.7 | B-14 | 2.99 | A-10 | 0.11 | | | S-7 | 1 | 100 | 80 | 93 | 10 | N | 4 | A | 5 |
| | | | | | A-5 | 0.58 | | | S-8 | 3.97 | | | | | | | | |
| | | | | | A-13 | 0.06 | | | S-11 | 1 | | | | | | | | |
| | | | | | A-16 | 2.61 | | | S-12 | 3.98 | | | | | | | | |
| Example 69 | P-6 | 83.7 | B-14 | 2.88 | A-10 | 0.14 | | | S-7 | 1 | 100 | 80 | 93 | 10 | N | 4 | A | 5 |
| | | | | | A-5 | 0.75 | | | S-8 | 3.97 | | | | | | | | |
| | | | | | A-13 | 0.08 | | | S-11 | 0.99 | | | | | | | | |
| | | | | | A-16 | 2.52 | | | S-12 | 3.97 | | | | | | | | |

(continued)

| Table 1 (continued) | Formulation of composition | | | | | | | | | | | Content of magnetic particles having primary particle diameter of 4μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% by mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 70 | P-6 | 86.5 | B-14 | 2.98 | A-10 | 0.15 | | | S-7 | 0.7 | 100 | 80 | 93 | 7 | N | 4 | A | 5 |
| | | | | | A-5 | 0.77 | | | S-8 | 2.77 | | | | | | | | |
| | | | | | A-13 | 0.08 | | | S-11 | 0.69 | | | | | | | | |
| | | | | | A-16 | 2.6 | | | S-12 | 2.76 | | | | | | | | |
| Example 71 | P-6 | 83.7 | B-14 | 2.99 | A-10 | 0.12 | | | S-7 | 1 | 100 | 80 | 93 | 10 | N | 4 | A | 4 |
| | | | | | A-5 | 0.58 | | | S-8 | 4 | | | | | | | | |
| | | | | | A-16 | 2.61 | | | S-11 | 1 | | | | | | | | |
| | | | | | | | | | S-12 | 4 | | | | | | | | |
| Example 72 | P-16 | 83.7 | B-14 | 2.88 | A-10 | 0.14 | | | S-7 | 1 | 100 | > 90 | 93 | 10 | N | 4 | A | 5 |
| | | | | | A-5 | 0.75 | | | S-8 | 3.97 | | | | | | | | |
| | | | | | A-13 | 0.08 | | | S-11 | 0.99 | | | | | | | | |
| | | | | | A-16 | 2.52 | | | S-12 | 3.97 | | | | | | | | |
| Example 73 | P-17 | 83.7 | B-14 | 2.88 | A-10 | 0.14 | | | S-7 | 1 | 100 | > 90 | 93 | 10 | N | 4 | A | 5 |
| | | | | | A-5 | 0.75 | | | S-8 | 3.97 | | | | | | | | |
| | | | | | A-13 | 0.08 | | | S-11 | 0.99 | | | | | | | | |
| | | | | | A-16 | 2.52 | | | S-12 | 3.97 | | | | | | | | |

(continued)

| Table 1 (continued) | Formulation of composition | | | | | | | | | | | Content of magnetic particles having primary particle diameter of 4μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% by mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 74 | P-6 | 83.7 | B-14 | 4.08 | A-2 | 0.56 | | | S-7 | 1 | 100 | 80 | 93 | 10 | N | 4 | A | 4 |
| | | | | 1.36 | | | | | S-8 | 4 | | | | | | | | |
| | | | B-15 B-7 | 0.3 | | | | | S-11 | 1 | | | | | | | | |
| | | | | | | | | | S-12 | 4 | | | | | | | | |
| Example 7: | P-6 | 83.7 | B-14 | 3.98 | A-2 | 0.69 | | | S-7 | 1 | 100 | 80 | 93 | 10 | N | 4 | A | 4 |
| | | | | 1.33 | | | | | S-8 | 4 | | | | | | | | |
| | | | B-15 B-7 | 0.3 | | | | | S-11 | 1 | | | | | | | | |
| | | | | | | | | | S-12 | 4 | | | | | | | | |
| Example 76 | P-16 | 83.7 | B-14 | 3.98 | A-2 | 0.69 | | | S-7 | 1 | 100 | > 90 | 93 | 10 | N | 4 | A | 5 |
| | | | B-15 | 1.33 | | | | | S-8 | 4 | | | | | | | | |
| | | | B-7 | 0.3 | | | | | S-11 | 1 | | | | | | | | |
| | | | | | | | | | S-12 | 4 | | | | | | | | |
| Example 77 | P-17 | 83.7 | B-14 | 3.98 | A-2 | 0.69 | | | S-7 | 1 | 100 | > 90 | 93 | 10 | N | 4 | A | 4 |
| | | | B-15 | 1.33 | | | | | S-8 | 4 | | | | | | | | |
| | | | B-7 | 0.3 | | | | | S-11 | 1 | | | | | | | | |
| | | | | | | | | | S-12 | 4 | | | | | | | | |

[Table 4]

| Table 1 (continued) | Formulation of composition | | | | | | | | | | | Content of magnetic particles having primary particle diameter of 4μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% bv mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 78 | P-3 | 83.7 | B-1 | 2.98 | A-1 | 0.34 | | | S-1 | 10 | 100 | > 90 | 93 | 10 | N | 4 | A | 4 |
| | | | B-10 | 2.98 | | | | | | | | | | | | | | |
| Example 79 | P-3 | 83.7 | B-1 | 2.8 | A-12 | 0.7 | | | S-1 | 10 | 100 | > 90 | 93 | 10 | N | 4 | A | 5 |
| | | | B-10 | 2.8 | | | | | | | | | | | | | | |
| Example 80 | P-3 | 83.7 | B-1 | 2.63 | A-1 | 0.34 | | | S-1 | 10 | 100 | > 90 | 93 | 10 | N | 4 | A | 5 |
| | | | B-10 | 2.63 | A-13 | 0.7 | | | | | | | | | | | | |
| Example 81 | P-3 | 83.741 | B-1 | 3.15 | | | Sur-1 | 0.009 | S-1 | 13.1 | 100 | > 90 | 96 | 13 | N | 5 | A | 4 |
| Example 82 | P-3 | 83.691 | B-1 | 3.15 | | | Sur-2 | 0.009 | S-1 | 10 | 100 | > 90 | 93 | 10 | N | 4 | A | 4 |
| | | | B-10 | 3.15 | | | | | | | | | | | | | | |
| Example 83 | P-3 | 83.7 | B-1 | 3.15 | | | | | S-2 | 10 | 100 | > 90 | 93 | 10 | P | 4 | A | 5 |
| | | | B-10 | 3.15 | | | | | | | | | | | | | | |
| Example 84 | P-3 | 83.7 | B-1 | 3.15 | | | | | S-3 | 10 | 100 | > 90 | 93 | 10 | P | 4 | A | 5 |
| | | | B-10 | 3.15 | | | | | | | | | | | | | | |
| Example 85 | P-3 | 83.7 | B-1 | 3.15 | | | | | S-4 | 10 | 100 | > 90 | 93 | 10 | P | 4 | A | 5 |
| | | | B-10 | 3.15 | | | | | | | | | | | | | | |
| Example 86 | P-3 | 83.7 | B-1 | 3.15 | | | | | S-5 | 10 | 100 | >90 | 93 | 10 | P | 4 | A | 5 |
| | | | B-10 | 3.15 | | | | | | | | | | | | | | |

(continued)

| Table 1 (continued) | Formulation of composition | | | | | | | | | | | Content of magnetic particles having primary particle diameter of 4μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% bv mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 87 | P-3 | 83.7 | B-1 | 3.15 | | | | | S-6 | 10 | 100 | >90 | 93 | 10 | P | 4 | A | 5 |
| | | | B-10 | 3.15 | | | | | | | | | | | | | | |
| Example 88 | P-3 | 83.7 | B-1 | 3.15 | | | | | S-7 | 10 | 100 | > 90 | 93 | 10 | N | 4 | A | 4 |
| | | | B-10 | 3.15 | | | | | | | | | | | | | | |
| Example 89 | P-3 | 83.7 | B-1 | 3.15 | | | | | S-8 | 10 | 100 | > 90 | 93 | 10 | N | 4 | A | 4 |
| | | | B-10 | 3.15 | | | | | | | | | | | | | | |
| Example 90 | P-3 | 83.7 | B-1 | 3.15 | | | | | S-9 | 10 | 100 | > 90 | 93 | 10 | P | 4 | A | 5 |
| | | | B-10 | 3.15 | | | | | | | | | | | | | | |
| Example 91 | P-3 | 83.7 | B-1 | 3.15 | | | | | S-10 | 10 | 100 | > 90 | 93 | 10 | N | 4 | A | 3 |
| | | | B-10 | 3.15 | | | | | | | | | | | | | | |
| Example 92 | P-3 | 83.7 | B-1 | 3.15 | | | | | S-11 | 10 | 100 | > 90 | 93 | 10 | N | 4 | A | 3 |
| | | | B-10 | 3.15 | | | | | | | | | | | | | | |
| Example 93 | P-3 | 83.7 | B-1 | 3.15 | | | | | S-12 | 10 | 100 | > 90 | 93 | 10 | N | 4 | A | 3 |
| | | | B-10 | 3.15 | | | | | | | | | | | | | | |
| Example 94 | P-3 | 83.7 | B-1 | 3.15 | | | | | S-2 | 5 | 100 | > 90 | 93 | 10 | P | 4 | A | 5 |
| | | | B-10 | 3.15 | | | | | S-11 | 5 | | | | | | | | |

(continued)

| Table 1 (continued) | Formulation of composition | | | | | | | | | | | Content of magnetic particles having primary particle diameter of 4μm or more (% by mass) | Content of magnetic particles with respect to total solid content of composition (% by mass) | Content of solvent with respect to total mass of composition (% by mass) | Content of solvent having boiling point of 160°C or higher with respect to total mass of composition (% bv mass) | Magnetic properties | Fluidity | Filling suitability |
|---|---|---|---|---|---|---|---|---|---|---|---|---|---|---|---|---|---|---|
| | Magnetic particles | | Binder component | | Additive | | Activator | | Solvent | | Total amount | | | | | | | |
| | Type | Amount | Type | Amount | Type | Amount | Type | Amount | Type | Amount | | | | | | | | |
| Example 95 | P-3 | 83.7 | B-1 | 3.15 | | | | | S-2 | 7.5 | 100 | > 90 | 93 | 10 | P | 4 | A | 5 |
| | | | B-10 | 3.15 | | | | | S-11 | 2.5 | | | | | | | | |
| Example 96 | P-3 | 83.7 | B-1 | 3.15 | | | | | S-2 | 2.5 | 100 | > 90 | 93 | 10 | N | 4 | A | 3 |
| | | | B-10 | 3.15 | | | | | S-11 | 7.5 | | | | | | | | |
| | | | B-10 | 2.59 | | | | | | | | | | | | | | |
| Comparative Example 1 | P-3 | 68.82 | B-1 | 2.59 | | | | | S-1 | 26 | 100 | > 90 | 93 | 26 | N | 4 | A | 2 |
| | | | B-10 | 2.59 | | | | | | | | | | | | | | |
| Comparative Example 2 | P-3 | 81 | B-1 | 4.5 | | | | | S-1 | 10 | 100 | > 90 | 90 | 10 | N | 2 | A | 5 |
| | | | B-10 | 4.5 | | | | | | | | | | | | | | |
| Comparative Example 3 | P-3 | 91.14 | B-1 | 3.43 | | | | | S-1 | 2 | 100 | > 90 | 93 | 2 | N | 4 | B | Inevaluable |
| | | | B-10 | 3.43 | | | | | | | | | | | | | | |
| Comparative Example 4 | P-5 | 83.7 | B-1 | 3.15 | | | | | S-1 | 10 | 100 | 20 | 93 | 10 | N | 1 | A | 4 |

From the results shown in Table 1, it has been revealed that the composition according to the embodiment of the present invention has excellent fluidity and capable of forming a cured substance having excellent filling suitability and excellent magnetic properties.

In addition, from the results of examples (for example, comparison of Examples 1 to 16 and the like), it has been confirmed that the filling suitability of the formed cured substance is further improved in a case where the average primary particle diameter of the magnetic particles is 20 $\mu$m or less (preferably 7 $\mu$m or less). Presumably, filling suitability of Example 15 might be further improved because particles having coated surface were used as magnetic particles.

From the results of examples (for example, comparison of Examples 3 and 24 to 27, and the like), it has been confirmed that the magnetic properties of the formed cured substance are further improved in a case where the content of magnetic particles is 92% by mass or more (preferably 95% by mass or more) with respect to the total solid content of the composition.

From the results of examples (for example, comparison of Examples 3 and 28 to 33, and the like), it has been confirmed that the filling suitability of the composition is further improved in a case where the content of the solvent is 15% by mass or less (preferably 8% by mass or less) with respect to the total mass of the composition.

From the results of examples (for example, the comparison of Examples 58 to 62, the comparison of Examples 68 to 71, the comparison of Examples 78 to 80, and the like), it has been confirmed that the filling suitability of the composition is further improved in a case where the composition contains a silane coupling agent or the like as an adhesion aid. The comparison of Examples 58 to 62 leaded to the assumption that the incorporation of the adhesion aid such as a silane coupling agent into the composition and the content of solvent that is 8% by mass or less with respect to the total mass of the composition might contribute to the improvement of the filling suitability of the composition (particularly, in Example 61, presumably, coating of the surface of the magnetic particles in the composition might also contribute to the improvement of the filling suitability of the composition).

From the results of examples (for example, comparison of Examples 83 to 96 and the like), it has been confirmed that the filling suitability of the composition is further improved in a case where the composition contains a solvent having a boiling point of 160°C or higher, and the content of the solvent is 3% by mass or more with respect to the total mass of the composition.

In Examples 24 to 33, the same results are obtained even though the magnetic particles P-3 are replaced with P-2 or P-4.

On the other hand, the compositions of comparative examples did not exhibit desired effects. In Comparative Example 3, because the content of the solvent in the composition was too low, the fluidity of the composition was poor, and it was difficult to apply the composition by an applicator.

## Claims

**1.** A composition comprising:

magnetic particles;
one or more components selected from the group consisting of a resin and a resin precursor; and
a solvent,
wherein a content of magnetic particles having a primary particle diameter of 4 $\mu$m or more is 25% by mass or less with respect to a total mass of the magnetic particles,
a content of the magnetic particles is 91% by mass or more with respect to a total solid content of the composition, and
a content of the solvent is 3% to 24% by mass with respect to a total mass of the composition.

**2.** The composition according to claim 1,
wherein the magnetic particles are soft magnetic particles.

**3.** The composition according to claim 1 or 2,
wherein the solvent includes a solvent having a boiling point of 80°C or higher.

**4.** The composition according to any one of claims 1 to 3,
wherein the solvent includes a solvent having a boiling point of 160°C or higher.

**5.** The composition according to any one of claims 1 to 4,

wherein the solvent includes a solvent having a boiling point of 160°C or higher, and

a content of the solvent having a boiling point of 160°C or higher is 3% by mass or more with respect to the total mass of the composition.

**6.** The composition according to any one of claims 1 to 5,
wherein the components include at least one of an epoxy compound or an oxetane compound.

**7.** A magnetic particle-containing cured substance formed of the composition according to any one of claims 1 to 6.

**8.** A magnetic particle-introduced substrate comprising:

a substrate in which hole portions are formed; and
the magnetic particle-containing cured substance according to claim 7 that is disposed in the hole portions.

**9.** An electronic material comprising:
the magnetic particle-introduced substrate according to claim 8.

**INTERNATIONAL SEARCH REPORT**

International application No.
**PCT/JP2021/034059**

**A. CLASSIFICATION OF SUBJECT MATTER**

***H01F 1/26***(2006.01)i; ***C08L 63/00***(2006.01)i; ***C08L 101/00***(2006.01)i; ***H01F 1/28***(2006.01)i; ***H01F 1/37***(2006.01)i; ***H05K 1/03***(2006.01)i

FI: H01F1/26; C08L63/00 C; C08L101/00; H01F1/28; H01F1/37; H05K1/03 610L; H05K1/03 610R

According to International Patent Classification (IPC) or to both national classification and IPC

**B. FIELDS SEARCHED**

Minimum documentation searched (classification system followed by classification symbols)

H01F1/26; C08L63/00; C08L101/00; H01F1/28; H01F1/37; H05K1/03

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2018-73917 A (SUMIDA CORP.) 10 May 2018 (2018-05-10) paragraphs [0009], [0026]-[0043], [0054], table 1 | 1-7<br>8-9 |
| Y | WO 2020/022393 A1 (AJINOMOTO CO., INC.) 30 January 2020 (2020-01-30) paragraphs [0012]-[0074], [0096]-[0108], fig. 4-8 | 8-9 |
| A | JP 2020-72182 A (TDK CORP.) 07 May 2020 (2020-05-07) paragraphs [0033]-[0035], [0074]-[0075], [0109]-[0121], tables 2-5, fig. 6 | 1-9 |
| A | JP 2012-124355 A (TORAY IND., INC.) 28 June 2012 (2012-06-28) paragraphs [0024]-[0025], [0091]-[0097], table 1 | 3-9 |
| A | WO 2010/024166 A1 (SONY CHEMICAL & INFORMATION DEVICE CORP.) 04 March 2010 (2010-03-04) paragraph [0052] | 6-9 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
**06 December 2021**

Date of mailing of the international search report
**21 December 2021**

Name and mailing address of the ISA/JP
**Japan Patent Office (ISA/JP)**
**3-4-3 Kasumigaseki, Chiyoda-ku, Tokyo 100-8915**
**Japan**

Authorized officer

Telephone No.

Form PCT/ISA/210 (second sheet) (January 2015)

**INTERNATIONAL SEARCH REPORT**
**Information on patent family members**

International application No.
**PCT/JP2021/034059**

| Patent document cited in search report | Publication date (day/month/year) | Patent family member(s) | Publication date (day/month/year) |
|---|---|---|---|
| JP 2018-73917 A | 10 May 2018 | US 2018/0114618 A1<br>paragraphs [0010], [0041]-[0066], [0080], table 1<br>EP 3316265 A1<br>CN 107993786 A | |
| WO 2020/022393 A1 | 30 January 2020 | EP 3828901 A1<br>paragraphs [0011]-[0074], [0096]-[0109], fig. 4-8<br>TW 202012075 A<br>WO 2020/021968 A1<br>WO 2020/105704 A1 | |
| JP 2020-72182 A | 07 May 2020 | US 2020/0135380 A1<br>paragraphs [0049]-[0051], [0093]-[0094], [0127]-[0135], tables 2-5, fig. 6<br>CN 111128506 A | |
| JP 2012-124355 A | 28 June 2012 | (Family: none) | |
| WO 2010/024166 A1 | 04 March 2010 | JP 2010-77405 A<br>CN 102131867 A<br>HK 1157806 A1<br>KR 10-2011-0056504 A<br>TW 201022322 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2018194099 A
- JP 6024927 B
- JP 2019067960 A
- WO 2016088645 A
- JP 2012155288 A
- JP 2009265518 A
- JP 5923557 B
- JP 2013249417 A
- JP 2010106268 A
- US 20110124824 A
- JP 2010097210 A
- JP 2015068893 A
- JP 59044615 A
- JP S59044615 A
- JP 54034327 B
- JP S54034327 AB
- JP 58012577 B
- JP S58012577 B
- JP 54025957 B
- JP S54025957 B
- JP 54092723 B
- JP S54092723 B
- JP 59053836 A
- JP S59053836 A
- JP 59071048 A
- JP S59071048 A
- EP 993966 B
- EP 1204000 B
- JP 2001318463 A
- WO 2008123097 A
- JP 2016075845 A
- JP 2008106250 A
- JP 2016122101 A
- JP 2016068401 A
- JP 2014137523 A
- JP 2015187676 A
- JP 2014106326 A
- JP 2010168539 A
- JP 2013029760 A
- JP 2008260927 A
- JP 2008292970 A
- JP 2004043405 A
- JP 2014005382 A
- JP 10291969 A
- JP H10291969 A
- JP 4225898 B
- JP 2009191179 A
- JP 2001233842 A
- JP 2000080068 A
- JP 2006342166 A
- JP 2000066385 A
- JP 2004534797 A
- JP 2009519904 A
- US 7626957 B
- JP 2010015025 A
- US 2009292039 A
- WO 2009131189 A
- US 7556910 B
- JP 2009221114 A
- JP 2010262028 A
- JP 2014500852 A
- JP 2013164471 A
- JP 2014137466 A
- WO 2015036910 A
- KR 1020160109444 A
- JP 2014041318 A
- WO 2014017669 A
- JP 2011132503 A
- JP 2020008634 A
- JP 2011089090 A


### Non-patent literature cited in the description


- **A. J. LEO.** Comprehensive Medicinal Chemistry. Pergamon press, 1990, vol. 4, 295
- **C. HANSCH ; A. J. LEO.** Substituent Constants For Correlation Analysis in Chemistry and Biology. John Wiley & Sons
- **A. J. LEO.** Calculating logPoct from structure. *Chem. Rev.,* 1993, vol. 93, 1281-1306
- **KIYOMI KATO.** Ultraviolet Curing System. GL Sciences Inc, 1989
- *J. C. S. Perkin,* 1979, vol. II, 1653-1660
- *J. C. S. Perkin,* 1979, vol. II, 156-162
- *Journal of Photopolymer Science and Technology,* 1995, 202-232